# EUROPEAN PATENT APPLICATION

(11) **EP 2 100 940 A2**
(43) Date of publication of application: **16.09.2009**
(21) Application number: 09154749.7
(22) Date of filing: 10.03.2009
(51) Int. Cl.: C09K 11/06, H05B 33/14

(54) **Organic electroluminescent device using organic electroluminescent compounds**

(30) Priority: 14.03.2008 KR 20080024056
(71) Applicant: Gracel Display Inc., Seoul 133-833 (KR)
(72) Inventor: Kim, Bong Ok, 135-090 Seoul (KR); Kim, Sung Min, 157-886 Seoul (KR); Yoon, Seung Soo, 135-884 Seoul (KR)
(74) Representative: Kent, Venetia Katherine

(57) **Abstract**

The present invention relates to an organic electroluminescent device comprising an organic layer interposed between an anode and an cathode on a substrate, wherein the organic layer comprises an electroluminescent layer comprising one or more host compound(s) represented by Chemical Formula (1) and one or more dopant compound(s) represented by Chemical Formula (2):

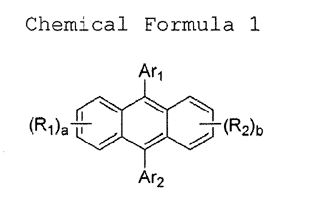

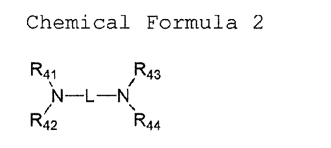

The organic electroluminescent device according to the present invention exhibits long life, high efficiency and high luminance with good color purity and lowered operation voltage, as well as enhanced stability of device.

## Description

### FIELD OF THE INVENTION

The present invention relates to an organic electroluminescent device comprising an organic layer interposed between an anode and an cathode on a substrate, wherein the organic layer comprises an electroluminescent layer comprising one or more host compound(s) represented by Chemical Formula (1) and one or more dopant compound(s) represented by Chemical Formula (2):

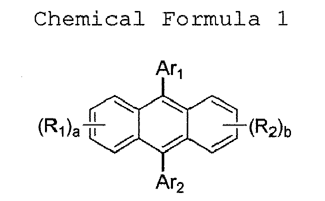

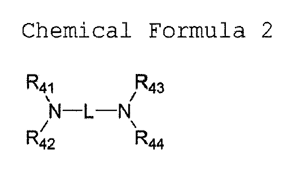

### BACKGROUND OF THE INVENTION

Recently, planar display devices having less occupancy of space are increasingly required, as the display devices become bigger in size. Among those planar display devices, techniques regarding organic electroluminescent devices (also referred to as organic light emitting diodes (OLED's)) have been rapidly developed, and several prototypes have been known.

An organic electroluminescent device is a device wherein, when charge is applied to an organic film formed between an electron injecting electrode (cathode) and a hole injecting electrode (anode), an electron and a hole form a pair, which diminishes with emitting light. A device can be formed on a transparent flexible substrate such as plastics. The device can be operated at a lower voltage (not more than 10 V) with relatively lower power consumption but excellent color purity, as compared to a plasma display panel or an inorganic EL display.

Since the organic electroluminescent (EL) devices can develop three colors (green, blue and red), they have been focused as full colored display devices for next generation.

The procedure for manufacturing an organic EL device comprises the following steps:
(1) First, anode material is coated on a transparent substrate. As the anode material, ITO (indium tin oxide) is usually employed.
(2) A hole injecting layer (HIL) is coated thereon. As the hole injecting layer, it is common to coat copper phthalocyanine (CuPc) with a thickness of 10 nm to 30 nm.
(3) Then, hole transport layer (HTL) is introduced. As the hole transport layer, 4,4'-bis[N-(1-naphthyl)-N-phenylamino]biphenyl (NPB) is vapor-deposited with a thickness of about 30 nm to 60 nm.
(4) An organic emitting layer is formed thereon. If required, dopant is added. In case of green electroluminescence, tris(8-hydroxyquinolate)aluminium (Alq₃) is commonly vapor-deposited with a thickness of 30 to 60 nm as the organic emitting layer, and MQD(N-methylquinacridone) is usually employed as dopant.
(5) An electron transport layer (ETL) and an electron injecting layer (EIL) is then sequentially coated thereon, or an electron injecting/transport layer is formed. In case of green electroluminescence, since Alq₃ of (4) has good capability of electron transport, an electron injecting/transport layer may not be necessarily employed.
(6) Then, a cathode is coated, and finally passivation is carried out.

Depending upon how the emitting layer is formed in such a structure, a blue, green or red electroluminescent device can be realized. In the meanwhile, conventional substances used as green electroluminescent compound for realizing green electroluminescent device had problems of insufficient life and poor luminous efficiency.

Various organic compounds may be used for the electron injecting layer or the electron transfer layer in the above-mentioned structure. The compounds include light metal complexes such as tris(8-quinolinolate)aluminum (Alq₃), oxadiazole, triazole, benzimidazole, benzoxazole, benzothiazole, and the like, but they are not satisfactory in terms of luminance, durability, or the like. Among them, it is reported that Alq₃ is the best compound because of excellent stability and electron affinity. However, when it is employed for a blue electroluminescent device, electroluminescence due to exciton diffusion results in lowered color purity.

As described above, recent developments for practical use of electroluminescent devices are prominent, and the characteristic point is to obtain thin-type electroluminescent devices having high luminance, a variety of electroluminescent wavelength and rapid response. For the device of long life and high efficiency, lowered power consumption is essentially required.

### SUMMARY OF THE INVENTION

With intensive efforts to overcome the problems of conventional techniques as described above, the present inventors have invented an organic electroluminescent device wherein an organic layer comprised of a certain combination of compounds is interposed between an anode and a cathode on a substrate in order to realize high color purity, high luminance and long life.

The object of the present invention is to provide an organic electroluminescent device comprising an organic layer interposed between an anode and a cathode on a substrate, wherein the organic layer comprises an electroluminescent layer containing one or more host compound(s) and one or more dopant compound(s).

Another object of the invention is to provide an organic electroluminescent device exhibiting high luminous efficiency, excellent color purity, low operation voltage and good operation life.

Thus, the present invention relates to organic electroluminescent devices. More specifically, the organic electroluminescent devices according to the present invention is **characterized in that** the organic electroluminescent device comprises an organic layer interposed between an anode and an cathode on a substrate, and the organic layer comprises an electroluminescent layer containing one or more host compound(s) represented by Chemical Formula (1) and one or more dopant compound(s) represented by Chemical Formula (2): 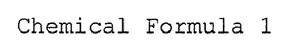 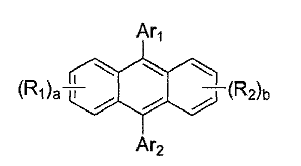 wherein, Ar₁, Ar₂, R₁ and R₂ independently represent hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl, or a substituent selected from the following structures; or each of them may be linked to an adjacent substituent via (C3-C60)alkylene or (C3-C60)alkenylene with or without a fused ring to form an alicyclic ring, or a monocyclic or polycyclic aromatic ring; 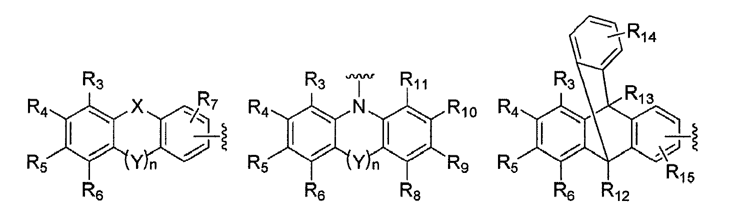 wherein, R₃ through R₁₅ independently represent hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl;
X and Y independently represent a chemical bond, or - C(R₂₁)(R₂₂)-, -N(R₂₃)-, -S-, -O-, -Si(R₂₄)(R₂₅)-, -P(R₂₆)-, - C(=O)-, -B(R₂₇)-, -In(R₂₈)-, -Se-, -Ge(R₂₉)(R₃₀)-, -Sn(R₃₁)(R₃₂)-, -Ga(R₃₃)-, or -(R₃₄)C=C(R₃₅)-;
R₂₁ through R₃₅ independently represent hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl; or each of R₂₁ through R₃₅ may be linked to an adjacent substituent via (C3-C60)alkylene or (C3-C60)alkenylene with or without a fused ring to form an alicyclic ring, or a monocyclic or polycyclic aromatic ring;
the alkyl, alkenyl, alkynyl, cycloalkyl, heterocycloalkyl, aryl, heteroaryl, arylsilyl, alkylsilyl, alkylamino and arylamino of Ar₁, Ar₂, R₁ and R₂ may be further substituted by one or more substituent(s) selected from deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl;
a and b are integers from 0 to 4, provided that a+b ≥ 1; and
n is an integer from 0 to 4; 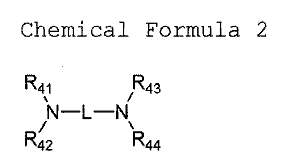 wherein,
L represents (C6-C60)arylene with or without one or more substituent(s) selected from a group consisting of deuterium, halogen, (C1-C60)alkyl, (C6-C60)aryl, (C4-C60)heteroaryl, 5-or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl; the alkyl, cycloalkyl, heterocycloalkyl, aryl, heteroaryl, arylsilyl, alkylsilyl, alkylamino and arylamino substituent on the arylene may be further substituted by one or more substituent(s) selected from deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl;
R₄₁ through R₄₄ independently represent (C1-C60)alkyl, (C6-C60)aryl, (C4-C60)heteroaryl, (C6-C60)arylamino, (C1-C60)alkylamino, 5- or 6-membered heterocycloalkyl containing one or more heteroatom(s) selected from N, O and S, or (C3-C60)cycloalkyl, or each of R₄₁ through R₄₄ is linked to an adjacent substituent via (C3-C60)alkylene or (C3-C60)alkenylene with or without a fused ring to form an alicyclic ring, or a monocyclic or polycyclic aromatic ring;
the alkyl, aryl, heteroaryl, arylamino, alkylamino, cycloalkyl or heterocycloalkyl of R₄₁ through R₄₄ may be further substituted by one or more substituent(s) selected from deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl.

### BRIEF DESCRIPTION OF THE DRAWINGS

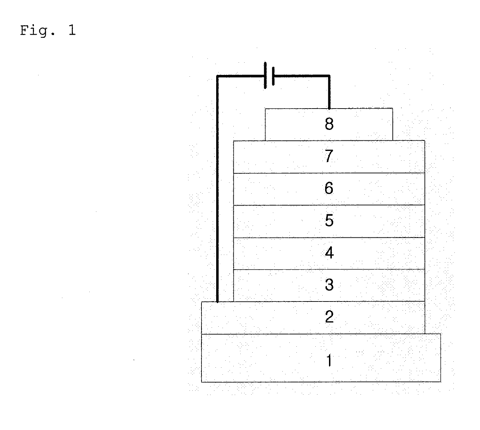

Fig. 1 is a cross-sectional view of an OLED.

### DETAILED DESCRIPTION OF THE INVENTION

Referring now to the Drawings, Fig. 1 illustrates a cross-sectional view of an OLED of the present invention comprising a Glass 1, Transparent electrode 2, Hole injecting layer 3, Hole transport layer 4, Electroluminescent layer 5, Electron transport layer 6, Electron injecting layer 7 and A1 cathode 8.

The term "alkyl" and "alkoxy" described herein and any substituents comprising "alkyl" moiety include both linear and branched species.

The term "aryl" described herein means an organic radical derived from aromatic hydrocarbon via elimination of one hydrogen atom. Each ring suitably comprises a monocyclic or fused ring system containing from 4 to 7, preferably from 5 to 6 cyclic atoms. Specific examples include phenyl, naphthyl, biphenyl, anthryl, tetrahydronaphthyl, indenyl, fluorenyl, phenanthryl, triphenylenyl, pyrenyl, perylenyl, chrysenyl, naphthacenyl and fluoranthenyl, but they are not restricted thereto.

The term "heteroaryl" described herein means an aryl group containing from 1 to 4 heteroatom(s) selected from N, O and S for the aromatic cyclic backbone atoms, and carbon atom(s) for remaining aromatic cyclic backbone atoms. The heteroaryl may be a 5- or 6-membered monocyclic heteroaryl or a polycyclic heteroaryl which is fused with one or more benzene ring(s), and may be partially saturated. Specific examples include monocyclic heteroaryl groups such as furyl, thiophenyl, pyrrolyl, imidazolyl, pyrazolyl, thiazolyl, thiadiazolyl, isothiazolyl, isoxazolyl, oxazolyl, oxadiazolyl, triazinyl, tetrazinyl, triazolyl, tetrazolyl, furazanyl, pyridyl, pyrazinyl, pyrimidinyl, pyridazinyl; polycyclic heteroaryl groups such as benzofuranyl, benzothiophenyl, isobenzofuranyl, benzimidazolyl, benzothiazolyl, benzisothiazolyl, benzisoxazolyl, benzoxazolyl, isoindolyl, indolyl, indazolyl, benzothiadiazolyl, quinolyl, isoquinolyl, cinnolinyl, quinazolinyl, quinolizinyl, quinoxalinyl, carbazolyl, phenanthridinyl and benzodioxolyl; but they are not restricted thereto.

The naphthyl of the compounds according to the invention may be 1-naphthyl or 2-naphthyl; the anthryl may be 1-anthryl, 2-anthryl or 9-anthryl; and the fluorenyl may be 1-fluorenyl, 2-fluorenyl, 3-fluorenyl, 4-fluorenyl or 9-fluorenyl.

The substituents comprising "(C1-C60)alkyl" moiety described herein may contain 1 to 60 carbon atoms, 1 to 20 carbon atoms, or 1 to 10 carbon atoms. The substituents comprising "(C6-C60)aryl" moiety may contain 6 to 60 carbon atoms, 6 to 20 carbon atoms, or 6 to 12 carbon atoms. The substituents comprising "(C3-C60)heteroaryl" moiety may contain 3 to 60 carbon atoms, 4 to 20 carbon atoms, or 4 to 12 carbon atoms. The substituents comprising "(C3-C60)cycloalkyl" moiety may contain 3 to 60 carbon atoms, 3 to 20 carbon atoms, or 3 to 7 carbon atoms. The substituents comprising "(C2-C60)alkenyl or alkynyl" moiety may contain 2 to 60 carbon atoms, 2 to 20 carbon atoms, or 2 to 10 carbon atoms.

The organic electroluminescent device according to the present invention shows efficient mechanism for energy transfer between host and dopant, so that it may ensure high efficiency of luminescent properties on the basis of the improved electron density distribution. In addition, the device can overcome the property of lowered efficiency at early stage and poor life property, which were possessed by conventional materials, and ensure the luminescent properties of high efficiency with long life for each color.

In the host compound represented by Chemical Formula (1), Ar₁ and Ar₂ independently represent phenyl, naphthyl, fluorenyl, biphenyl, fluoranthenyl, perylenyl, pyrenyl, phenanthrenyl, spirobifluorenyl, pyridyl or quinolyl; R₁ and R₂ represent methyl, ethyl, n-propyl, i-propyl, n-butyl, i-butyl, t-butyl, n-pentyl, i-pentyl, n-hexyl, n-heptyl, n-octyl, 2-ethylhexyl, n-nonyl, decyl, dodecyl, hexadecyl, methoxy, ethoxy, n-propoxy, i-propoxy, n-butoxy, i-butoxy, t-butoxy, n-pentoxy, i-pentoxy, n-hexyloxy, n-heptoxy, fluoro, cyclopropyl, cyclobutyl, cyclopentyl, cyclohexyl, cycloheptyl, cyclooctyl, cyclononyl, cyclodecyl, phenyl, naphthyl, fluorenyl, biphenyl, fluoranthenyl, perylenyl, pyrenyl, phenanthrenyl, spirobifluorenyl, pyridyl or quinolyl; and the phenyl, naphthyl, fluorenyl, biphenyl, fluoranthenyl, perylenyl, pyrenyl, phenanthrenyl, spirobifluorenyl, pyridyl or quinolyl of Ar₁, Ar₂, R₁ and R₂ may be further substituted by one or more substituent(s) selected from deuterium, methyl, ethyl, n-propyl, i-propyl, n-butyl, i-butyl, t-butyl, n-pentyl, i-pentyl, n-hexyl, n-heptyl, n-octyl, 2-ethylhexyl, n-nonyl, decyl, dodecyl, hexadecyl, methoxy, ethoxy, n-propoxy, i-propoxy, n-butoxy, i-butoxy, t-butoxy, n-pentoxy, i-pentoxy, n-hexyloxy, n-heptoxy, fluoro, cyclopropyl, cyclobutyl, cyclopentyl, cyclohexyl, cycloheptyl, cyclooctyl, cyclononyl, cyclodecyl, trimethylsilyl, triethylsilyl, tripropylsilyl, tri(t-butyl)silyl, t-butyldimethylsilyl, dimethylphenylsilyl, triphenylsilyl, phenyl, naphthyl, biphenyl, fluorenyl, phenanthryl, anthryl, fluoranthenyl, triphenylenyl, pyrenyl, chrysenyl, naphthacenyl, perylenyl, pyridyl, pyrrolyl, furanyl, thiophenyl, imidazolyl, benzimidazolyl, pyrazinyl, pyrimidinyl, pyridazinyl, quinolyl, triazinyl, benzofuranyl, benzothiophenyl, pyrazolyl, indolyl, carbazolyl, thiazolyl, oxazolyl, benzothiazolyl and benzoxazolyl.

The host compound of Chemical Formula (1) can be specifically exemplified by the following compounds, but they are not restricted thereto.

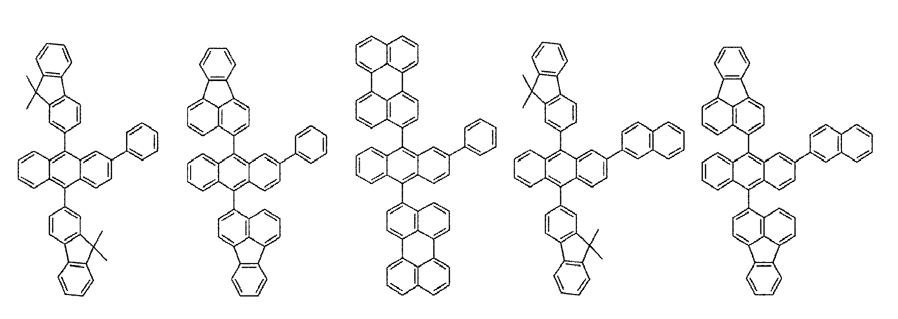

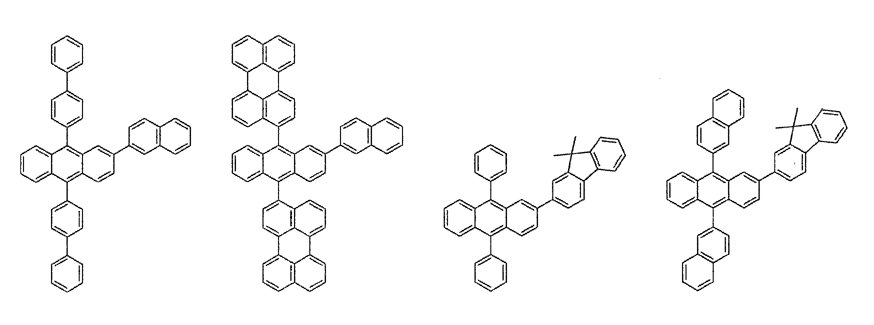

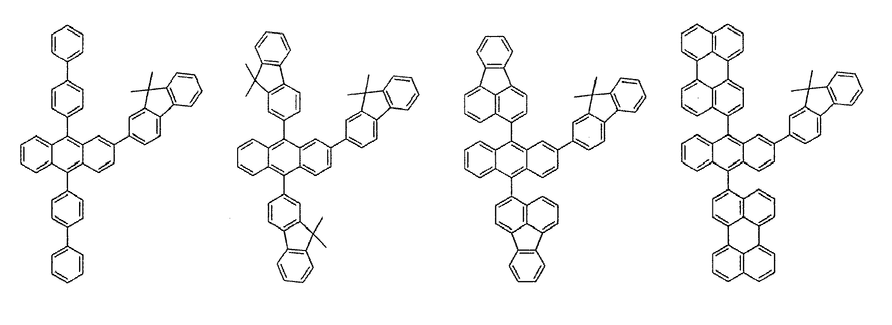

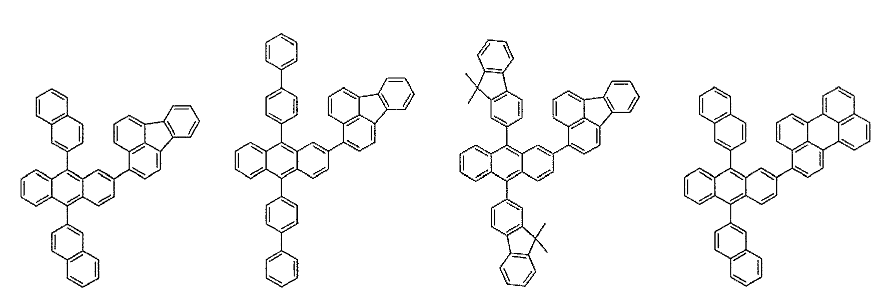

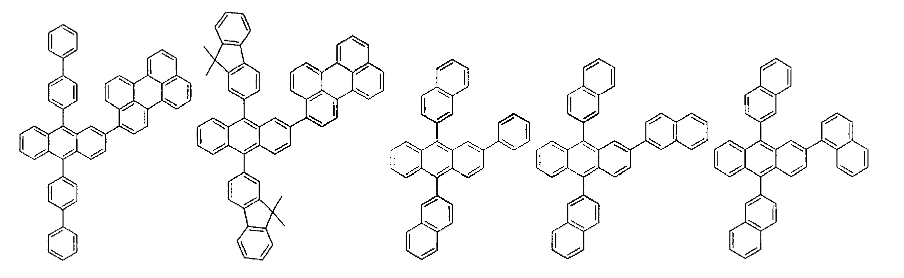

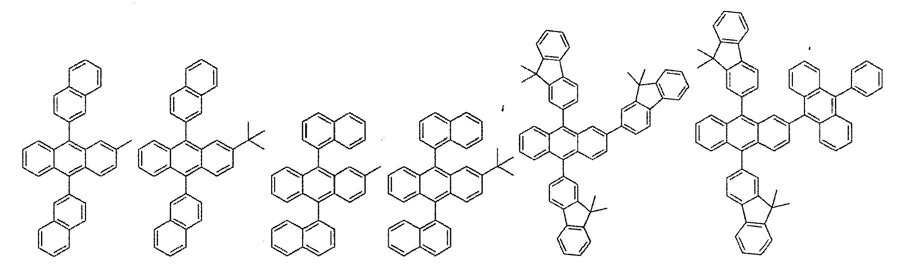

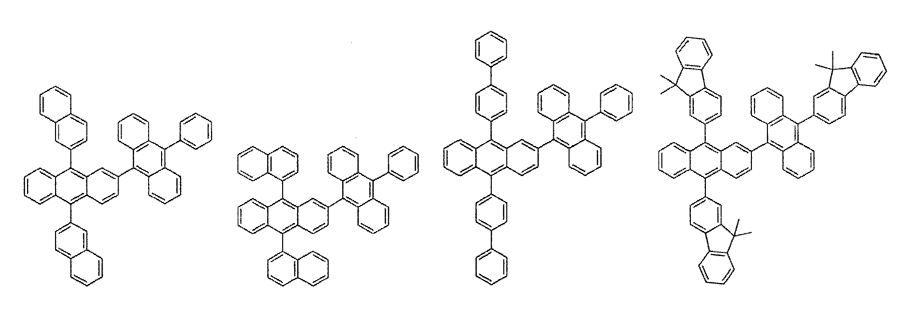

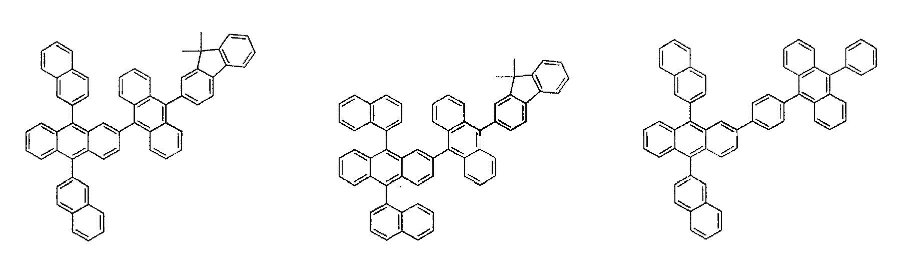

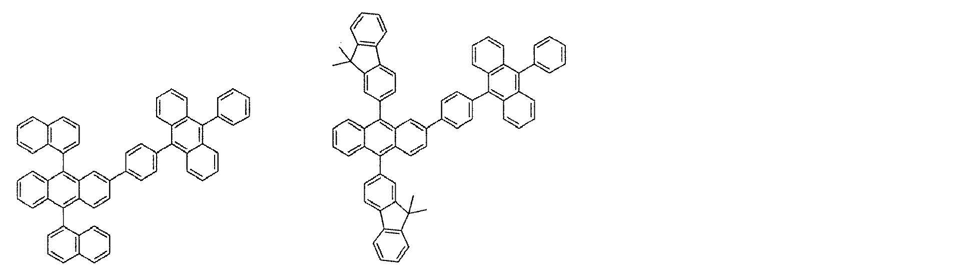

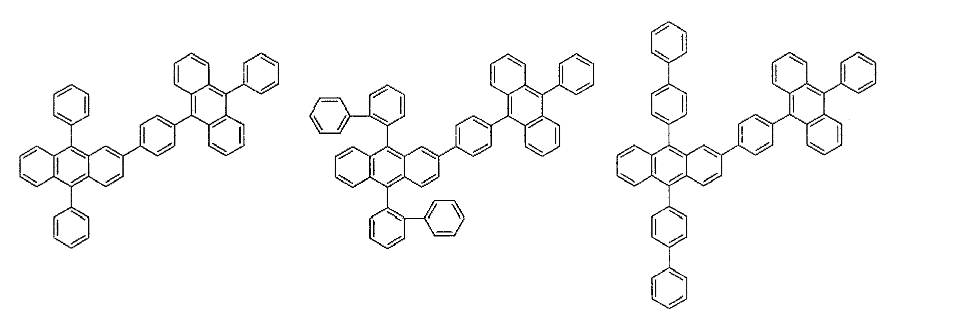

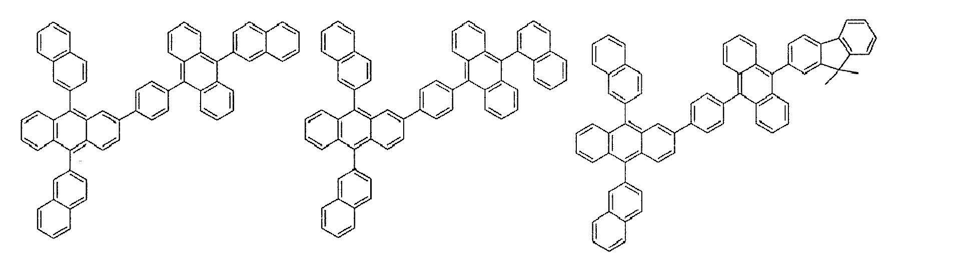

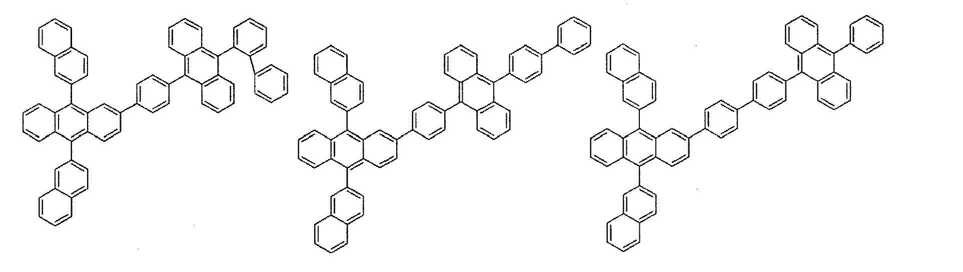

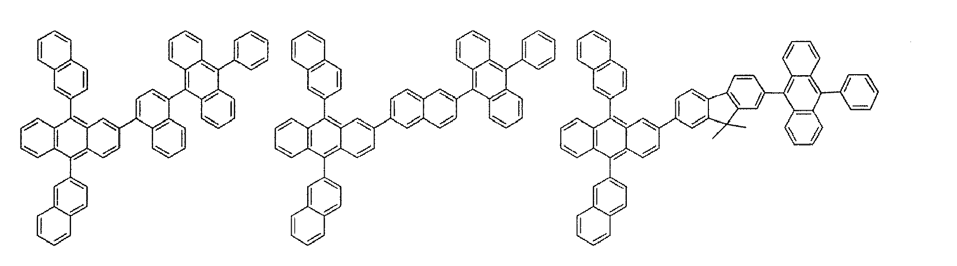

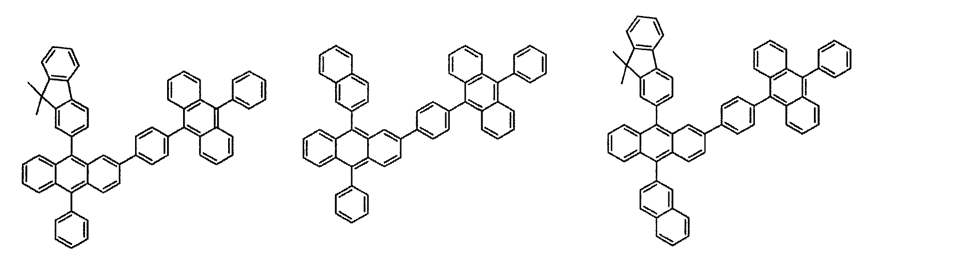

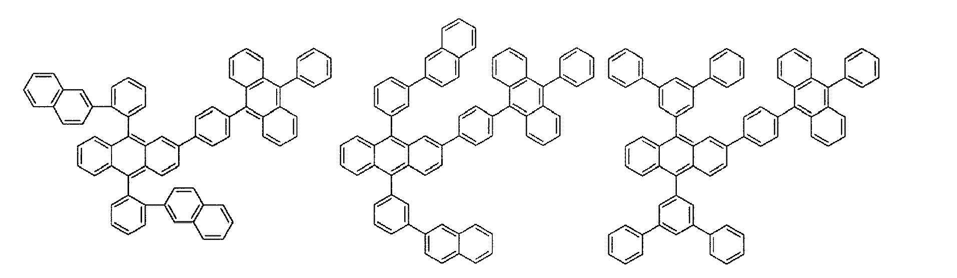

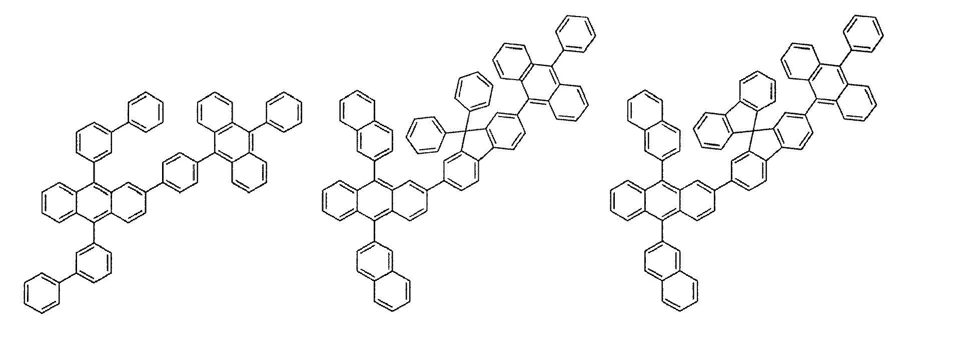

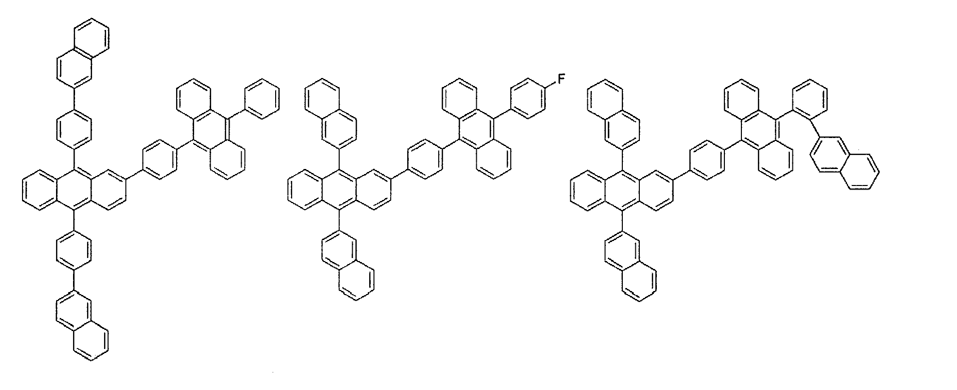

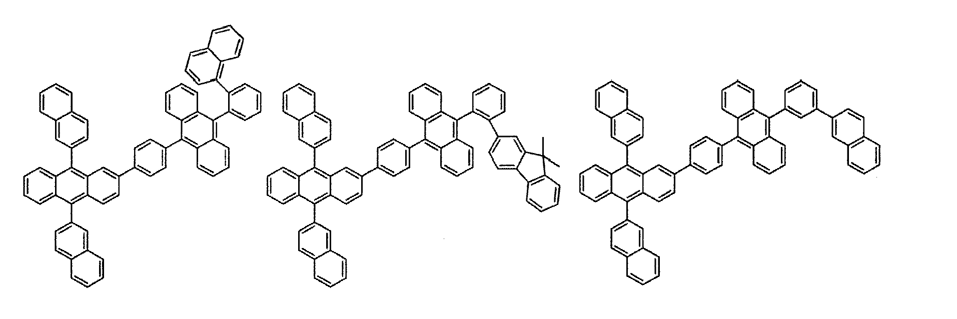

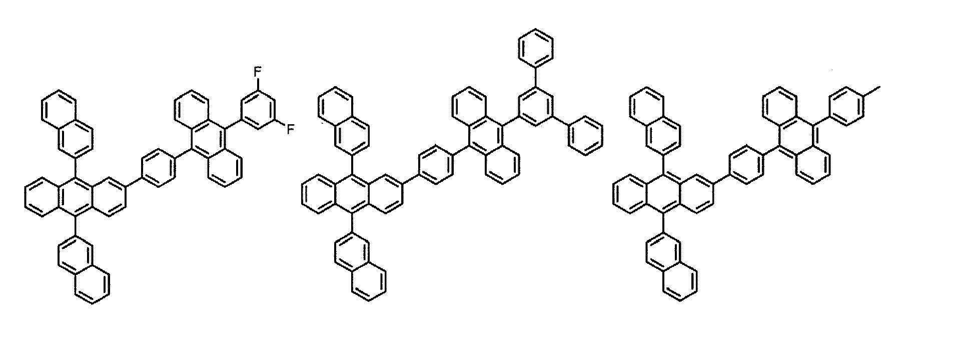

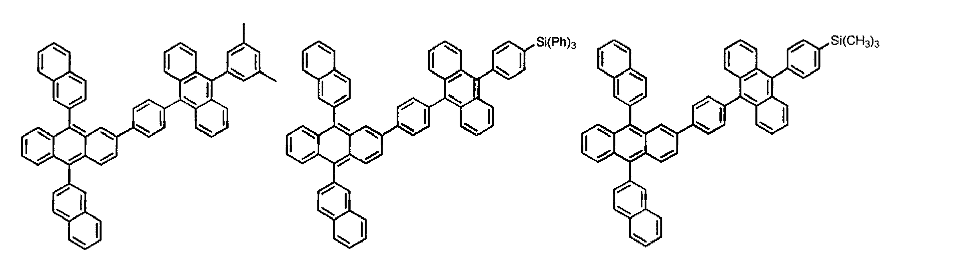

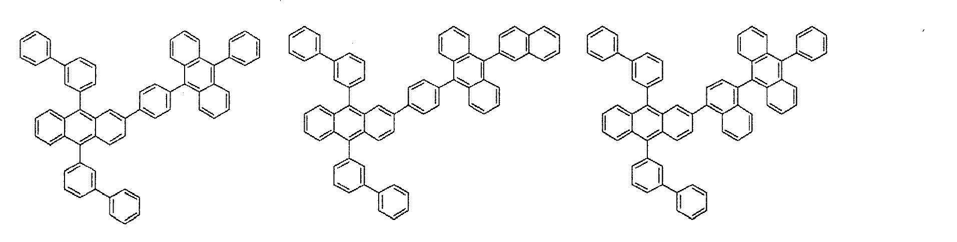

In the compounds of Chemical Formula (2), L may be selected from the following structures, but they are not restricted thereto: 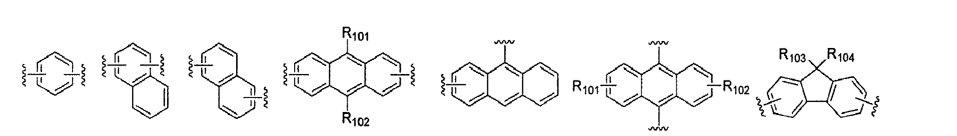 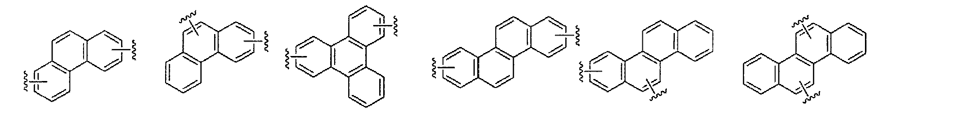 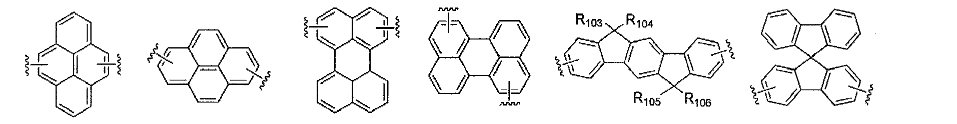 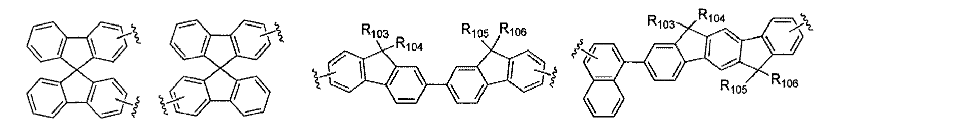 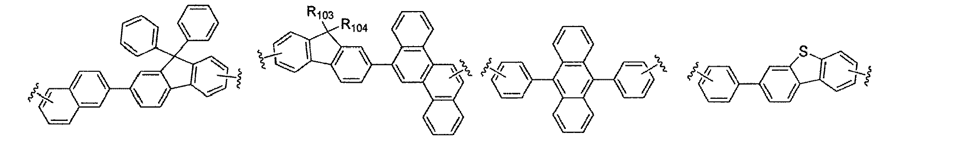 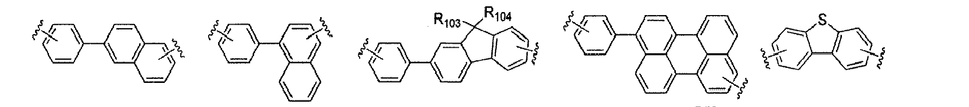 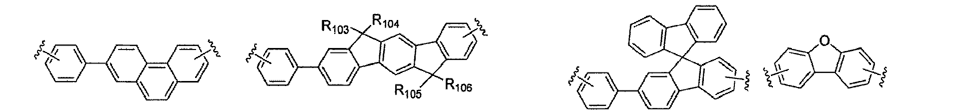 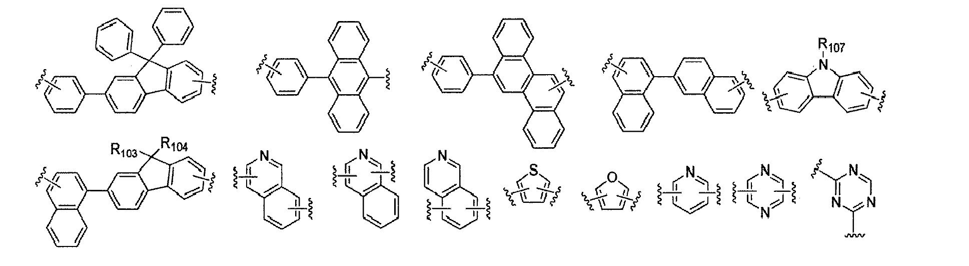 wherein, R₁₀₁ through R₁₀₇ independently represent hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl, or a substituent selected from the following structures; or each of R₁₀₁ through R₁₀₇ may be linked to an adjacent substituent via (C3-C60)alkylene or (C3-C60)alkenylene with or without a fused ring to form an alicyclic ring, or a monocyclic or polycyclic aromatic ring: 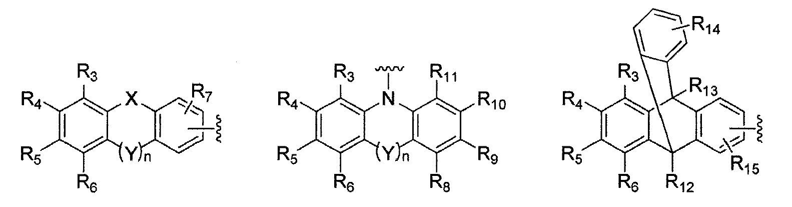 wherein, R₃ through R₁₅ independently represent hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl;
X and Y independently represent a chemical bond, or - C(R₂₁)(R₂₂)-, -N(R₂₃)-, -S-, -O-, -Si(R₂₄)(R₂₅)-, -P(R₂₆)-, - C(=O)-, -B(R₂₇)-, -In(R₂₈)-, -Se-, -Ge(R₂₉)(R₃₀)-, -Sn(R₃₁)(R₃₂)-, -Ga(R₃₃)-, or -(R₃₄)C=C(R₃₅)-;
R₂₁ through R₃₅ independently represent hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl; or each of R₂₁ through R₃₅ may be linked to an adjacent substituent via (C3-C60)alkylene or (C3-C60)alkenylene with or without a fused ring to form an alicyclic ring, or a monocyclic or polycyclic aromatic ring; the alkyl, alkenyl, alkynyl, cycloalkyl, heterocycloalkyl, aryl, heteroaryl, arylsilyl, alkylsilyl, alkylamino and arylamino of R₁₀₁ through R₁₀₇ may be further substituted by one or more substituent(s) selected from deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl; and
n is an integer from 0 to 4.

In the dopant compound of Chemical Formula (2), R₄₁ through R₄₄ independently represent methyl, ethyl, n-propyl, i-propyl, n-butyl, i-butyl, t-butyl, n-pentyl, i-pentyl, n-hexyl, n-heptyl, n-octyl, 2-ethylhexyl, n-nonyl, decyl, dodecyl, hexadecyl, cyclopropyl, cyclobutyl, cyclopentyl, cyclohexyl, cycloheptyl, cyclooctyl, cyclononyl, cyclodecyl, morpholino, thiomorpholino, phenyl, naphthyl, fluorenyl, biphenyl, pyridyl or quinolyl, or each of R₄₁ through R₄₄ may be linked to an adjacent substituent via (C4-C12)alkylene or (C4-C12)alkenylene with or without a fused ring to form an alicyclic ring, or a monocyclic or polycyclic aromatic ring; and the phenyl, naphthyl, fluorenyl, biphenyl, pyridyl or quinolyl of R₄₁ through R₄₄ may be further substituted by one or more substituent(s) selected from deuterium, methyl, ethyl, n-propyl, i-propyl, n-butyl, i-butyl, t-butyl, n-pentyl, i-pentyl, n-hexyl, n-heptyl, n-octyl, cyclopropyl, cyclobutyl, cyclopentyl, cyclohexyl, cycloheptyl, cyclooctyl, cyclononyl, cyclodecyl, trimethylsilyl, triethylsilyl, tripropylsilyl, tri(t-butyl)silyl, t-butyldimethylsilyl, dimethylphenylsilyl, triphenylsilyl, phenyl and fluorenyl.

The dopant compound of Chemical Formula (2) can be specifically exemplified by the following compounds, but they are not restricted thereto.

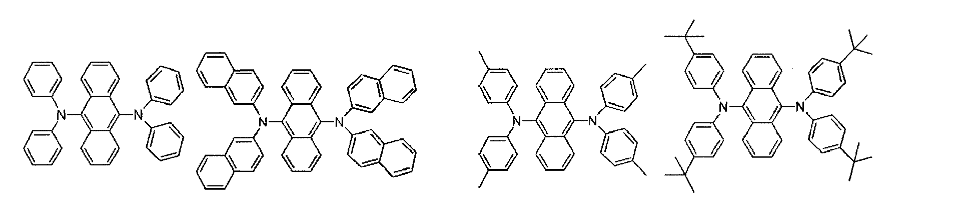

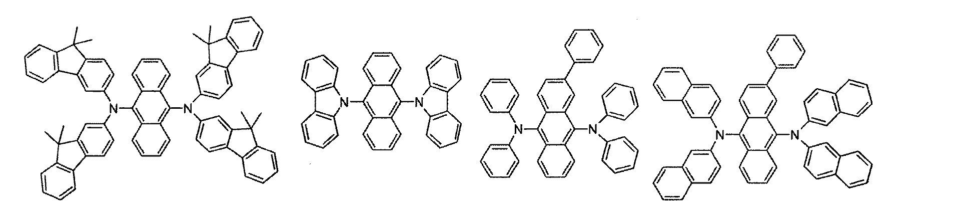

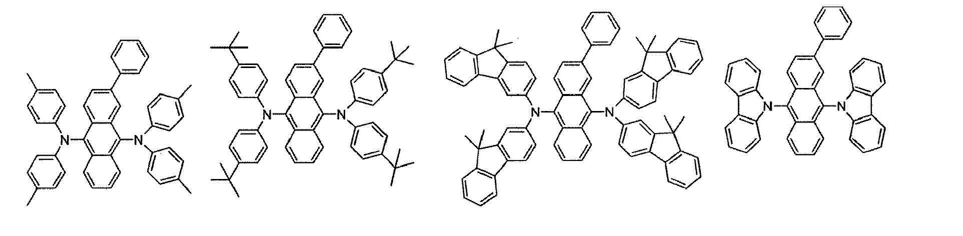

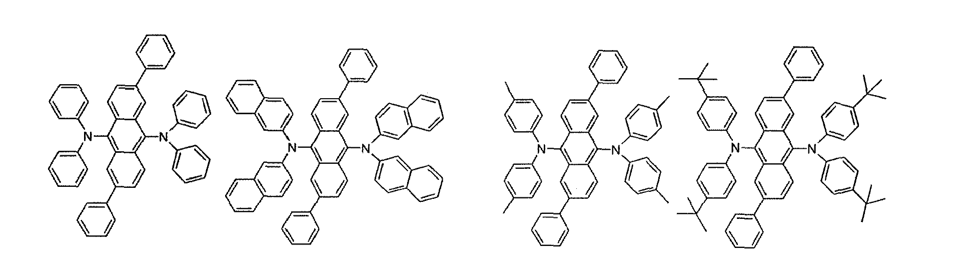

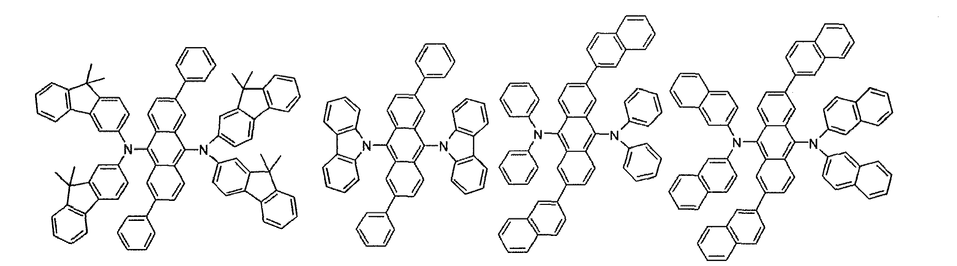

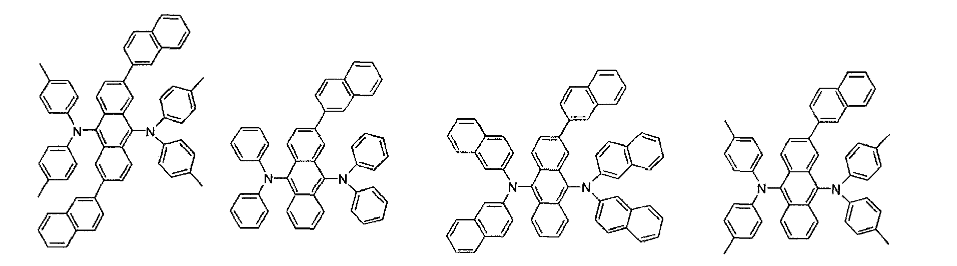

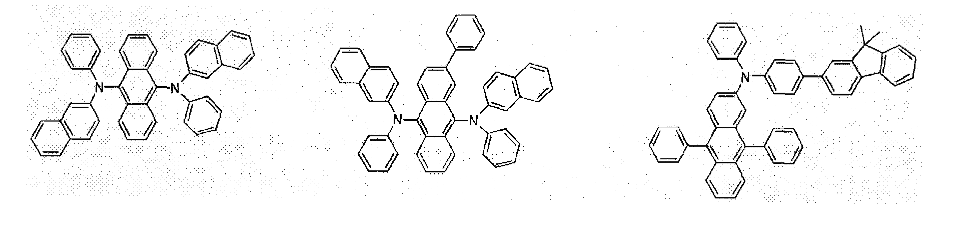

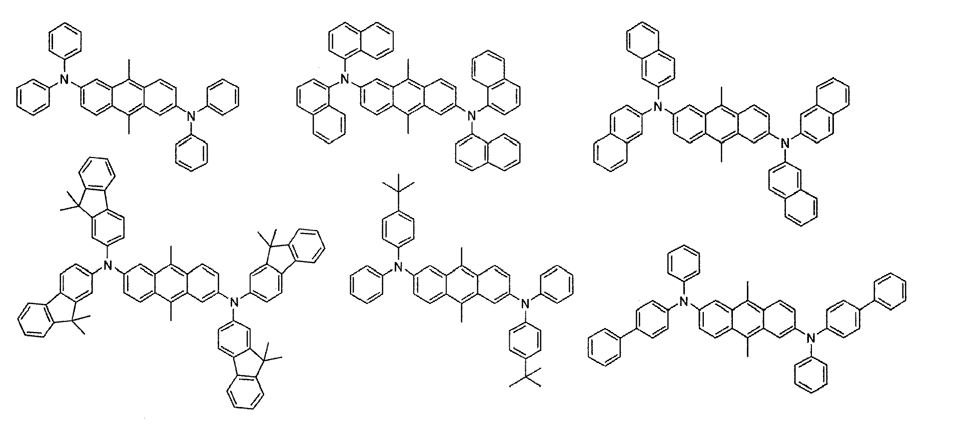

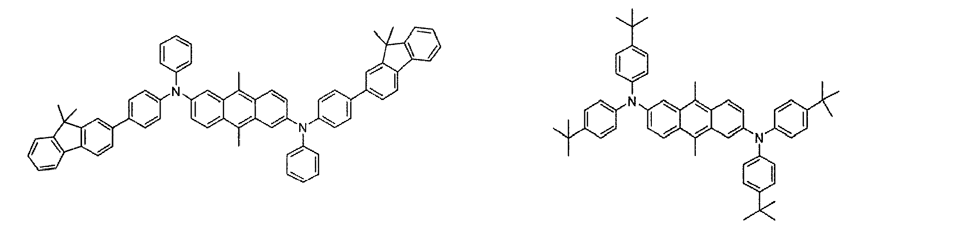

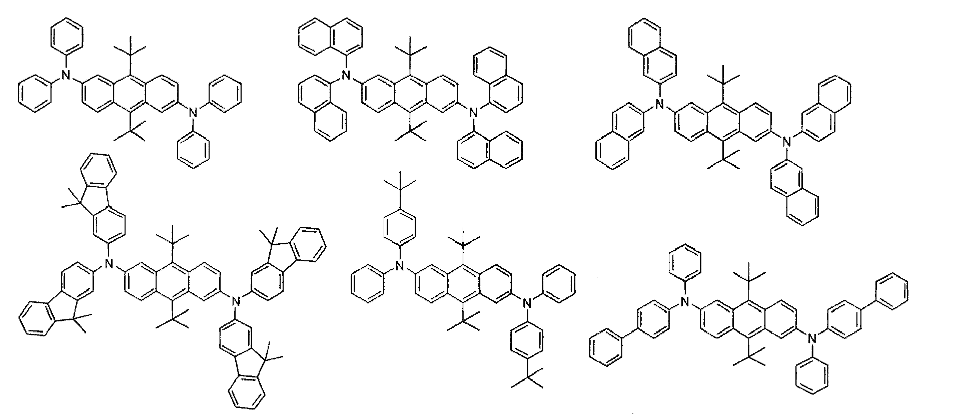

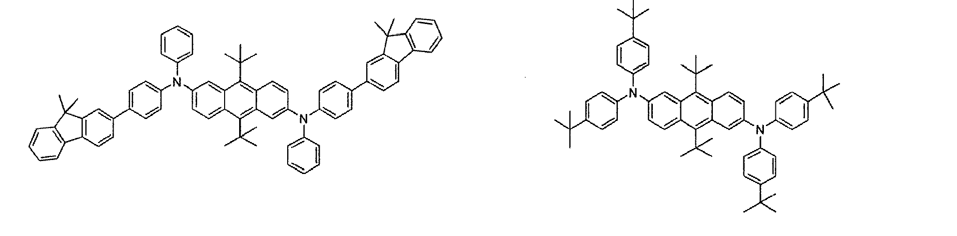

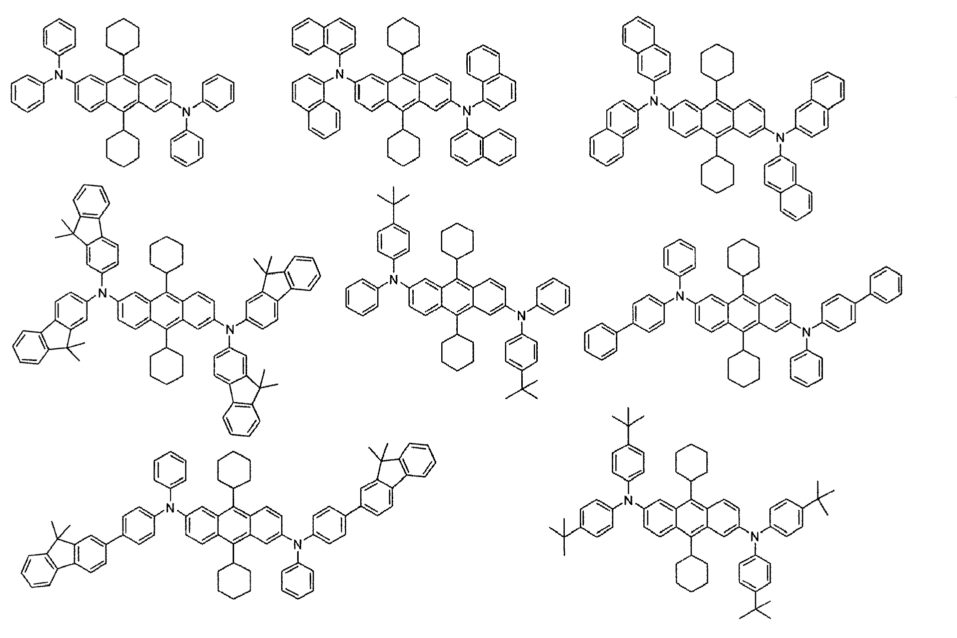

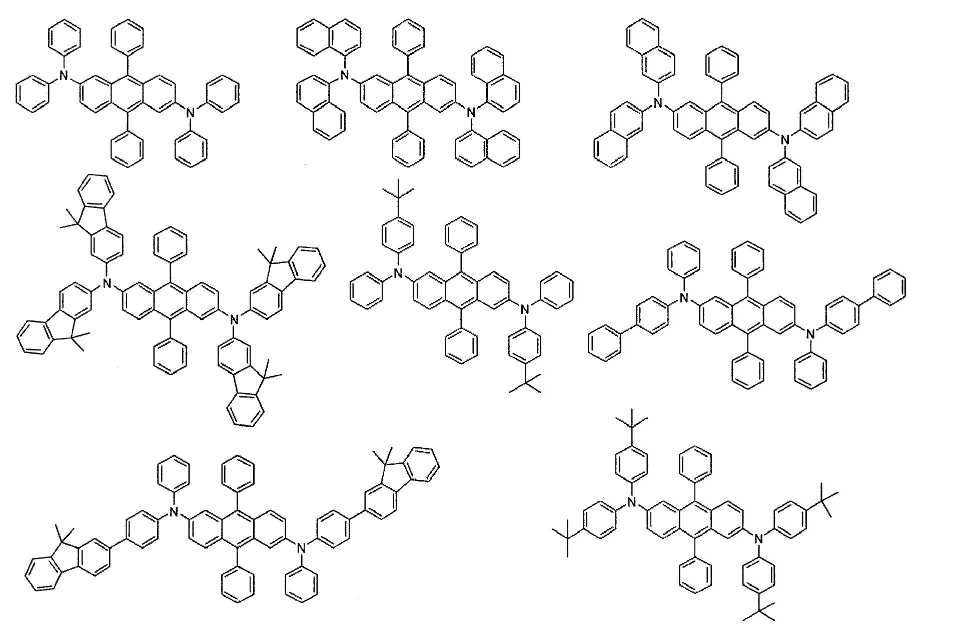

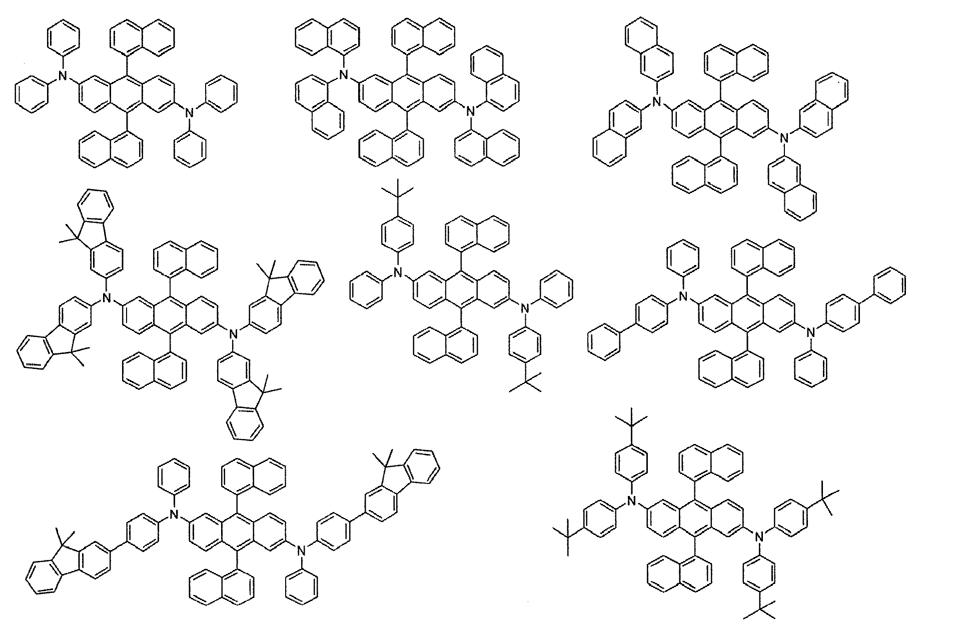

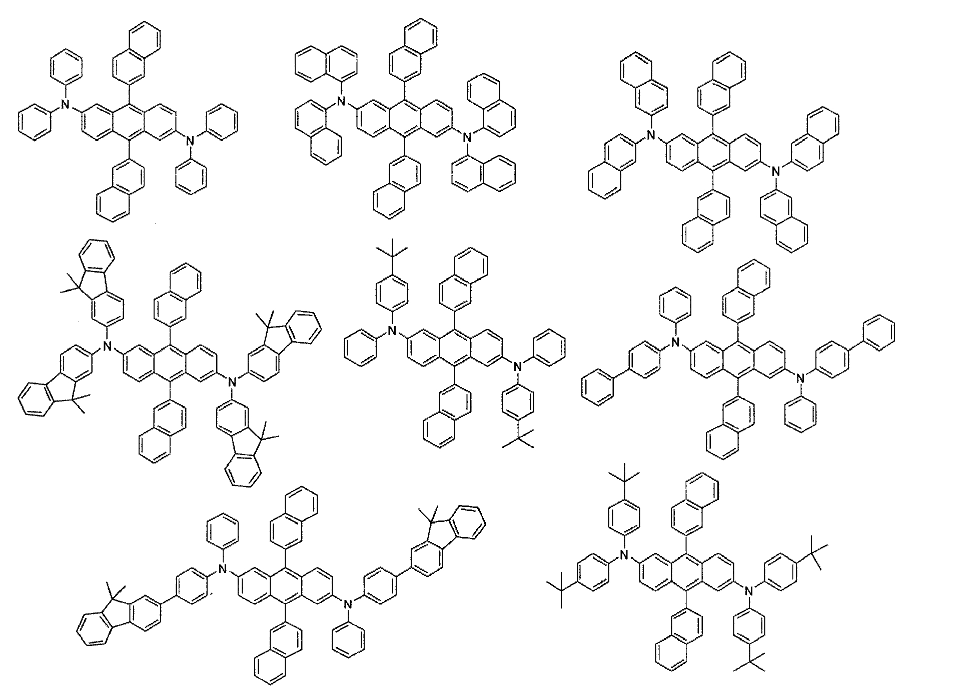

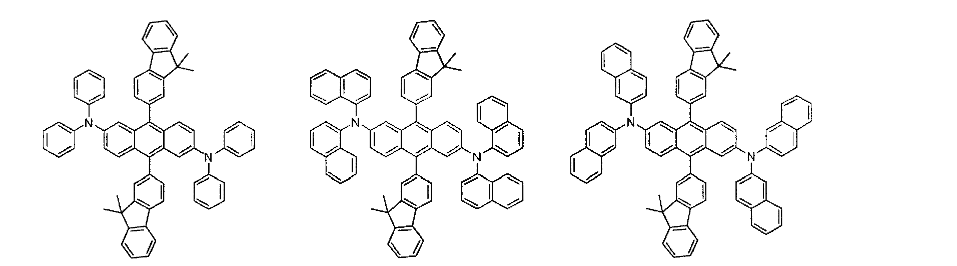

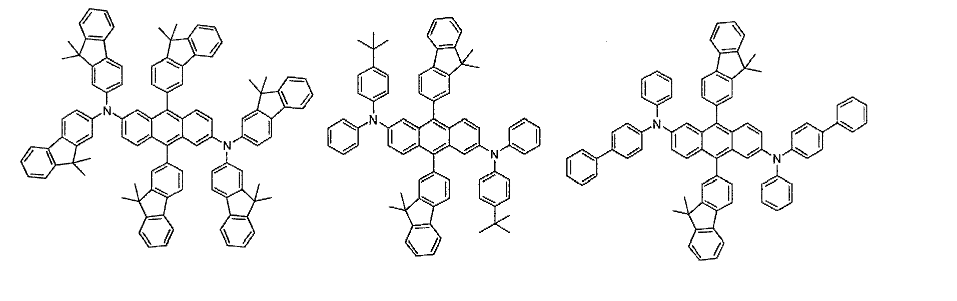

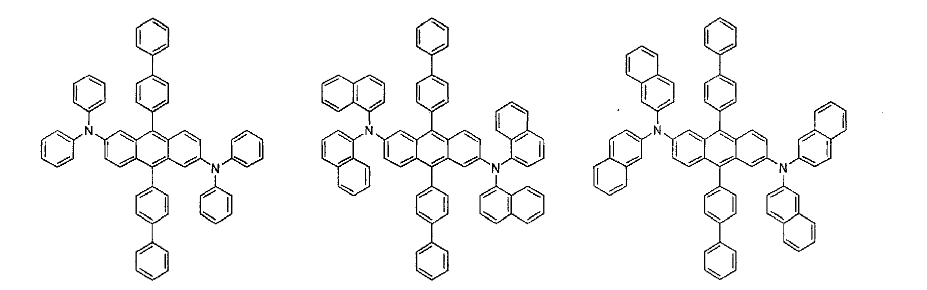

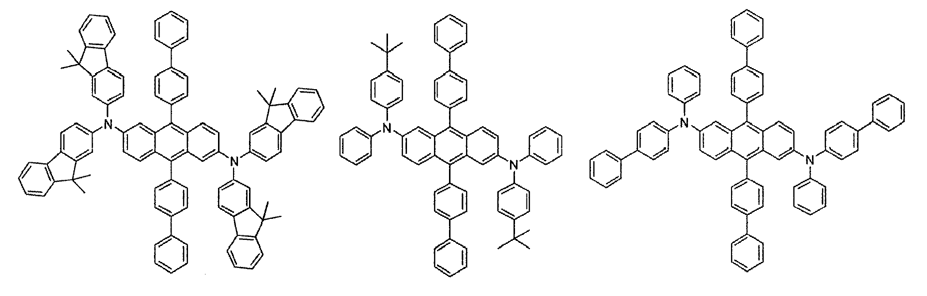

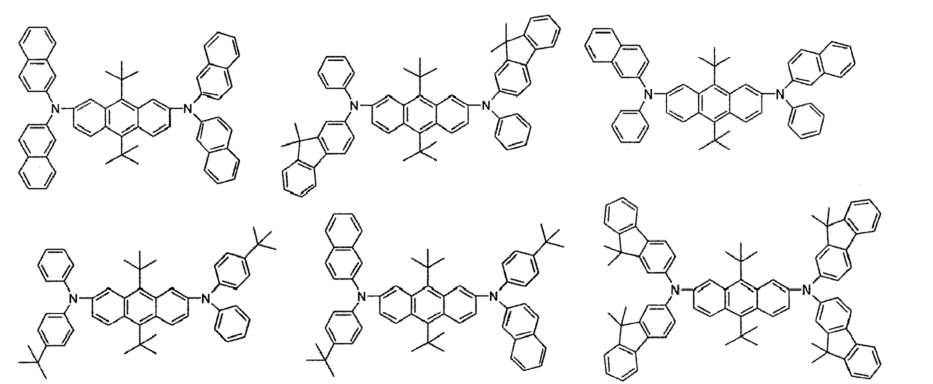

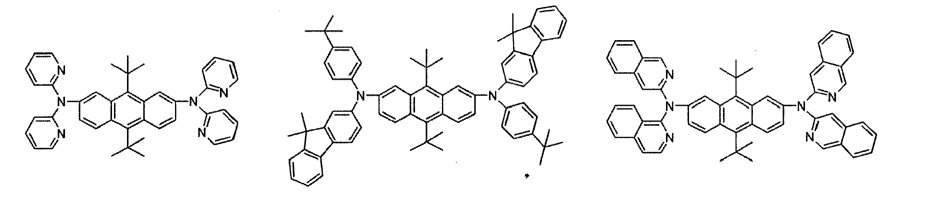

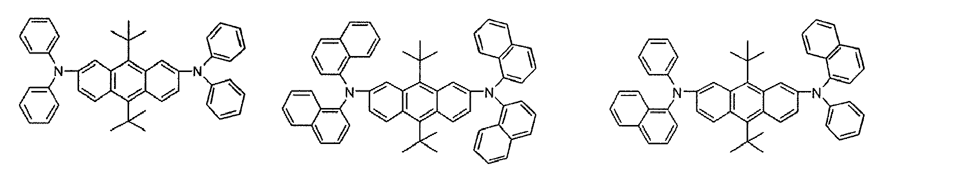

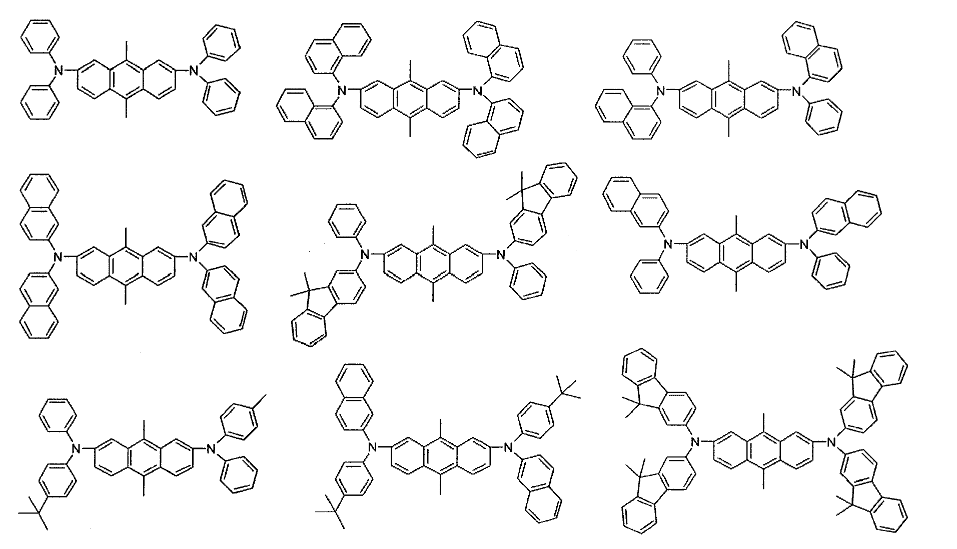

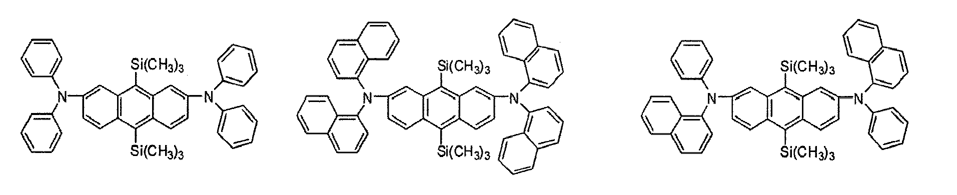

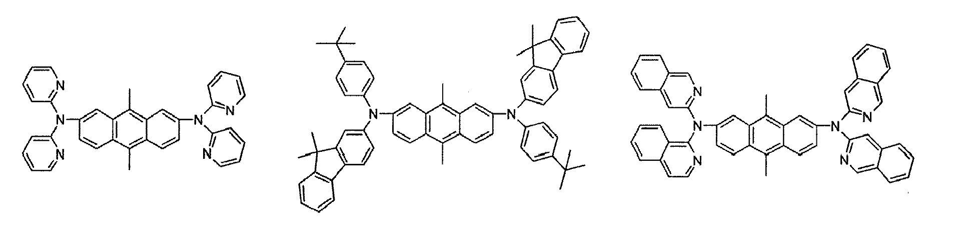

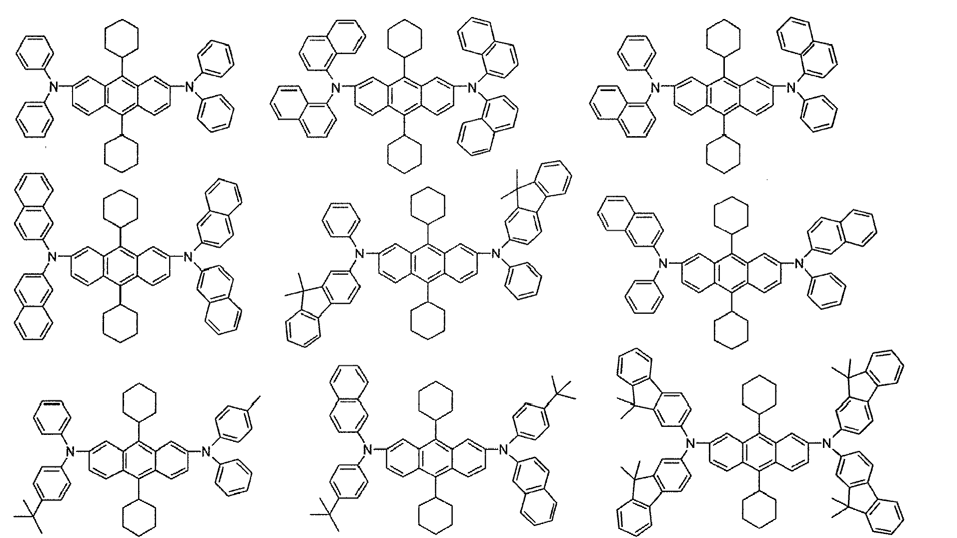

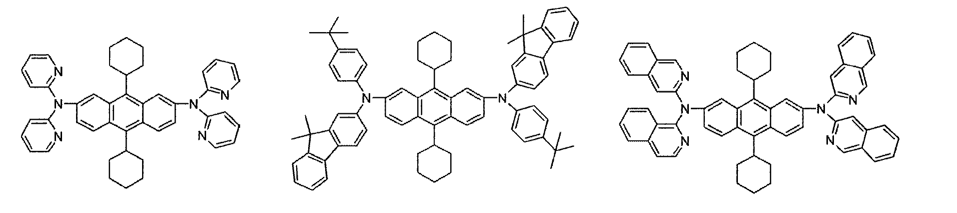

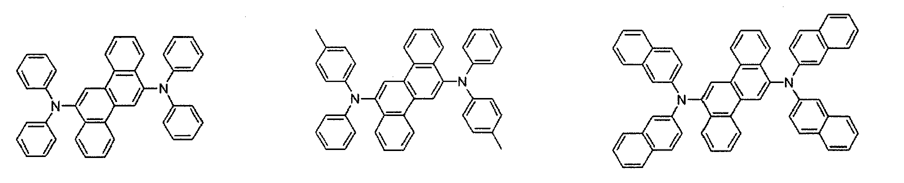

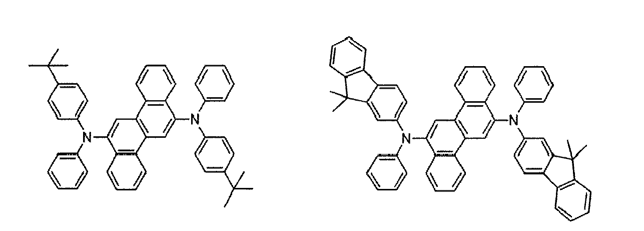

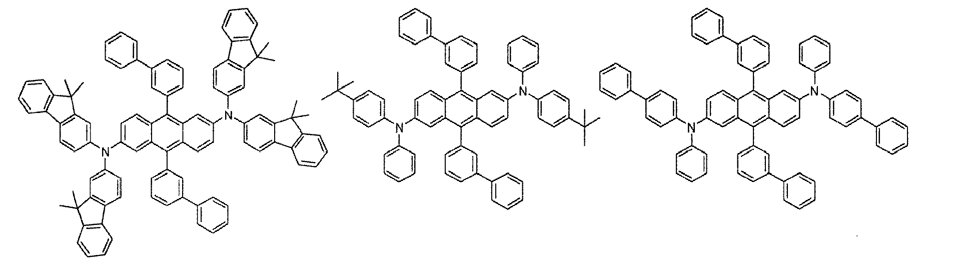

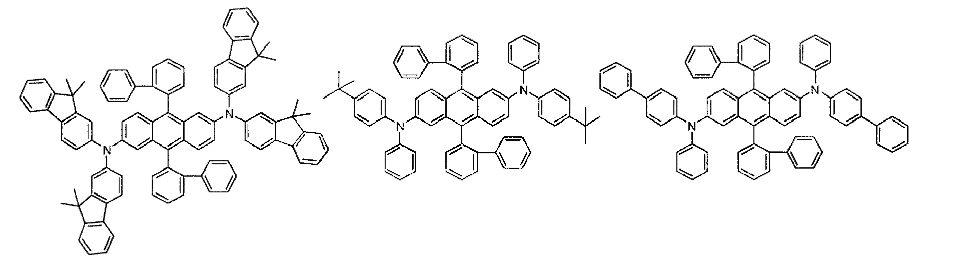

The electroluminescent layer means the layer where electroluminescence occurs, and it may be a single layer or a multi-layer consisting of two or more layers laminated. When a mixture of host-dopant is used according to the construction of the present invention, the doping concentration of the dopant of Chemical Formula (2) may be 0.5 to 20% by weight on the basis of the host of Chemical Formula (1). The electroluminescent device according to the present invention exhibits higher hole and electron conductivity, and excellent stability of the material as compared to conventional technique, and provides improved device life as well as luminous efficiency.

The present invention also provides organic solar cells, which comprises one or more organic electroluminescent compound(s) represented by Chemical Formula (1) or Chemical Formula (2).

The organic electroluminescent device according to the invention may further comprise one or more compound(s) selected from a group consisting of arylamine compounds and styrylarylamine compounds, as well as the organic electroluminescent compounds represented by Chemical Formula (1) and Chemical Formula (2). Examples of arylamine or styrylarylamine compounds include the compounds represented by Chemical Formula (3), but they are not restricted thereto: 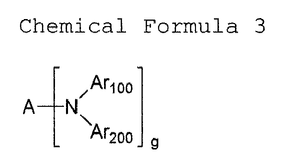 wherein, Ar₁₀₀ and Ar₂₀₀ independently represent hydrogen, deuterium, halogen, (C1-C60)alkyl, (C6-C60)aryl, (C4-C60)heteroaryl, mono or di-(C6-C60)arylamino, mono or di-(C1-C60)alkylamino, a 5- or 6-membered heterocycloalkyl containing one or more heteroatom(s) selected from N, O and S, or (C3-C60)cycloalkyl, or Ar₁₀₀ and Ar₂₀₀ may be linked via (C3-C60)alkylene or (C3-C60)alkenylene with or without a fused ring to form an alicyclic ring, or a monocyclic or polycyclic aromatic ring;
when g is 1, A represents (C6-C60)arylamino, (C6-C60)aryl, (C4-C60)heteroaryl, or a substituent represented by one of the following structural formulas: 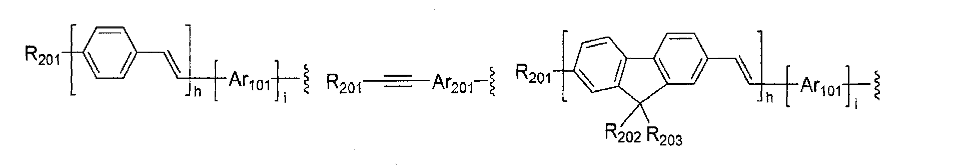 when g is 2, A represents (C6-C60)arylene, (C4-C60)heteroarylene, or a substituent represented by one of the following structural formulas: 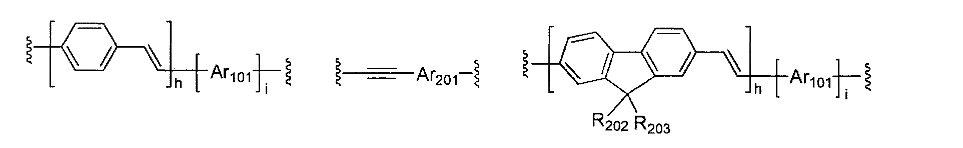 wherein Ar₁₀₁ and Ar₂₀₁ independently represent (C6-C60)arylene or (C4-C60)heteroarylene;
R₂₀₁ through R₂₀₃ independently represent hydrogen, halogen, deuterium, (C1-C60)alkyl or (C6-C60)aryl;
h is an integer from 1 to 4, i is an integer of 0 or 1; and
the alkyl, aryl, heteroaryl, arylamino, alkylamino, cycloalkyl or heterocycloalkyl of Ar₁₀₀ and Ar₂₀₀; the arylamino, aryl, heteroaryl, arylene or heteroarylene of A; the arylene or heteroarylene of Ar₁₀₁ and Ar₂₀₁; or the alkyl or aryl of R₂₀₁ through R₂₀₃ may be further substituted by one or more substituent(s) selected from a group consisting of deuterium, halogen, (C1-C60)alkyl, (C6-C60)aryl, (C4-C60)heteroaryl, 5-or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, mono or di-(C1-C60)alkylamino, mono or di-(C6-C60)arylamino, (C6-C60)ar(C1-C60)alkyl, (C6-C60)aryloxy, (C1-C60)alkoxy, (C6-C60)arylthio, (C1-C60)alkylthio, (C1-C60)alkoxycarbonyl, (C1-C60)alkylcarbonyl, (C6-C60)arylcarbonyl, carboxyl, nitro and hydroxyl.

The arylamine compounds and styrylarylamine compounds may be more specifically exemplified by the following compounds, but are not restricted thereto.

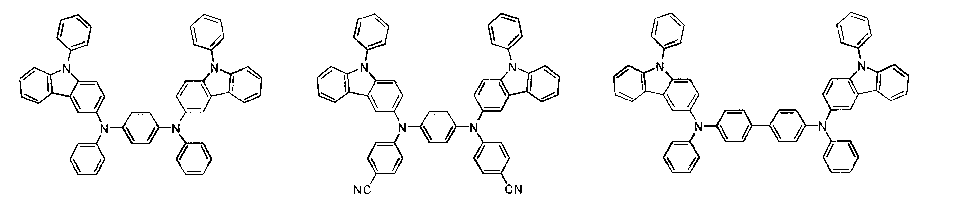

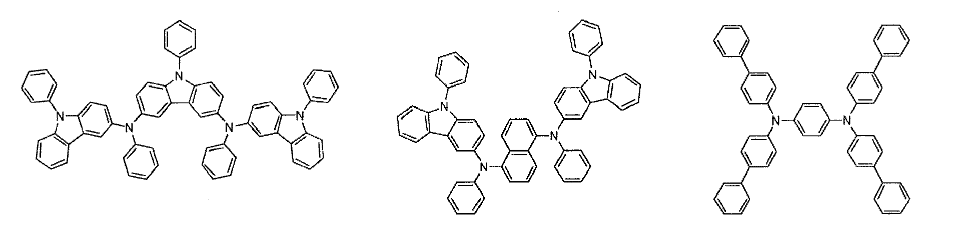

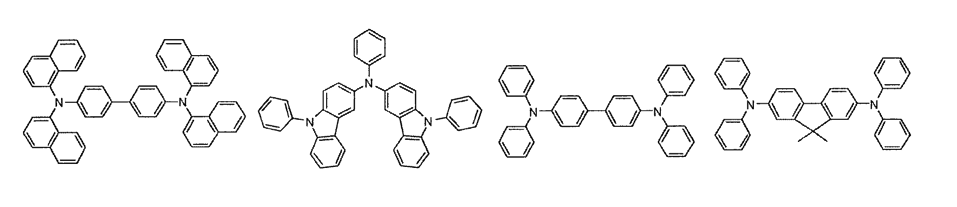

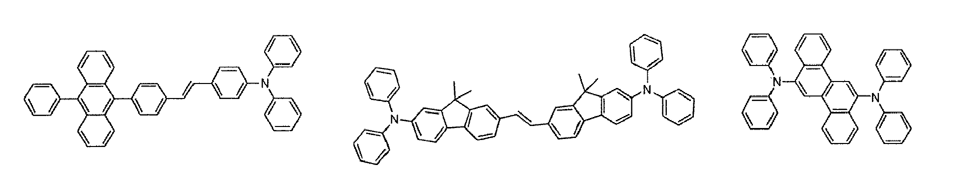

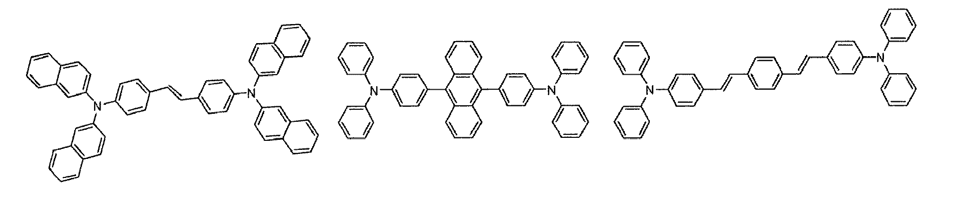

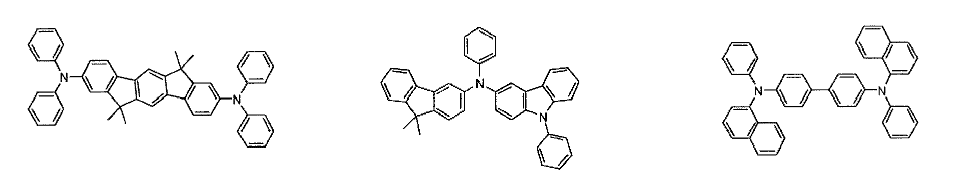

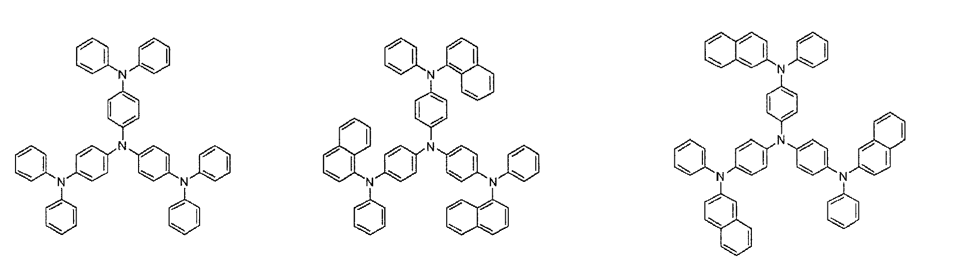

In an organic electroluminescent device according to the present invention, the organic layer may further comprise one or more metal(s) selected from a group consisting of organic metals of Group 1, Group 2, 4^{th} period and 5^{th} period transition metals, lanthanide metals and d-transition elements, as well as the organic electroluminescent compounds represented by Chemical Formula (1) and Chemical Formula (2). The organic layer may comprise a charge generating layer in addition to the electroluminescent layer.

The present invention can realize an organic electroluminescent device having a pixel structure of independent light-emitting mode, which comprises an organic electroluminescent device containing the compounds of Chemical Formula (1) and Chemical Formula (2) as a sub-pixel and one or more sub-pixel(s) comprising one or more compound(s) selected from a group consisting of Ir, Pt, Pd, Rh, Re, Os, Tl, Pb, Bi, In, Sn, Sb, Te, Au and Ag, patterned in parallel at the same time.

Further, the organic electroluminescent device is an organic electroluminescent display wherein the organic layer comprises, in addition to the organic electroluminescent compound according to the invention, one or more compound(s) selected from compounds having electroluminescent peak of wavelength of not more than 500 nm or those having electroluminescent peak of wavelength of not less than 560 nm, at the same time. The compounds having electroluminescent peak of wavelength of not more than 500 nm or those having electroluminescent peak of wavelength of not less than 560 nm may be exemplified by the compounds represented by one of Chemical Formulas (4) to (10), but they are not restricted thereto.

**M¹L³L⁴L⁵** Chemical Formula 4

In Chemical Formula (4), M¹ is selected from Group 7, 8, 9, 10, 11, 13, 14, 15 and 16 metals in the Periodic Table of Elements, and ligands L³, L⁴ and L⁵ are independently selected from the following structures: 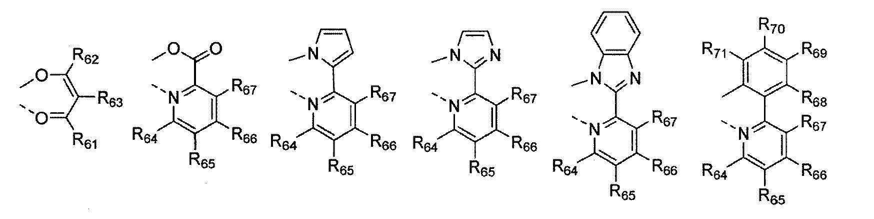 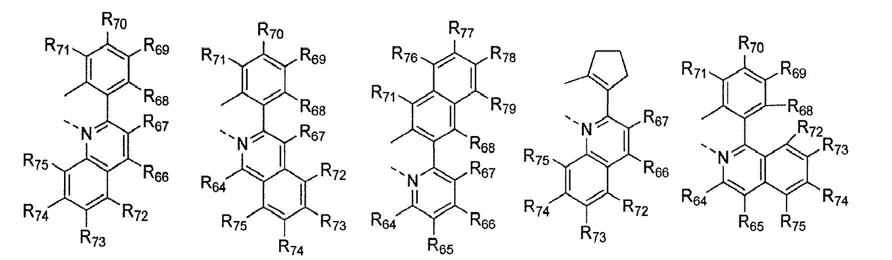 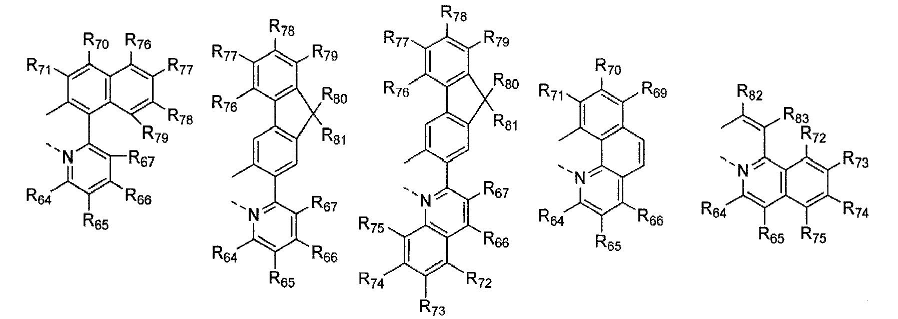 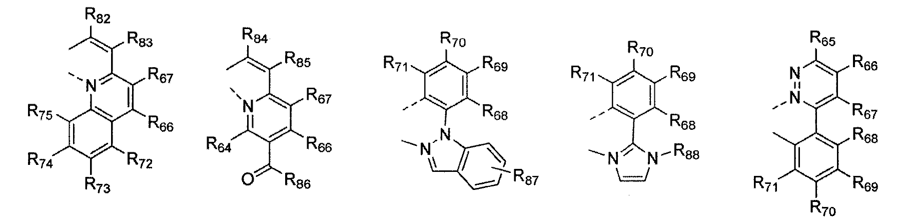 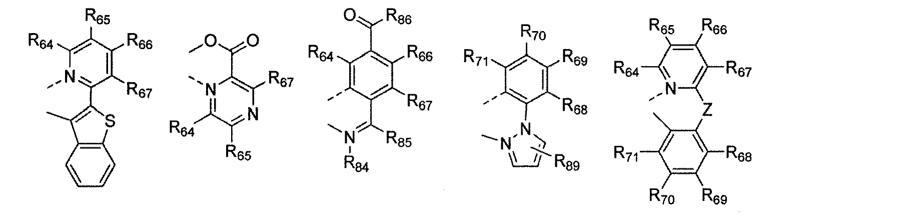 wherein, R₆₁ through R₆₃ independently represent hydrogen, deuterium, (C1-C60)alkyl with or without halogen substituent(s), (C6-C60)aryl with or without (C1-C60)alkyl substituent(s), or halogen;
R₆₄ through R₇₉ independently represent hydrogen, deuterium, (C1-C60)alkyl, (C1-C30)alkoxy, (C3-C60)cycloalkyl, (C2-C30)alkenyl, (C6-C60)aryl, mono or di(C1-C30)alkylamino, mono or di(C6-30)arylamino, SF₅, tri(C1-C30)alkylsilyl, di(C1-C30)alkyl(C6-C30)arylsilyl, tri(C6-C30)arylsilyl, cyano or halogen, and the alkyl, cycloalkyl, alkenyl or aryl of R₆₄ through R₇₉ by linkage via alkylene or alkenylene may be further substituted by one or more substituent(s) selected from (C1-C60)alkyl, (C6-C60)aryl and halogen;
R₈₀ through R₈₃ independently represent hydrogen, deuterium, (C1-C60)alkyl with or without halogen substituent(s), or (C6-C60)aryl with or without (C1-C60)alkyl substituent(s);
R₈₄ and R₈₅ independently represent hydrogen, deuterium, (C1-C60)alkyl, (C6-C60)aryl or halogen, or R₈₄ and R₈₅ may be linked via (C3-C12)alkylene or (C3-C12)alkenylene with or without a fused ring to form an alicyclic ring, or a monocyclic or polycyclic aromatic ring; and the alkyl or aryl of R₈₄ and R₈₅, or the alicyclic ring, or the monocyclic or polycyclic aromatic ring formed from R₈₄ and R₈₅ via (C3-C12)alkylene or (C3-C12)alkenylene with or without a fused ring may be further substituted by one or more substituent(s) selected from (C1-C60)alkyl with or without halogen substituent(s), (C1-C30)alkoxy, halogen, tri(C1-C30)alkylsilyl, tri(C6-C30)arylsilyl and (C6-C60)aryl;
R₈₆ represents (C1-C60)alkyl, (C6-C60) aryl, (C5-C60)heteroaryl or halogen;
R₈₇ through R₈₉ independently represent hydrogen, deuterium, (C1-C60)alkyl, (C6-C60)aryl or halogen, and the alkyl or aryl of R₈₆ through R₈₉ may be further substituted by halogen or (C1-C60)alkyl;
Z represents 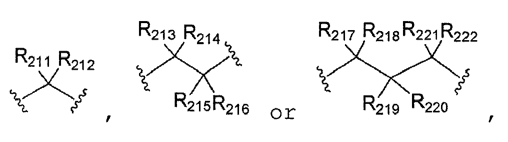 and R₂₁₁ through R₂₂₂ independently represent hydrogen, deuterium, (C1-C60)alkyl with or without halogen substituent(s), (C1-C30)alkoxy, halogen, (C6-C60)aryl, cyano, (C5-C60)cycloalkyl, or each of R₂₁₁ through R₂₂₂ may be linked to an adjacent substituent via alkylene or alkenylene to form a (C5-C7) spiro-ring or a (C5-C9) fused ring, or each of them may be linked to R₆₇ or R₆₈ via alkylene or alkenylene to form a (C5-C7) fused ring.

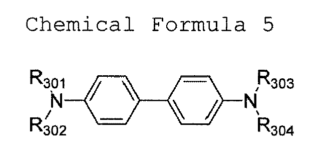

In Chemical Formula (5), R₃₀₁ through R₃₀₄ independently represent (C1-C60)alkyl or (C6-C60)aryl, or each of them may be linked to an adjacent substituent via (C3-C60)alkylene or (C3-C60)alkenylene with or without a fused ring to form an alicyclic ring, or a monocyclic or polycyclic aromatic ring; and the alkyl or aryl of R₃₀₁ through R₃₀₄, or the alicyclic ring, or the monocyclic or polycyclic aromatic ring formed therefrom by linkage via (C3-C60)alkylene or (C3-C60)alkenylene with or without a fused ring may be further substituted by one or more substituent(s) selected from deuterium, (C1-C60)alkyl with or without halogen substituent(s), (C1-C60)alkoxy, halogen, tri(C1-C60)alkylsilyl, tri(C6-C60)arylsilyl and (C6-C60)aryl.

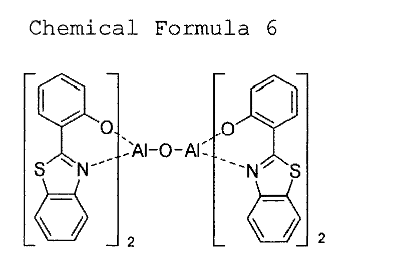

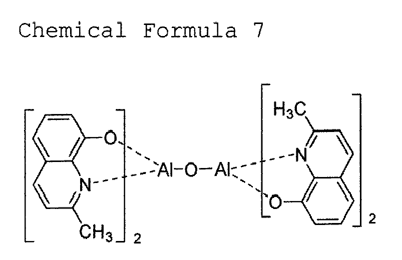

**L⁶L⁷M²(Q)_{d}** Chemical Formula 8

In Chemical Formula (8), the ligands, L⁶ and L⁷ are independently selected from the following structures: 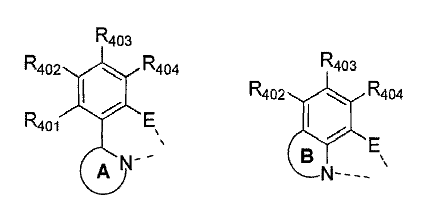 M² is a bivalent or trivalent metal;
d is 0 when M² is a bivalent metal, while d is 1 when M² is a trivalent metal;
Q represents (C6-C60)aryloxy or tri(C6-C60)arylsilyl, and the aryloxy and triarylsilyl of Q may be further substituted by (C1-C60)alkyl or (C6-C60)aryl;
E represents O, S or Se;
ring A represents oxazole, thiazole, imidazole, oxadiazole, thiadiazole, benzoxazole, benzothiazole, benzimidazole, pyridine or quinoline;
ring B represents pyridine or quinoline, and ring B may be further substituted by (C1-C60)alkyl, or phenyl or naphthyl with or without (C1-C60)alkyl substituent(s);
R₄₀₁ through R₄₀₄ independently represent hydrogen, deuterium, (C1-C60)alkyl, halogen, tri(C1-C60)alkylsilyl, tri(C6-C60)arylsilyl or (C6-C60)aryl, or each of them may be linked to an adjacent substituent via (C3-C60)alkylene or (C3-C60)alkenylene to form a fused ring, and the pyridine or quinoline may form a chemical bond with R₄₀₁ to form a fused ring;
the aryl of ring A and R₄₀₁ through R₄₀₄ may be further substituted by deuterium, (C1-C60)alkyl, halogen, (C1-C60)alkyl with halogen substituent(s), phenyl, naphthyl, tri(C1-C60)alkylsilyl, tri(C6-C60)arylsilyl or amino group.

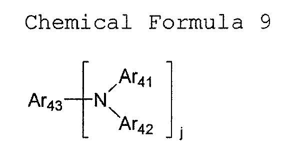

In Chemical Formula (9), Ar₄₁ and Ar₄₂ independently represent hydrogen, deuterium, halogen, (C1-C60)alkyl, (C6-C60)aryl, (C4-C60)heteroaryl, mono or di-(C6-C60)arylamino, mono or di-(C1-C60)alkylamino, a 5- or 6-membered heterocycloalkyl containing one or more heteroatom(s) selected from N, O and S, or (C3-C60)cycloalkyl, or Ar₄₁ and Ar₄₂ may be linked via (C3-C60)alkylene or (C3-C60)alkenylene with or without a fused ring to form an alicyclic ring, or a monocyclic or polycyclic aromatic ring;
when j is 1, Ar₄₃ represents (C6-C60)arylamino, (C6-C60)aryl or (C4-C60)heteroaryl, or aryl represented by one of the following structural formulas: 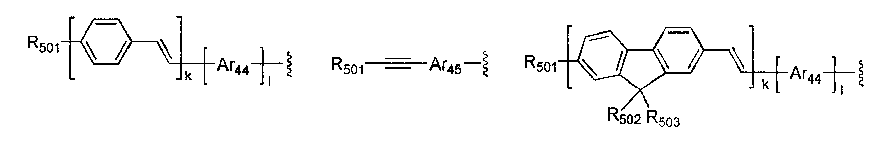 when j is 2, Ar₄₃ represents (C6-C60)arylene, (C4-C60)heteroarylene, or arylene represented by one of the following structural formulas: 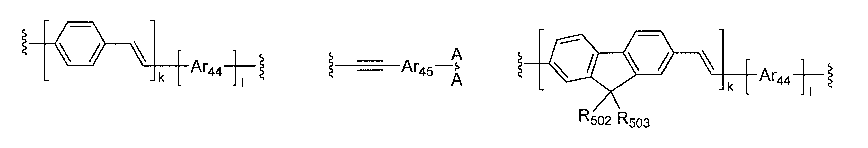 wherein Ar₄₄ and Ar₄₅ independently represent (C6-C60)arylene or (C4-C60)heteroarylene;
R₅₀₁ through R₅₀₃ independently represent hydrogen, deuterium, (C1-C60)alkyl or (C6-C60)aryl;
k is an integer from 1 to 4, 1 is an integer of 0 or 1; and
the alkyl, aryl, heteroaryl, arylamino, alkylamino, cycloalkyl or heterocycloalkyl of Ar₄₁ and Ar₄₂; the alicyclic ring, or the monocyclic or polycyclic aromatic ring formed from Ar₄₁ and Ar₄₂ via alkylene or alkenylene; the aryl, heteroaryl, arylene or heteroarylene of Ar₄₃; or the arylene or heteroarylene of Ar₄₄ and Ar₄₅, or the alkyl or aryl of R₅₀₁ through R₅₀₃ may be further substituted by one or more substituent(s) selected from a group consisting of halogen, deuterium, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, mono or di-(C1-C60)alkylamino, mono or di-(C6-C60)arylamino, (C6-C60)ar(C1-C60)alkyl, (C6-C60)aryloxy, (C1-C60)alkoxy, (C6-C60)arylthio, (C1-C60)alkylthio, (C1-C60)alkoxycarbonyl, (C1-C60)alkylcarbonyl, (C6-C60)arylcarbonyl, (C6-C60)aryloxycarbonyl, (C1-C60)alkoxycarbonyloxy, (C1-C60)alkylcarbonyloxy, (C6-C60)arylcarbonyloxy, (C6-C60)aryloxycarbonyloxy, (C1-C60)alkylcarbonyloxy, (C6-C60)arylcarbonyloxy, carboxyl, nitro and hydroxyl.

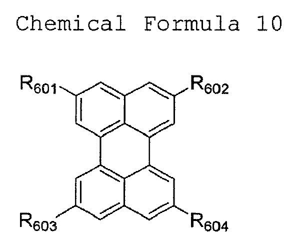

In Chemical Formula (10), R₆₀₁ through R₆₀₄ independently represent hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, (C1-C60)alkylcarbonyl, (C6-C60)arylcarbonyl, (C6-C60)aryloxycarbonyl, (C1-C60)alkoxycarbonyloxy, (C1-C60)alkylcarbonyloxy, (C6-C60)arylcarbonyloxy, (C6-C60)aryloxycarbonyloxy, (C1-C60)alkylcarbonyloxy, (C6-C60)arylcarbonyloxy, carboxyl, nitro or hydroxyl, or each of R₆₀₁ through R₆₀₄ may be linked to an adjacent substituent via (C3-C60)alkylene or (C3-C60)alkenylene with or without a fused ring to form an alicyclic ring, or a monocyclic or polycyclic aromatic ring;
the alkyl, alkenyl, alkynyl, cycloalkyl, heterocycloalkyl, aryl, heteroaryl, arylsilyl, alkylsilyl, alkylamino or arylamino of R₆₀₁ through R₆₀₄, or the alicyclic ring, or the monocyclic or polycyclic aromatic ring formed therefrom by linkage to an adjacent substituent via (C3-C60)alkylene or (C3-C60)alkenylene with or without a fused ring may be further substituted by one or more substituent(s) selected from deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, (C1-C60)alkylcarbonyl, (C6-C60)arylcarbonyl, (C6-C60)aryloxycarbonyl, (C1-C60)alkoxycarbonyloxy, (C1-C60)alkylcarbonyloxy, (C6-C60)arylcarbonyloxy, (C6-C60)aryloxycarbonyloxy, (C1-C60)alkylcarbonyloxy, (C6-C60)arylcarbonyloxy, carboxyl, nitro and hydroxyl.

The compounds for an electroluminescent layer, having electroluminescent peak of wavelength of not more than 500 nm or those having electroluminescent peak of wavelength of not less than 560 nm, may be exemplified by the following compounds, but they are not restricted thereto.

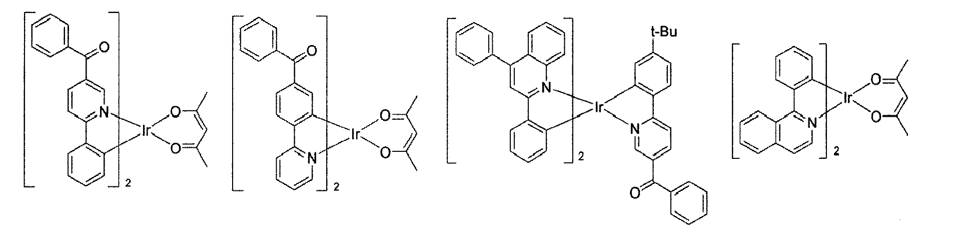

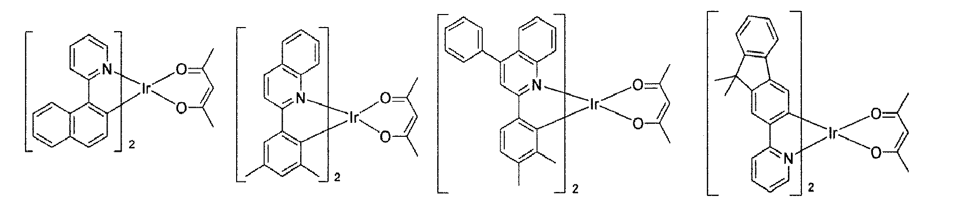

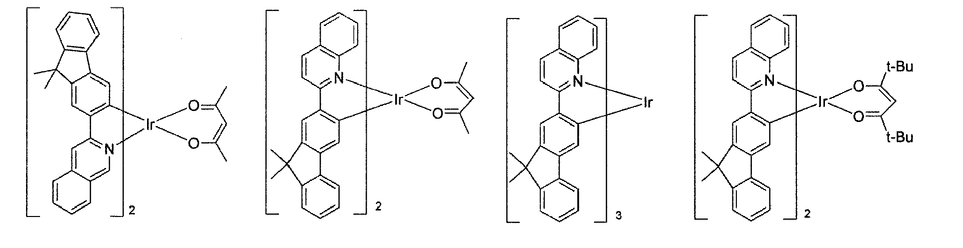

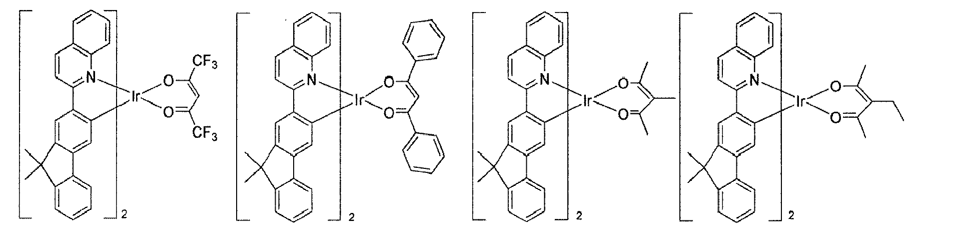

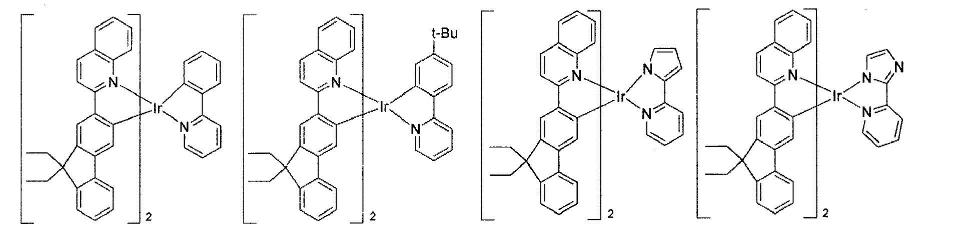

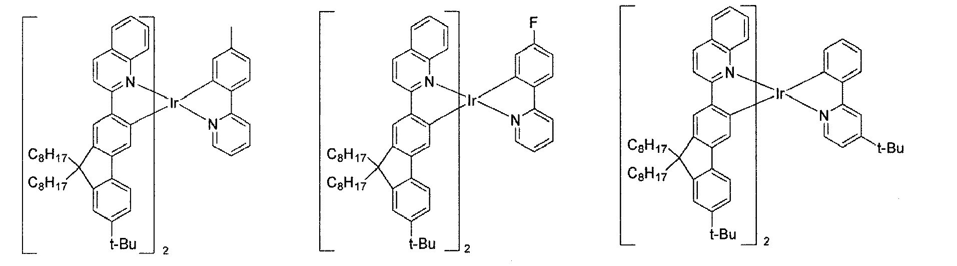

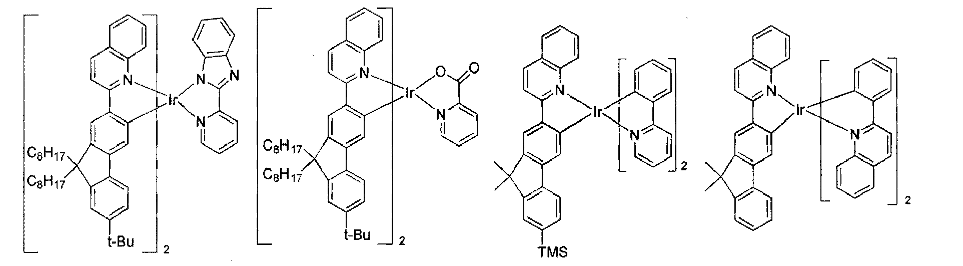

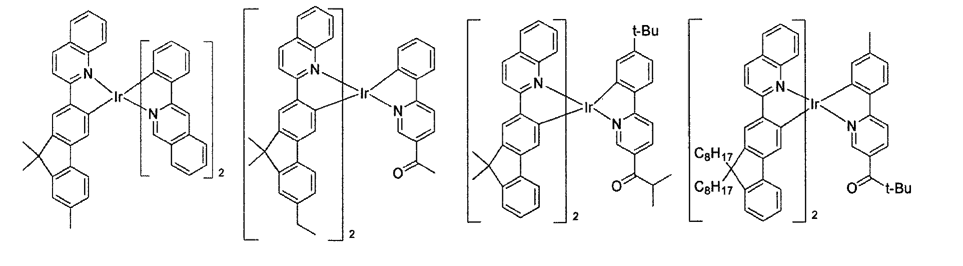

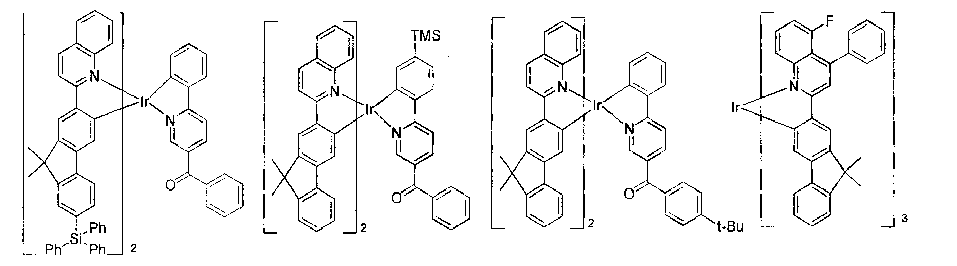

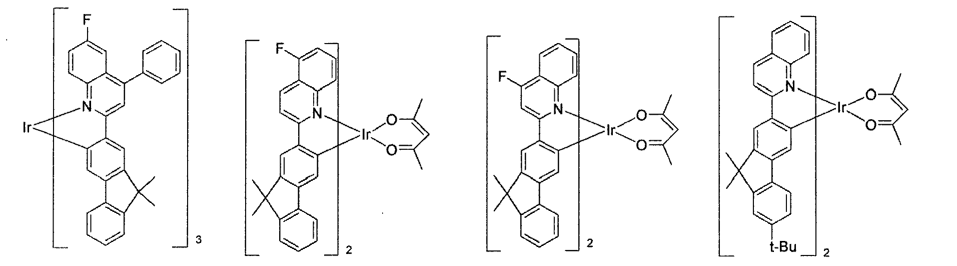

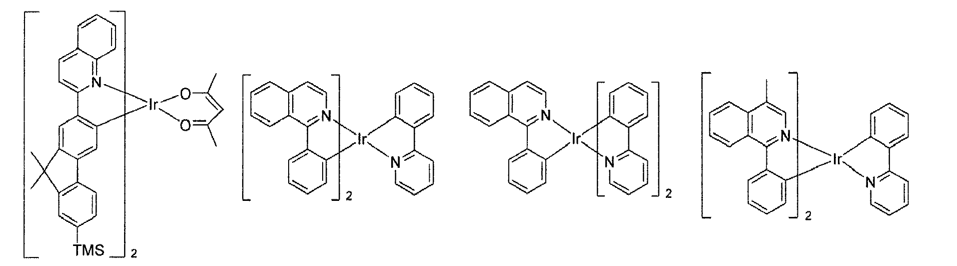

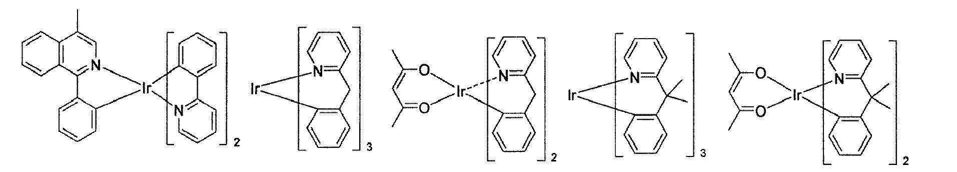

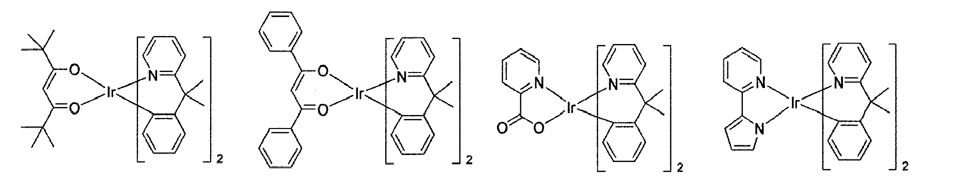

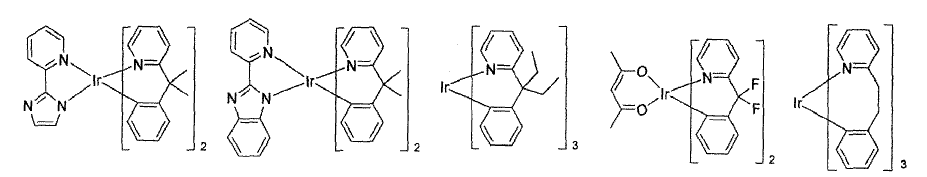

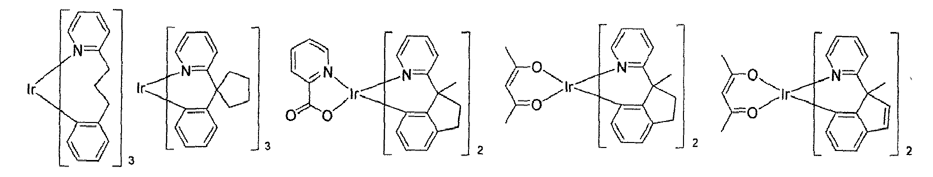

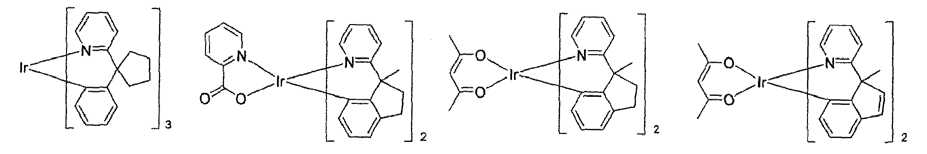

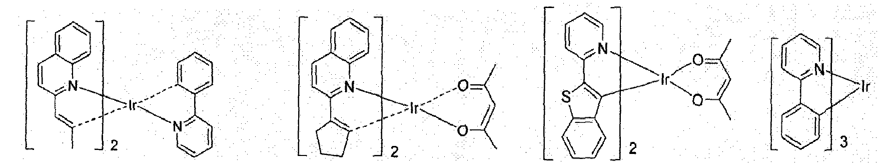

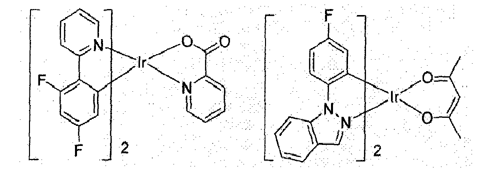

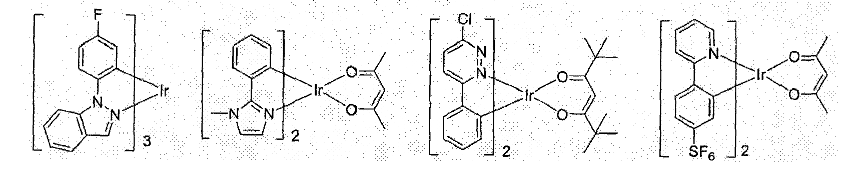

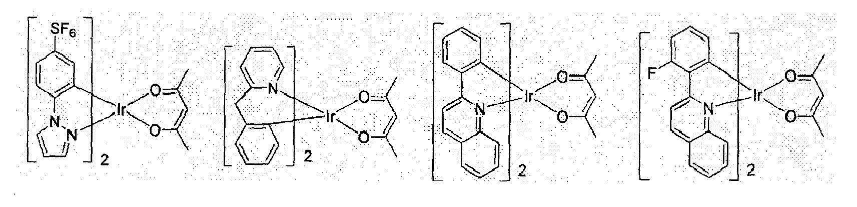

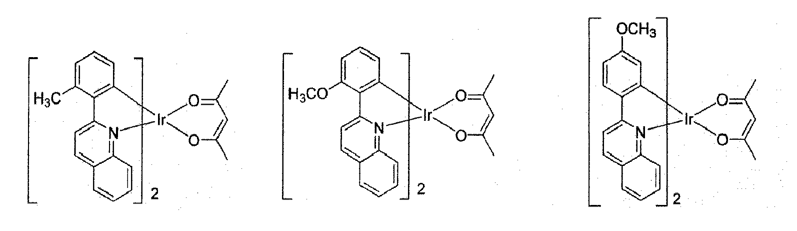

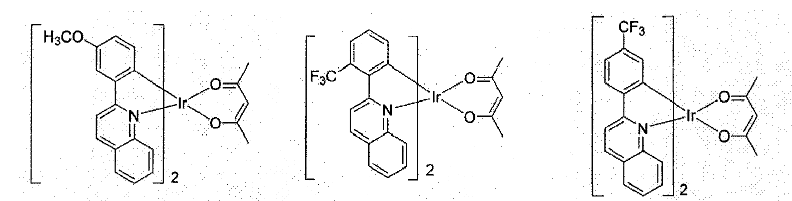

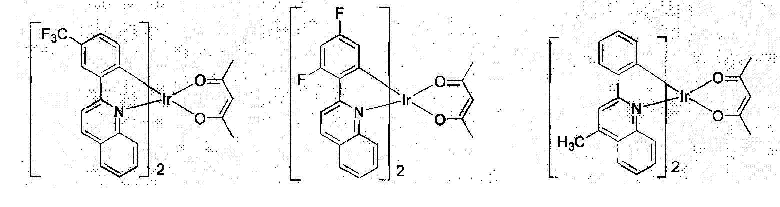

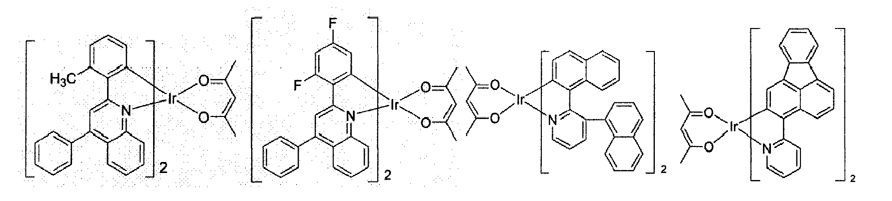

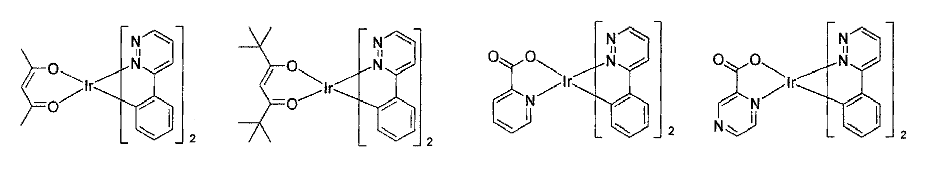

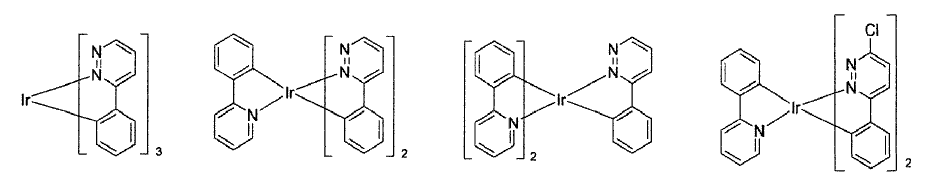

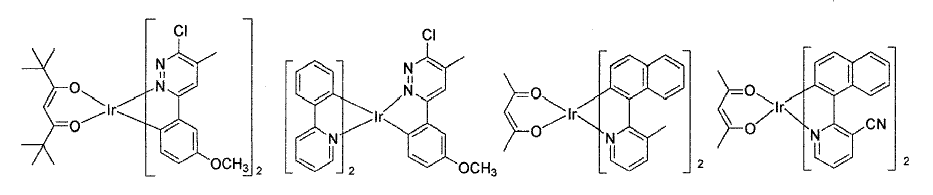

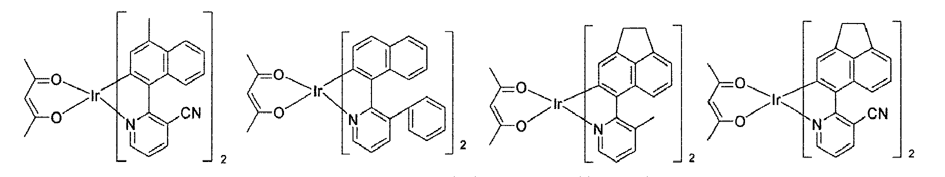

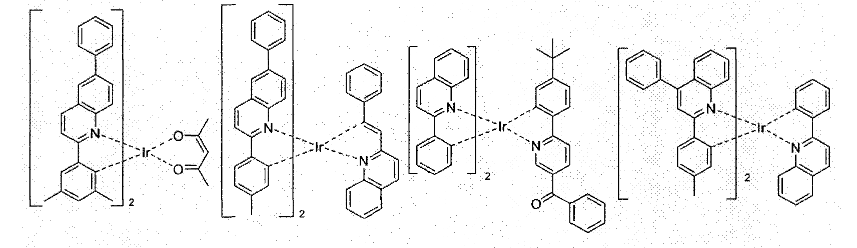

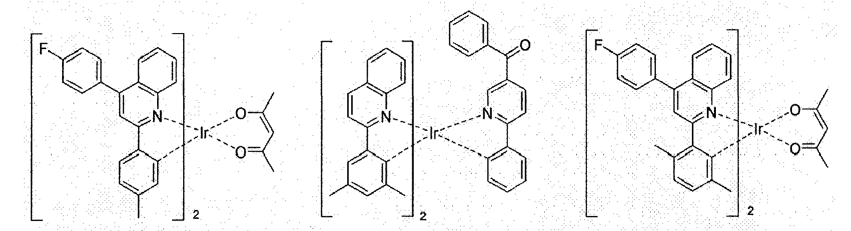

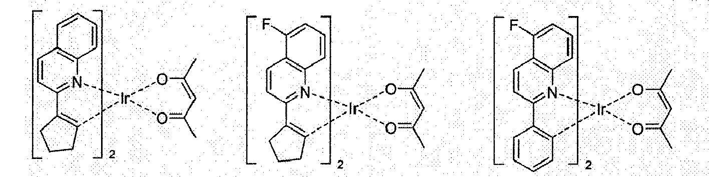

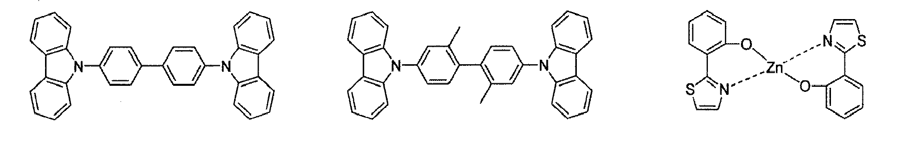

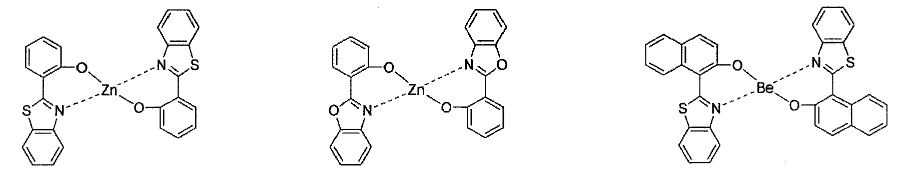

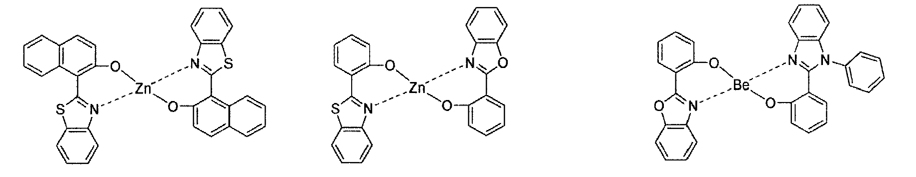

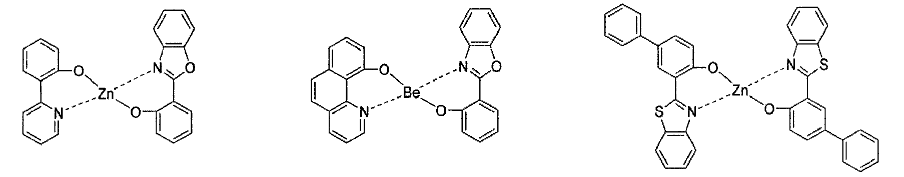

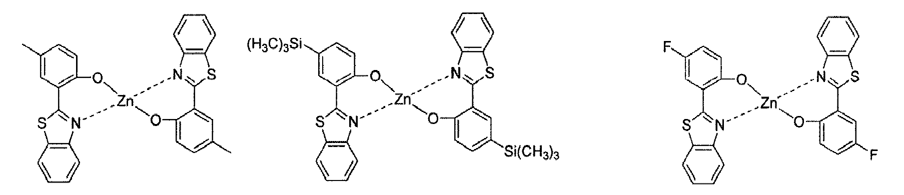

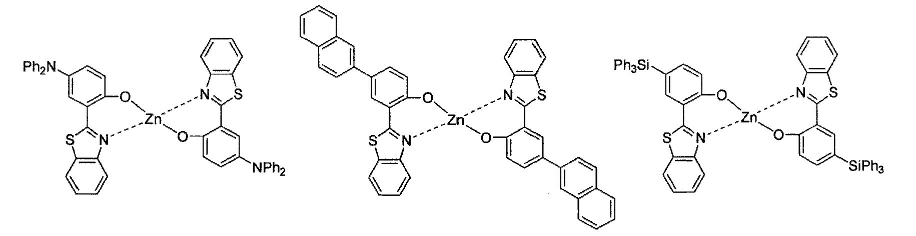

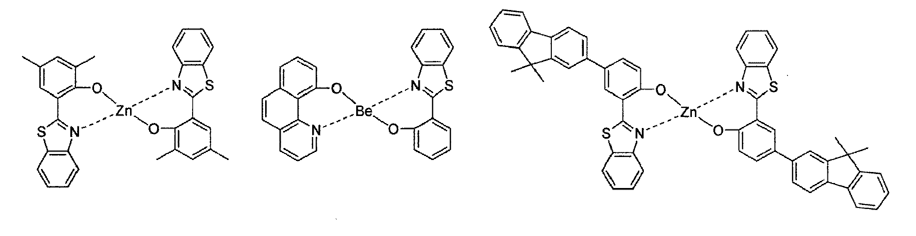

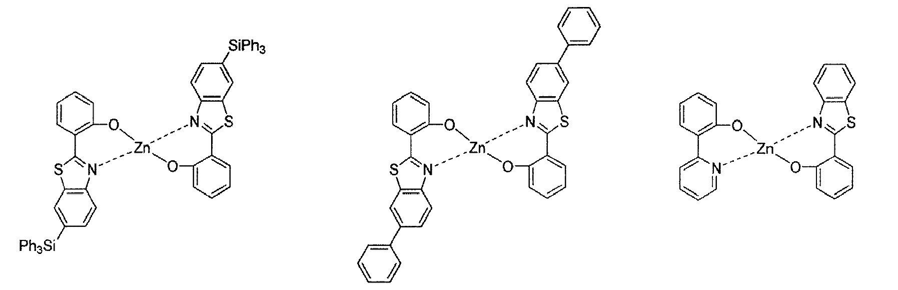

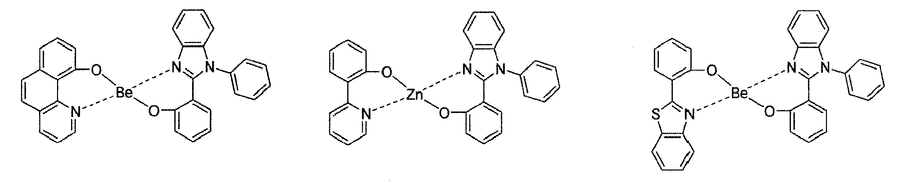

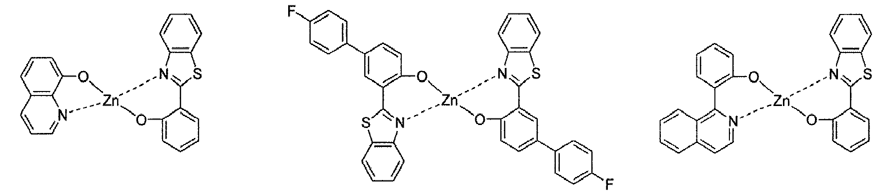

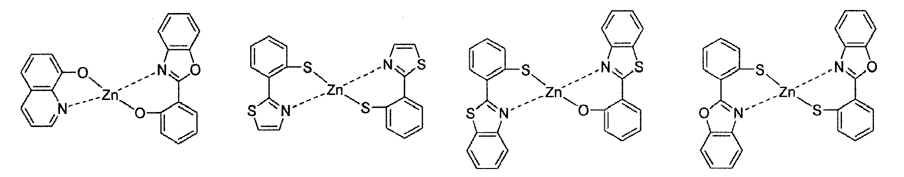

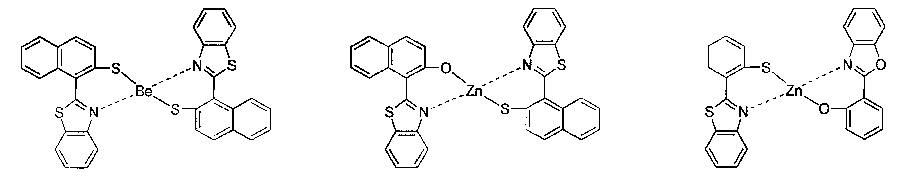

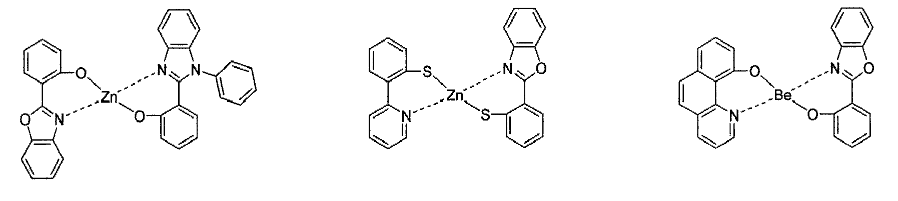

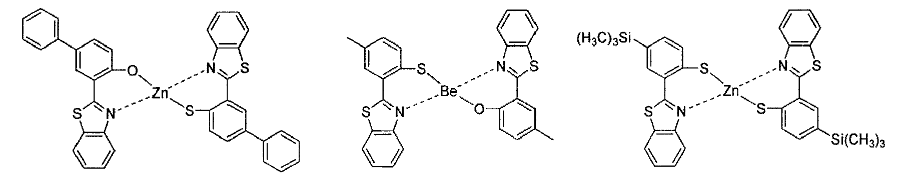

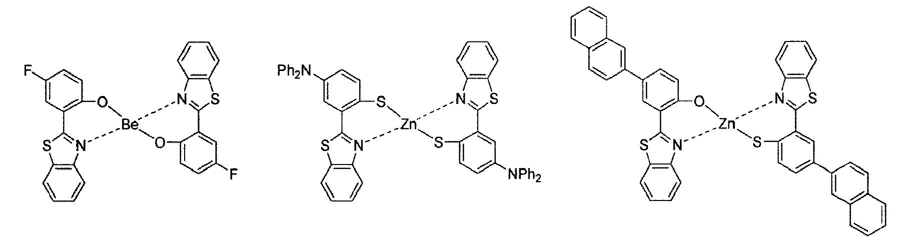

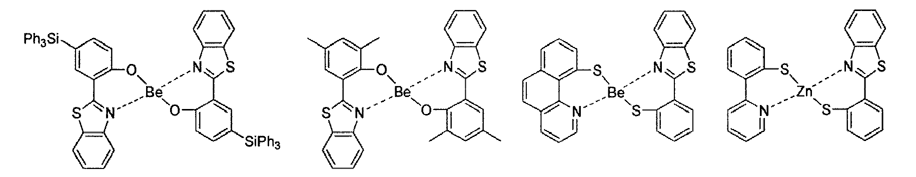

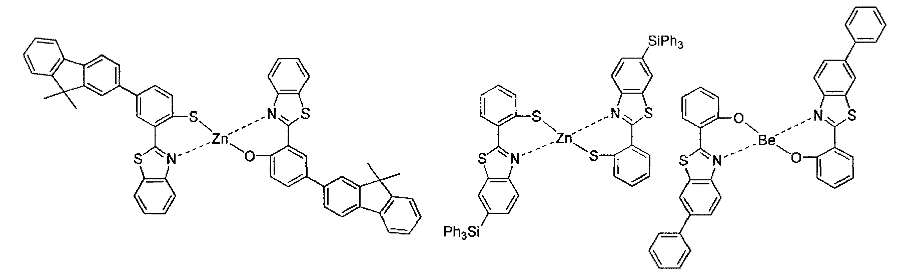

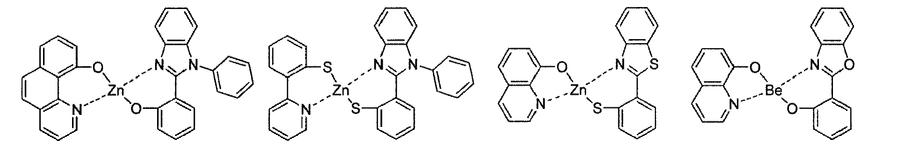

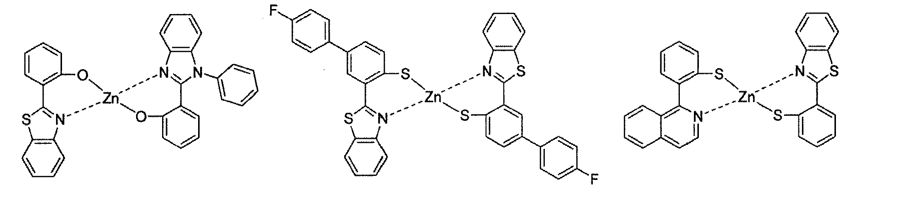

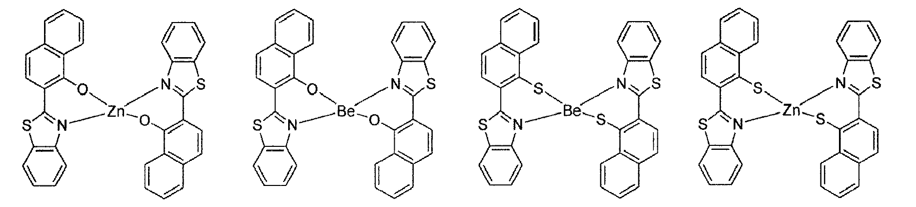

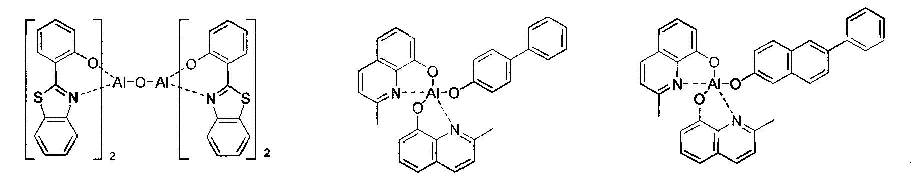

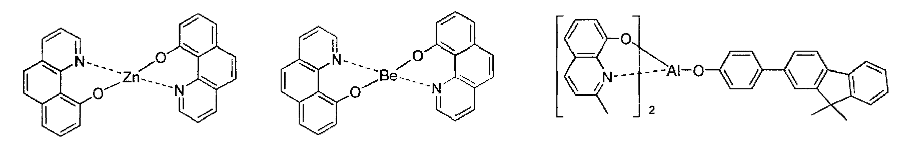

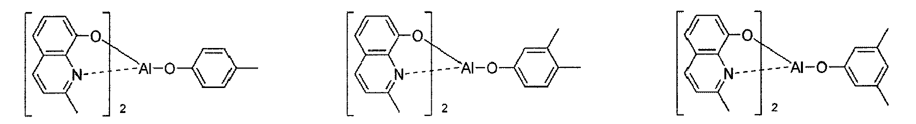

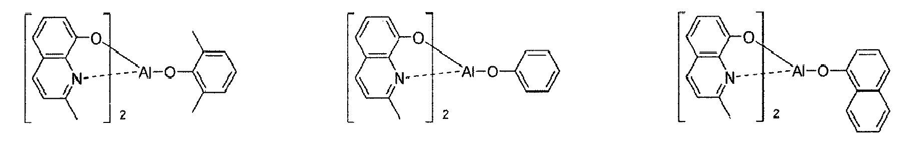

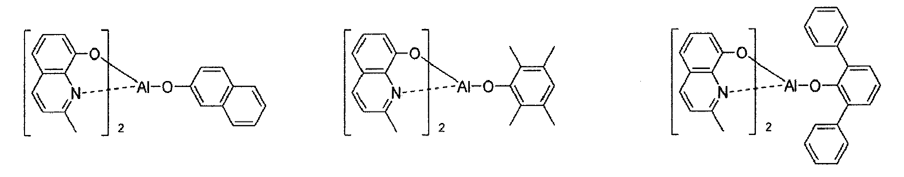

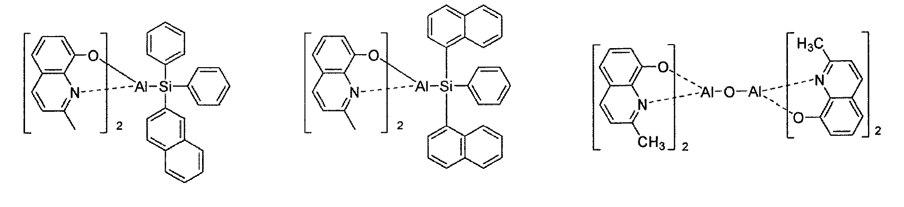

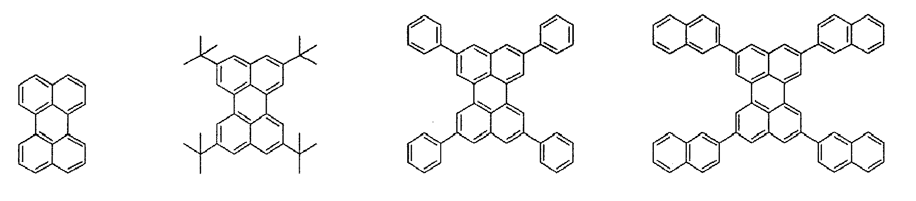

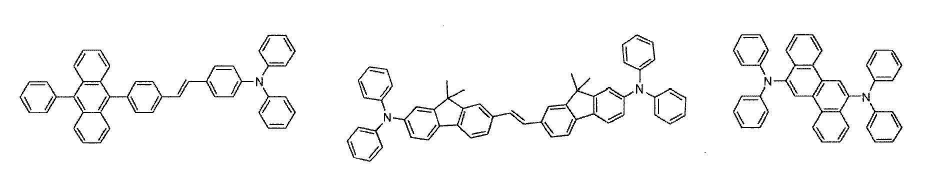

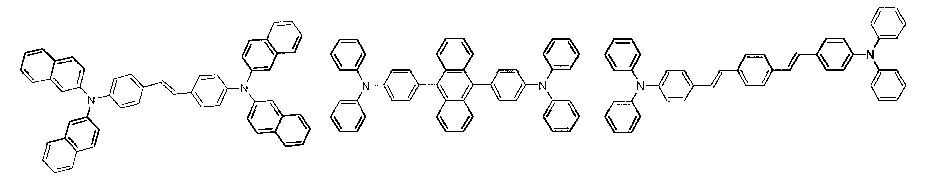

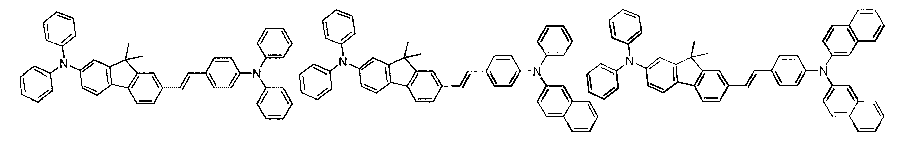

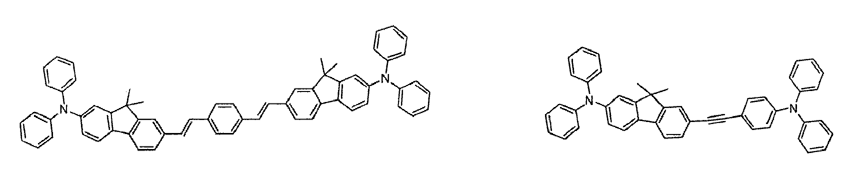

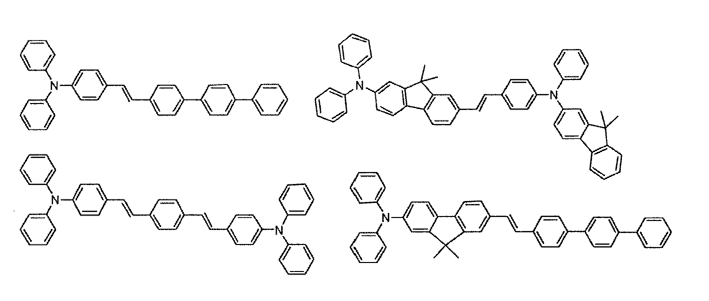

In an organic electroluminescent device according to the present invention, it is preferable to place one or more layer(s) (here-in-below, referred to as the "surface layer") selected from chalcogenide layers, metal halide layers and metal oxide layers, on the inner surface of at least one side of the pair of electrodes. Specifically, it is preferable to arrange a chalcogenide layer of silicon and aluminum metal (including oxides) on the anode surface of the EL medium layer, and a metal halide layer or a metal oxide layer on the cathode surface of the EL medium layer. As the result, stability in operation can be obtained.

Examples of chalcogenides preferably include SiOₓ (1≤X≤2), AlOₓ (1≤X≤1.5), SiON, SiAlON, or the like. Examples of metal halides preferably include LiF, MgF₂, CaF₂, fluorides of rare earth metal, or the like. Examples of metal oxides preferably include Cs₂O, Li₂O, MgO, SrO, BaO, CaO, or the like.

In an organic electroluminescent device according to the present invention, it is also preferable to arrange, on at least one surface of the pair of electrodes thus manufactured, a mixed region of electron transport compound and a reductive dopant, or a mixed region of a hole transport compound with an oxidative dopant. Accordingly, the electron transport compound is reduced to an anion, so that injection and transportation of electrons from the mixed region to an EL medium are facilitated. In addition, since the hole transport compound is oxidized to form a cation, injection and transportation of holes from the mixed region to an EL medium are facilitated. Preferable oxidative dopants include various Lewis acids and acceptor compounds. Preferable reductive dopants include alkali metals, alkali metal compounds, alkaline earth metals, rare-earth metals, and mixtures thereof.

The organic electroluminescent devices according to the invention exhibit long life, high efficiency and luminance, good color purity with lowered operation voltage and enhanced stability of the devices.

### Best Mode

Now, the luminescent properties of the organic electroluminescent devices according to the present invention are described by referring to Preparation Examples and Examples, which are provided for better understanding of the present invention, but are not intended to limit the scope of the invention by any means.

Preparation Examples 1 and 2 are described in Korean Patent Laid-Open Nos. 2007-0112317 and 2007-0021043.

### [Preparation Example 1] Preparation of Compound (101)

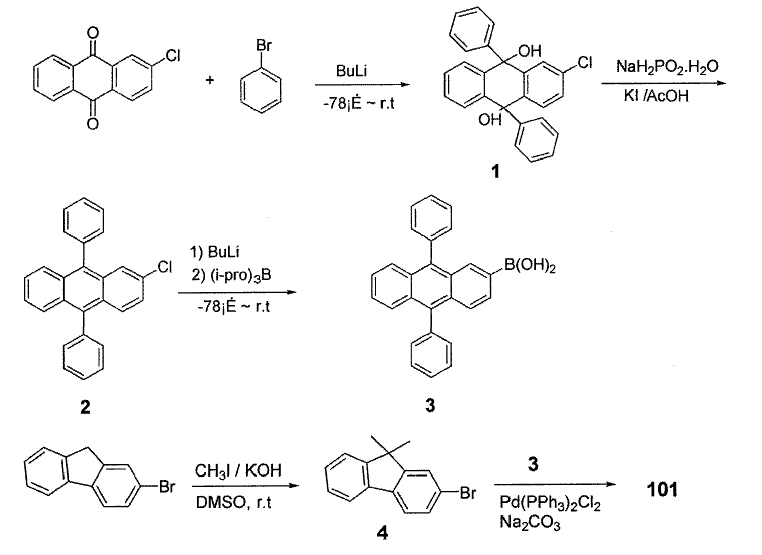

Tetrahydrofuran (3.5 L, 0.3 M) was added to bromobenzene (388 g, 2.47 mol), and the mixture was stirred at room temperature for 10 minutes to give complete dissolution. After chilling to -72°C, n-butyllithium (1.6 M in n-hexane) (1.7 L, 2.68 mol) was slowly added to the solution. After 1 hour, 2-chloroanthraquinone (250 g, 1.03 mol) was added, and the temperature was slowly raised to room temperature with stirring for 24 hours. Then, 10% HCl solution (1 L) was added to the reaction mixture, and the resultant mixture was stirred for 2 hours, and filtered under reduced pressure. The organic layer separated was evaporated to obtain Compound (1) (226 g, 55%) as clear brown oil.

A reaction vessel was charged with Compound (1) (226 g, 0.56 mol), potassium iodide (376 g, 2.27 mol), sodium phosphate monohydrate (480 g, 0.45 mol) and acetic acid (1.9 L, 0.3 M), and the mixture were stirred under reflux. After 18 hours, the mixture was cooled to room temperature, and filtered under reduced pressure. The solid thus obtained was neutralized by adding a small amount of potassium carbonate, dichloromethane and distilled water, and the mixture was stirred for 2 hours. The organic layer separated was evaporated to obtain Compound (2) (97.2 g, 47%) as dark yellow solid.

Compound (2) (97.2 g, 0.27 mol) and tetrahydrofuran (0.89 L, 0.3 M) were charged to a reaction vessel, and the mixture was stirred at room temperature for 10 minutes to obtain complete dissolution. After chilling to -72°C, n-butyllithium (1.6 M in n-hexane) (0.216 L, 0.35 mol) was slowly added to the solution. After 1 hour, triisopropyl borate (80.2 g, 0.43 mol) was added thereto, and the resultant mixture was stirred for 24 hours while slowly raising the temperature to room temperature. Then 10% HCl solution (0.5 L) was added thereto, and the resultant mixture was stirred for 2 hours, and filtered under reduced pressure. The organic layer separated was evaporated, and the residue was recrystallized from hexane and methanol to obtain Compound (3) (36.9 g, 37%) as apricot solid.

A reaction vessel was charged with 2-bromofluorene (20 g, 82 mmol), iodomethane (35 g, 0.25 mol), potassium hydroxide (13.8 g, 0.25 mol) and dimethylsulfoxide (0.16 L, 0.5 M), and the mixture was stirred at room temperature. After 24 hours, 10% HCl (0.2 L) was added thereto, and the resultant mixture was stirred for 10 minutes and filtered under reduced pressure. The solid obtained was recrystallized from hexane and methanol to obtain Compound (4) (14.75 g, 54%) as yellow solid.

Compound (3) (10 g, 26.72 mmol), Compound (4) (8.76 g, 32.06 mmol), trans-dichlorobistriphenylphosphine palladium (II) (0.38 g, 0.54 mmol), sodium carbonate (5.67 g, 53.44 mmol), toluene (0.1 L, 0.3 M) and distilled water (9 mL, 3 M) were charged to a reaction vessel, and stirred under reflux. After 22 hours, the temperature was lowered to room temperature, and the reaction was quenched by adding distilled water (0.1 L). The solid produced was filtered under reduced pressure, and purified via silica gel column chromatography (dichloromethane: n-hexane = 1:10) to obtain Compound (101) (8.52 g, 61%) as yellow solid.

¹H NMR (200 MHz, CDCl₃) : δ (ppm) = 1.66 (s, 6H), 7.20 (t, 2H), 7.30-7.47 (m, 12H), 7.51-7.58 (m, 3H), 7.68-7.71 (m, 3H), 7.75 (s, 1H), 7.84-7.85 (s, 2H), 7.92 (s, 1H)

MS/FAB : 522.80 (found), 522.67 (calculated)

Compounds (101) to (106) were synthesized according to the same procedure as described in Preparation Example 1.

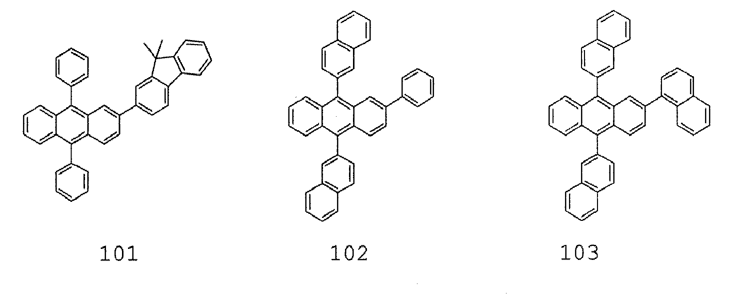

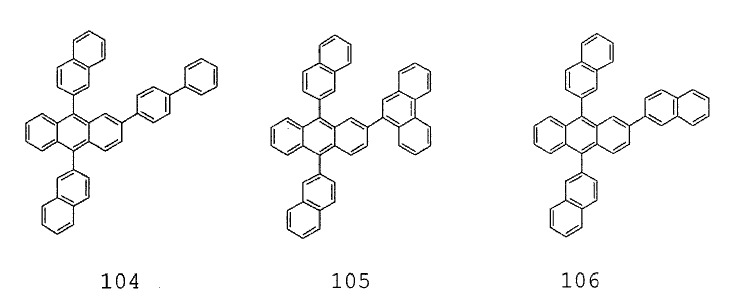

### [Preparation Example 2] Preparation of Compound (D-1)

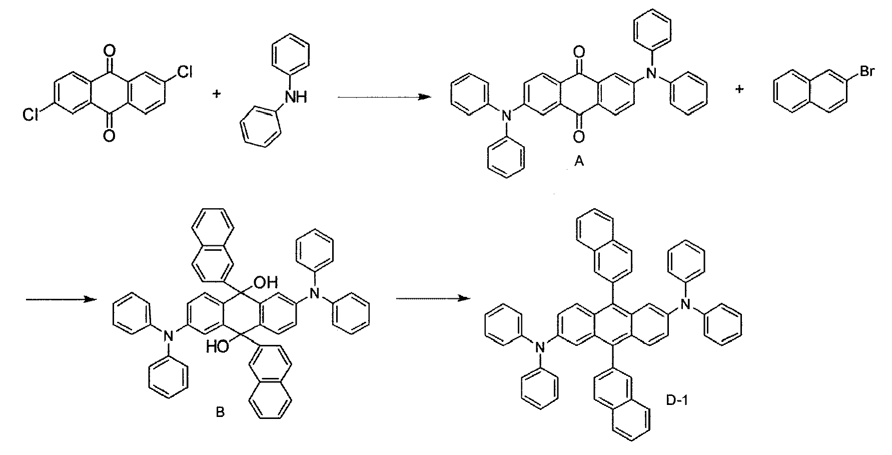

In dry toluene (50 mL), dissolved were 2,6-dichloroanthraquinone (1.0 g, 3.6 mmol) and diphenylamine (1.3 g, 7.7 mmol), and palladium acetate (Pd(OAc)₂) (2.4 g, 24.4 mmol), tri(t-butyl)phosphine (P(t-Bu)₃) (0.2 mL, 1.9 mmol) and sodium t-butoxide (t-BuONa) (0.93 g, 9.7 mmol) were added thereto. The mixture was stirred under reflux at 110°C for 3 days. When the reaction was completed, distilled water (10 mL) was added, and the resultant mixture was stirred for 30 minutes. Solid produced was filtered, washed with acetone and THF, and dried. Recrystallization from methylene chloride gave Compound (A) (1.1 g, 2.0 mmol, yield 56%).

Solution of 2-naphthyllithium in diethyl ether (5 mL), which had been previously prepared by using 2-bromonaphthalene (0.74 g, 4.4 mmol) and n-butyllithium (n-BuLi) (1.8 mL, 4.5 mmol, 2.5 M in hexane), was slowly added to solution of Compound A (1.1 g, 2.0 mmol) prepared as above in dry THF (30 mL) at -78°C, under nitrogen atmosphere. The reaction mixture was stirred at the same temperature for 2 hours, and the temperature was raised to ambient temperature. After stirring for 12 hours or more, saturated aqueous ammonium chloride solution (30 mL) was added thereto, and the resultant mixture was stirred for 2 hours to quench the reaction. The solid produced was filtered, washed with acetone, and dried to obtain Compound (B) (1.3 g, 1.7 mmol, yield 85%).

Compound (B) (1.3 g, 1.71 mmol) thus obtained was added to acetic acid (30 mL), and potassium iodide (1.6 g, 7.8 mmol) and sodium dihydrogen phosphate monohydrate (2.0 g, 14.5 mmol) were added thereto. The mixture was heated under reflux for 12 hours. When the reaction was completed, same volume of distilled water was added, and precipitate formed was filtered and washed with water and acetone. The solid obtained was recrystallized from THF to obtain pure title compound (D-1) (0.68 g, 0.89 mmol, yield 52%).

1H NMR(200MHz, CDCl₃): δ 6.46(d, 8H), 6.65-6.75(m, 8H), 7.0(m, 8H), 7.3(m, 4H), 7.5-7.6(m, 4H), 7.65-7.8(m,6H), 7.9(s, 2H)

MS/FAB: 764(found), 764.98(calculated)

According to the same procedure as described in Preparation Example 2, Compounds (D-2) to (D-6) were synthesized.

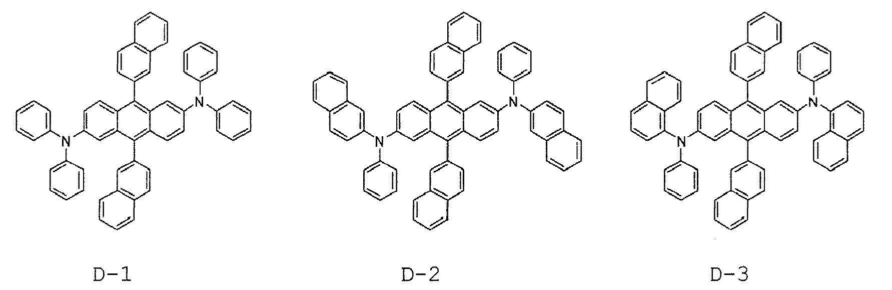

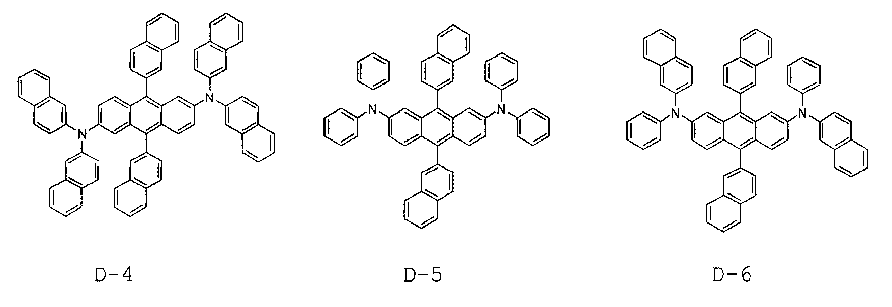

### [Example 1] Manufacture of an organic electroluminescent device

First, a transparent electrode ITO thin film (15 Ω/□) prepared from glass for OLED (produced by Samsung Corning) was subjected to ultrasonic washing with trichloroethylene, acetone, ethanol and distilled water, sequentially, and stored in isopronanol before use.

Then, an ITO substrate was equipped in a substrate folder of a vacuum vapor-deposit device, and 4,4',4"-tris(N,N-(2-naphthyl)-phenylamino)triphenylamine (2-TNATA)(of which the structure is shown below) was placed in a cell of the vacuum vapor-deposit device, which was then ventilated up to 10⁻⁶ torr of vacuum in the chamber. Electric current was applied to the cell to evaporate 2-TNATA, thereby providing vapor-deposit of a hole injecting layer having 60 nm of thickness on the ITO substrate.

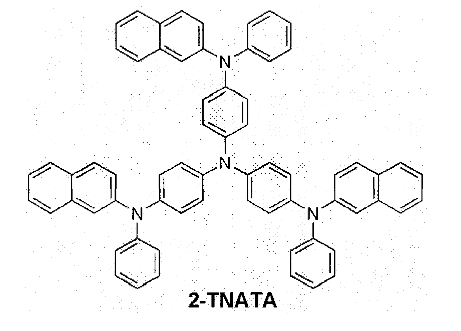

Then, to another cell of the vacuum vapor-deposit device, charged was N,N'-bis(α-naphthyl)-N,N'-diphenyl-4,4'-diamine (NPB) (of which the structure is shown below), and electric current was applied to the cell to evaporate NPB, thereby providing vapor-deposit of a hole transport layer of 20 nm of thickness on the hole injecting layer.

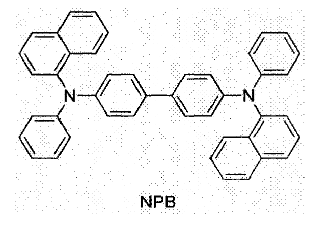

After forming the hole injecting layer and the hole transport layer, an electroluminescent layer was vapor-deposited as follows. In one cell of a vacuum vapor-deposit device, charged was Compound (101) (of which the structure is shown below), and another cell was charged with Compound (D-4) as dopant. The two materials were evaporated at different rates to carry out doping in a concentration of 2 to 5% by weight on the basis of the host, to vapor-deposit an electroluminescent layer having 30 nm of thickness on the hole transport layer.

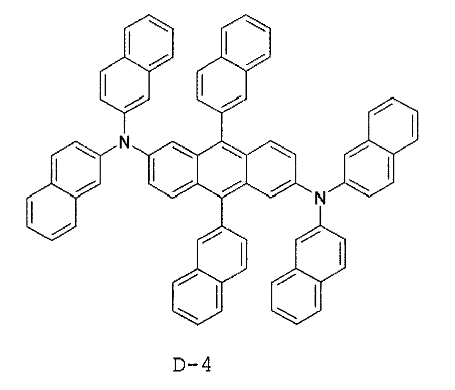

Then, tris(8-hydroxyquinoline)aluminum (III) (Alq) (of which the structure is shown below) was vapor-deposited as an electron transport layer in a thickness of 20 nm, and then lithium quinolate (Liq) (of which the structure is shown below) was vapor-deposited as an electron injecting layer (7) in a thickness of 1 to 2 nm. Thereafter, an Al cathode was vapor-deposited in a thickness of 150 nm by using another vacuum vapor-deposit device to manufacture an OLED.

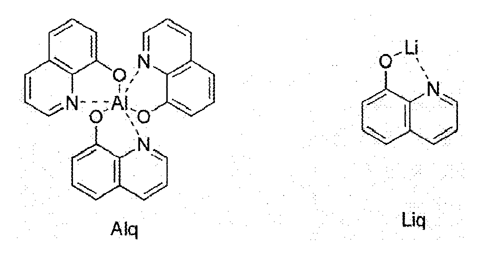

Each compound was employed for the electroluminescent material of an OLED after purifying via vacuum sublimation under 10⁻⁶ torr.

### [Comparative Example 1] Manufacture of an OLED by using conventional electroluminescent material

After forming a hole injecting layer and hole transport layer according to the same procedure described in Example 1, tris(8-hydroxyquinoline)-aluminum (III) (Alq) was charged to another cell of said vacuum vapor-deposit device as electroluminescent host material, and Coumarin 545T (C545T) (of which the structure is shown below) was charged to still another cell. Then the two materials were evaporated at different rates to carry out doping, and thus providing an electroluminescent layer having 30 nm of thickness vapor-deposited on the hole transport layer. The doping concentration was preferably from 1 to 3% by weight on the basis of Alq.

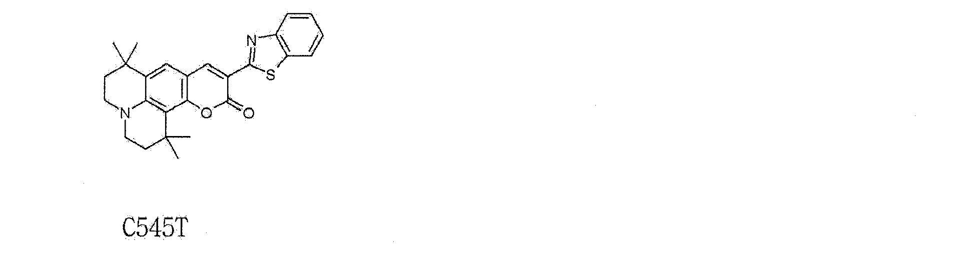

Then, an electron transport layer and electron injecting layer were vapor-deposited according to the same procedure as Example 1, and an Al cathode was vapor-deposited thereon with a thickness of 150 nm by using another vacuum vapor-deposit device to manufacture an OLED.

### [Experimental Example 1] Electroluminescent properties of OLED's manufactured

The luminous efficiencies of the OLED's comprising the organic EL compound according to the present invention (Examples 1) or conventional EL compound (Comparative Example 1) were measured at 5,000 cd/m², respectively, and the results are shown in Table 1.

**Table 1**

| No. | Host | Dopant | Doping rate | Luminous efficiency (cd/A) @5,000cd/m² | Color |
|---|---|---|---|---|---|
| 1 | **101** | D-1 | 3 | 18.2 | Green |
| 2 | **102** | D-2 | 3 | 18.6 | Green |
| 3 | **103** | D-3 | 3 | 18.2 | Green |
| 4 | **104** | D-4 | 3 | 18.9 | Green |
| 5 | **105** | D-5 | 3 | 18.7 | Green |
| 6 | **106** | D-6 | 3 | 20.2 | Green |
| 7 | **101** | D-1 | 3 | 20.8 | Green |
| 8 | **102** | D-2 | 3 | 21.6 | Green |
| 9 | **103** | D-3 | 3 | 19.1 | Green |
| 10 | **104** | D-4 | 3 | 19.3 | Green |
| 11 | **105** | D-5 | 3 | 18.5 | Green |
| 12 | **106** | D-6 | 3 | 19.6 | Green |
| Comp. 1 | Alq | Compound C545T | 1 | 10.3 | Green |

## Claims

1. An organic electroluminescent device comprising an organic layer interposed between an anode and an cathode on a substrate, wherein the organic layer comprises an electroluminescent layer containing one or more host compound(s) represented by Chemical Formula (1) and one or more dopant compound(s) represented by Chemical Formula (2): 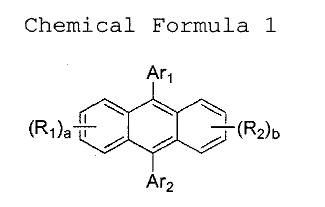 wherein, Ar₁, Ar₂, R₁ and R₂ independently represent hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl, or a substituent selected from the following structures; or each of them may be linked to an adjacent substituent via (C3-C60)alkylene or (C3-C60)alkenylene with or without a fused ring to form an alicyclic ring, or a monocyclic or polycyclic aromatic ring; 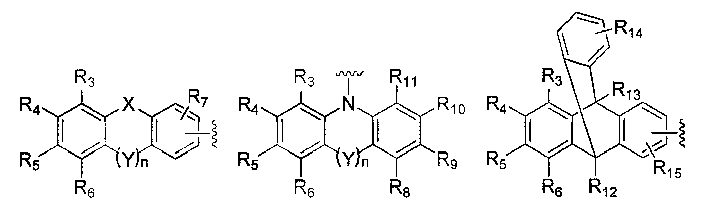 wherein, R₃ through R₁₅ independently represent hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl;
X and Y independently represent a chemical bond, or - C(R₂₁)(R₂₂)-, -N(R₂₃)-, -S-, -O-, -Si(R₂₄)(R₂₅)-, -P(R₂₆)-, - C(=O)-, -B(R₂₇)-, -In(R₂₈)-, -Se-, -Ge(R₂₉)(R₃₀)-, -Sn(R₃₁)(R₃₂)-, -Ga(R₃₃)-, or -(R₃₄)C=C(R₃₅)-;
R₂₁ through R₃₅ independently represent hydrogen, deuterium, halogen, (C1-C60)alkyl, (C6-C60) aryl, (C4-C60)heteroaryl, 5- or 6-membered heterocycloalkyl containing one or more heteroatom(s) selected from N, O and S, (C3-C60)cycloalkyl, tri(C1-C60)alkylsily di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl; or each of R₂₁ through R₃₅ may be linked to an adjacent substituent via (C3-C60)alkylene or (C3-C60)alkenylene with or without a fused ring to form an alicyclic ring, or a monocyclic or polycyclic aromatic ring;
the alkyl, alkenyl, alkynyl, cycloalkyl, heterocycloalkyl, aryl, heteroaryl, arylsilyl, alkylsilyl, alkylamino and arylamino of Ar₁, Ar₂, R₁ and R₂ may be further substituted by one or more substituent(s) selected from deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl;
a and b are integers from 0 to 4, provided that a+b ≥ 1; and
n is an integer from 0 to 4; 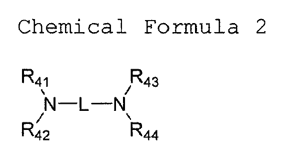 wherein,
L represents (C6-C60)arylene with or without one or more substituent(s) selected from a group consisting of deuterium, halogen, (C1-C60)alkyl, (C6-C60)aryl, (C4-C60)heteroaryl, 5-or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl; the alkyl, cycloalkyl, heterocycloalkyl, aryl, heteroaryl, arylsilyl, alkylsilyl, alkylamino and arylamino substituent on the arylene may be further substituted by one or more substituent(s) selected from deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl;
R₄₁ through R₄₄ independently represent (C1-C60)alkyl, (C6-C60)aryl, (C4-C60)heteroaryl, (C6-C60)arylamino, (C1-C60)alkylamino, 5- or 6-membered heterocycloalkyl containing one or more heteroatom(s) selected from N, O and S, or (C3-C60)cycloalkyl, or each of R₄₁ through R₄₄ is linked to an adjacent substituent via (C3-C60)alkylene or (C3-C60)alkenylene with or without a fused ring to form an alicyclic ring, or a monocyclic or polycyclic aromatic ring;
the alkyl, aryl, heteroaryl, arylamino, alkylamino, cycloalkyl or heterocycloalkyl of R₄₁ through R₄₄ may be further substituted by one or more substituent(s) selected from deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl.

2. The organic electroluminescent device according to claim 1, wherein Ar₁ and Ar₂ independently represent phenyl, naphthyl, fluorenyl, biphenyl, fluoranthenyl, perylenyl, pyrenyl, phenanthrenyl, spirobifluorenyl, pyridyl or quinolyl; R₁ and R₂ represent methyl, ethyl, n-propyl, i-propyl, n-butyl, i-butyl, t-butyl, n-pentyl, i-pentyl, n-hexyl, n-heptyl, n-octyl, 2-ethylhexyl, n-nonyl, decyl, dodecyl, hexadecyl, methoxy, ethoxy, n-propoxy, i-propoxy, n-butoxy, i-butoxy, t-butoxy, n-pentoxy, i-pentoxy, n-hexyloxy, n-heptoxy, fluoro, cyclopropyl, cyclobutyl, cyclopentyl, cyclohexyl, cycloheptyl, cyclooctyl, cyclononyl, cyclodecyl, phenyl, naphthyl, fluorenyl, biphenyl, fluoranthenyl, perylenyl, pyrenyl, phenanthrenyl, spirobifluorenyl, pyridyl or quinolyl; and the phenyl, naphthyl, fluorenyl, biphenyl, fluoranthenyl, perylenyl, pyrenyl, phenanthrenyl, spirobifluorenyl, pyridyl or quinolyl of Ar₁, Ar₂, R₁ and R₂ may be further substituted by one or more substituent(s) selected from deuterium, methyl, ethyl, n-propyl, i-propyl, n-butyl, i-butyl, t-butyl, n-pentyl, i-pentyl, n-hexyl, n-heptyl, n-octyl, 2-ethylhexyl, n-nonyl, decyl, dodecyl, hexadecyl, methoxy, ethoxy, n-propoxy, i-propoxy, n-butoxy, i-butoxy, t-butoxy, n-pentoxy, i-pentoxy, n-hexyloxy, n-heptoxy, fluoro, cyclopropyl, cyclobutyl, cyclopentyl, cyclohexyl, cycloheptyl, cyclooctyl, cyclononyl, cyclodecyl, trimethylsilyl, triethylsilyl, tripropylsilyl, tri(t-butyl)silyl, t-butyldimethylsilyl, dimethylphenylsilyl, triphenylsilyl, phenyl, naphthyl, biphenyl, fluorenyl, phenanthryl, anthryl, fluoranthenyl, triphenylenyl, pyrenyl, chrysenyl, naphthacenyl, perylenyl, pyridyl, pyrrolyl, furanyl, thiophenyl, imidazolyl, benzimidazolyl, pyrazinyl, pyrimidinyl, pyridazinyl, quinolyl, triazinyl, benzofuranyl, benzothiophenyl, pyrazolyl, indolyl, carbazolyl, thiazolyl, oxazolyl, benzothiazolyl and benzoxazolyl.

3. The organic electroluminescent device according to claim 1, wherein R₄₁ through R₄₄ independently represent methyl, ethyl, n-propyl, i-propyl, n-butyl, i-butyl, t-butyl, n-pentyl, i-pentyl, n-hexyl, n-heptyl, n-octyl, 2-ethylhexyl, n-nonyl, decyl, dodecyl, hexadecyl, cyclopropyl, cyclobutyl, cyclopentyl, cyclohexyl, cycloheptyl, cyclooctyl, cyclononyl, cyclodecyl, morpholino, thiomorpholino, phenyl, naphthyl, fluorenyl, biphenyl, pyridyl or quinolyl, or each of R₄₁ through R₄₄ may be linked to an adjacent substituent via (C4-C12)alkylene or (C4-C12)alkenylene to form a fused ring; and the phenyl, naphthyl, fluorenyl, biphenyl, pyridyl or quinolyl of R₄₁ through R₄₄ may be further substituted by one or more substituent(s) selected from deuterium, methyl, ethyl, n-propyl, i-propyl, n-butyl, i-butyl, t-butyl, n-pentyl, i-pentyl, n-hexyl, n-heptyl, n-octyl, cyclopropyl, cyclobutyl, cyclopentyl, cyclohexyl, cycloheptyl, cyclooctyl, cyclononyl, cyclodecyl, trimethylsilyl, triethylsilyl, tripropylsilyl, tri(t-butyl)silyl, t-butyldimethylsilyl, dimethylphenylsilyl, triphenylsilyl, phenyl and fluorenyl.

4. The organic electroluminescent device according to claim 1, wherein L is selected from the following structures: 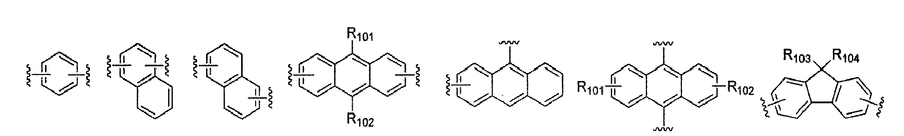 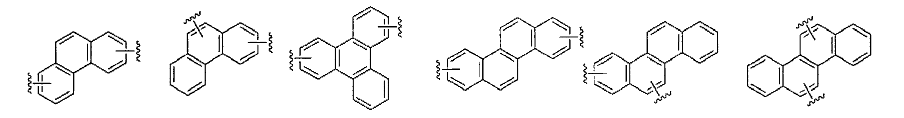 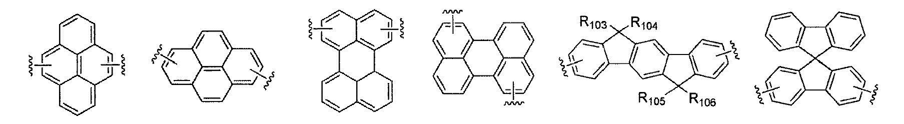 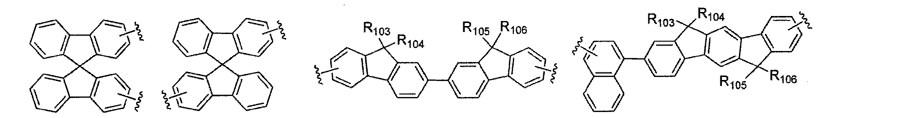 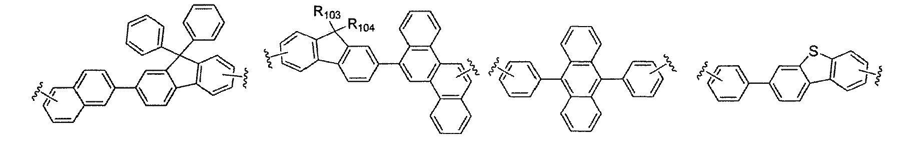 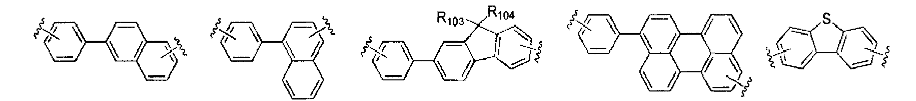 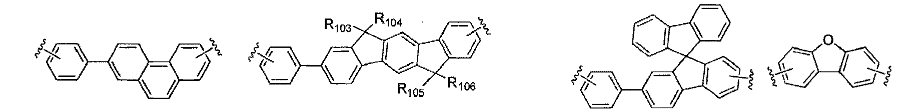 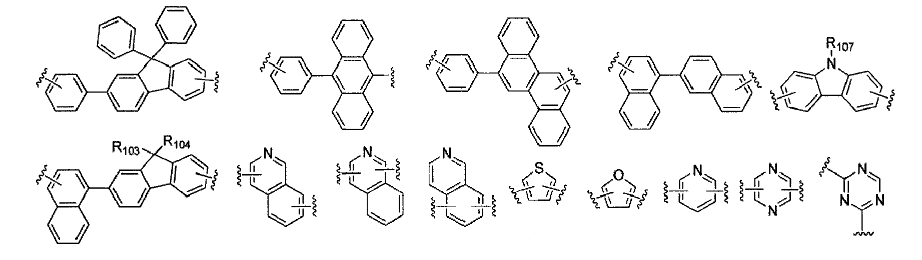 wherein, R₁₀₁ through R₁₀₇ independently represent hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl, or a substituent selected from the following structures; or each of R₁₀₁ through R₁₀₇ may be linked to an adjacent substituent via (C3-C60)alkylene or (C3-C60)alkenylene with or without a fused ring to form an alicyclic ring, or a monocyclic or polycyclic aromatic ring: 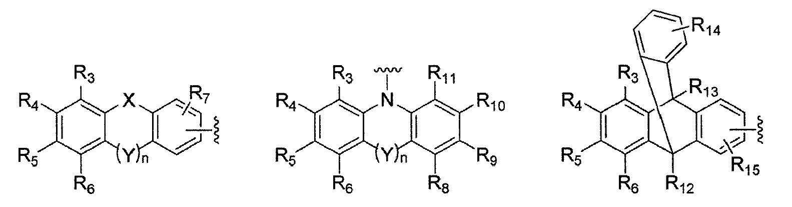 wherein, R₃ through R₁₅ independently represent hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl;
X and Y independently represent a chemical bond, or - C(R₂₁)(R₂₂)-, -N(R₂₃)-, -S-, -O-, -Si(R₂₄)(R₂₅)-, -P(R₂₆)-, - C(=O)-, -B(R₂₇)-, -In(R₂₈)-, -Se-, -Ge(R₂₉)(R₃₀)-, -Sn(R₃₁)(R₃₂)-, -Ga(R₃₃)-, or -(R₃₄)C=C(R₃₅)-;
R₂₁ through R₃₅ independently represent hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl; or each of R₂₁ through R₃₅ may be linked to an adjacent substituent via (C3-C60)alkylene or (C3-C60)alkenylene with or without a fused ring to form an alicyclic ring, or a monocyclic or polycyclic aromatic ring;
the alkyl, alkenyl, alkynyl, cycloalkyl, heterocycloalkyl, aryl, heteroaryl, arylsilyl, alkylsilyl, alkylamino and arylamino of R₁₀₁ through R₁₀₇ may be further substituted by one or more substituent(s) selected from deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl; and
n is an integer from 0 to 4.

5. The organic electroluminescent device according to claim 1, wherein the host is selected from the following compounds.

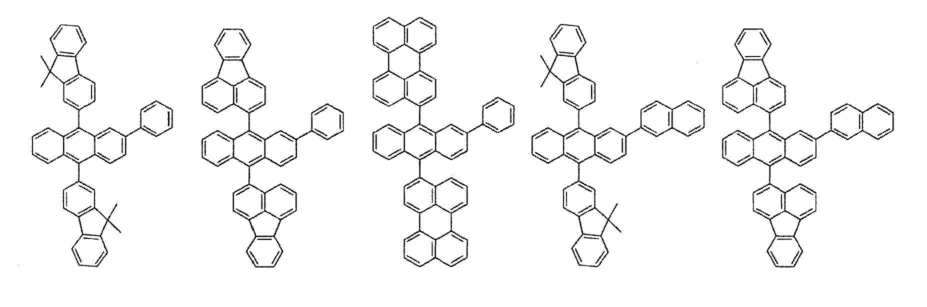

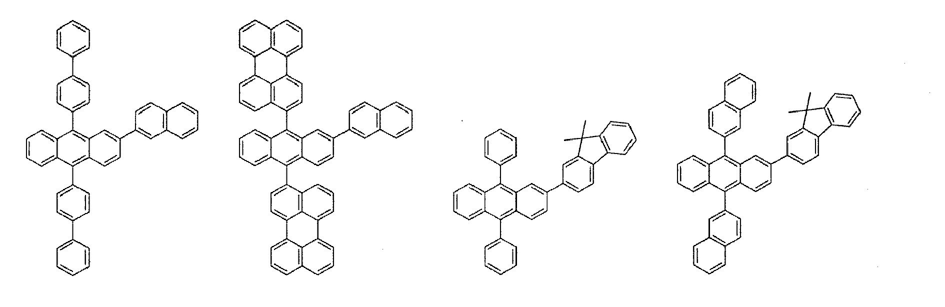

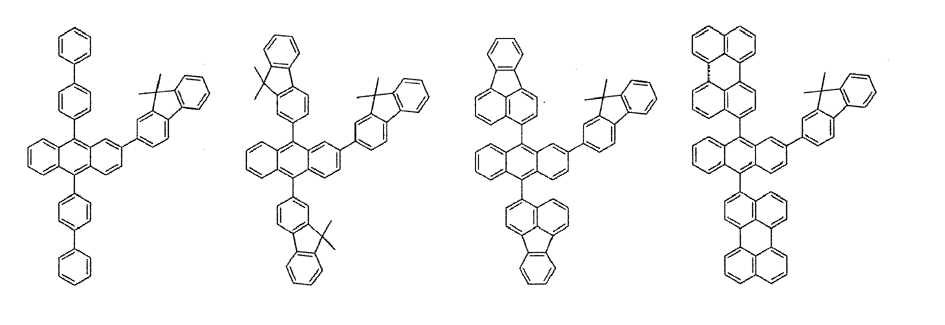

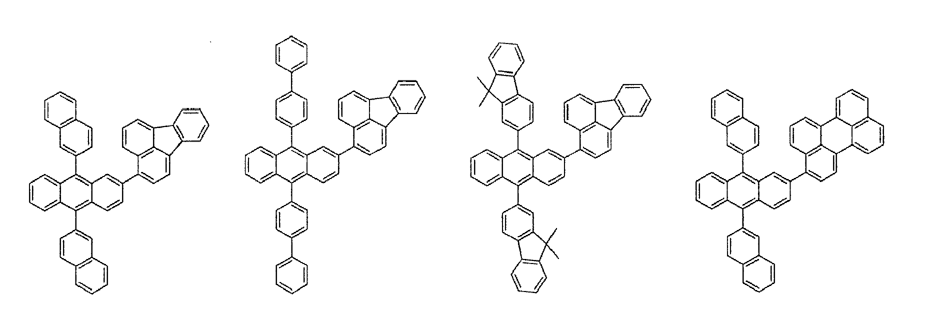

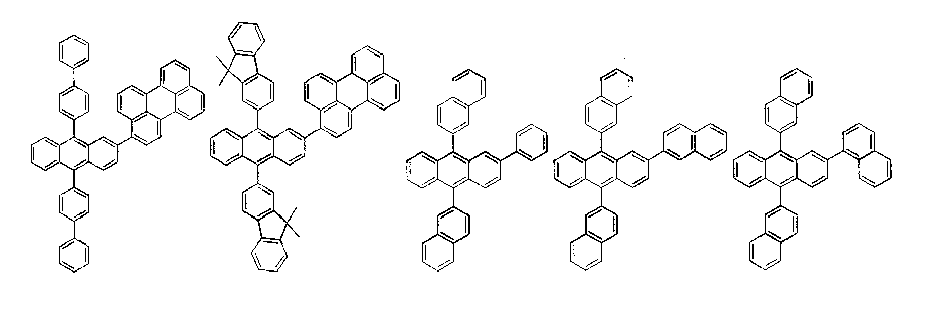

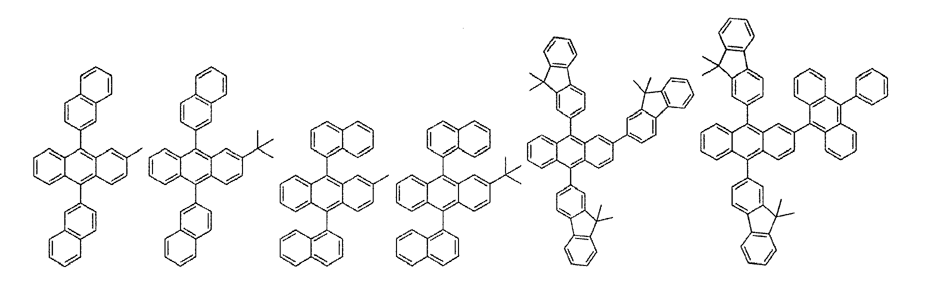

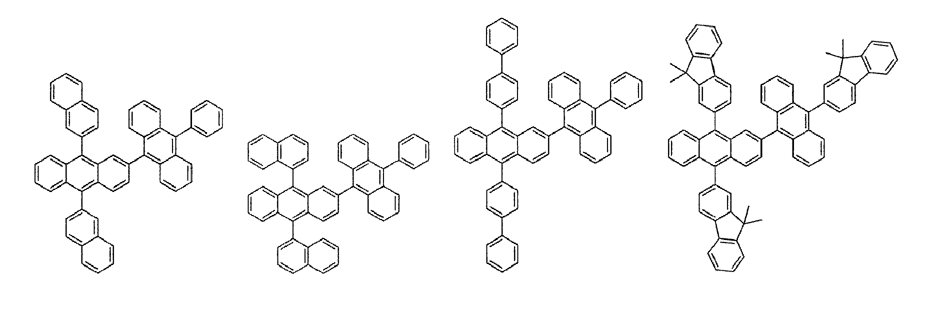

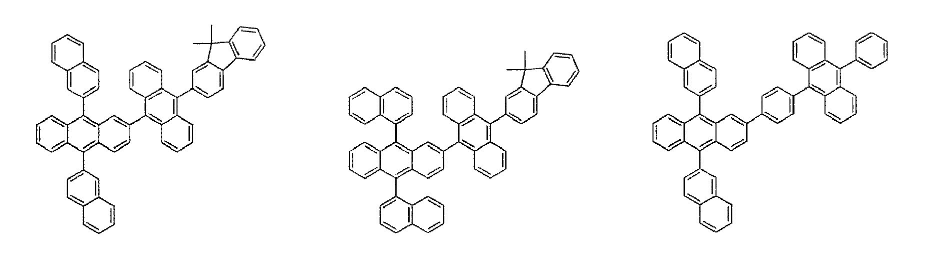

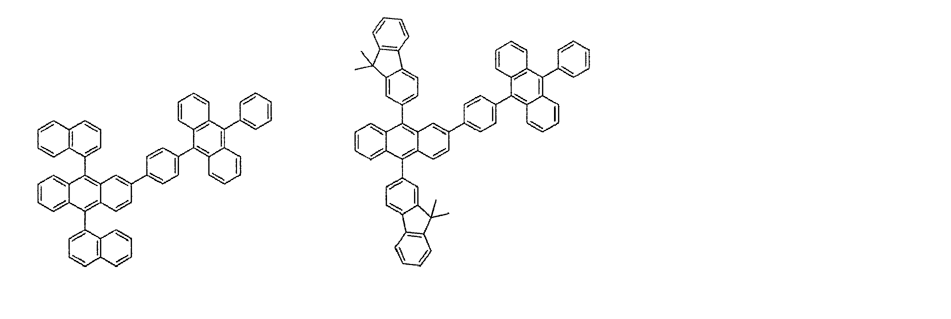

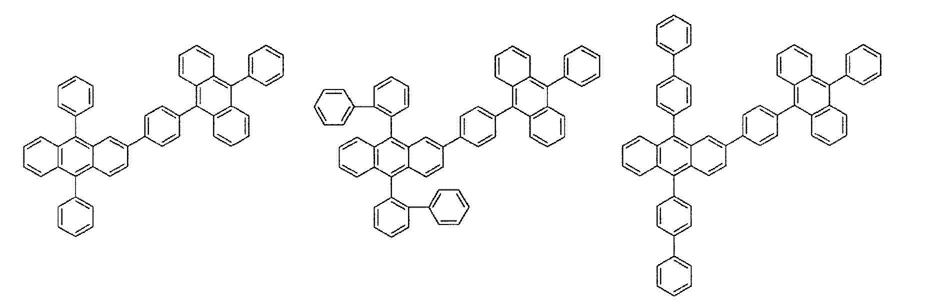

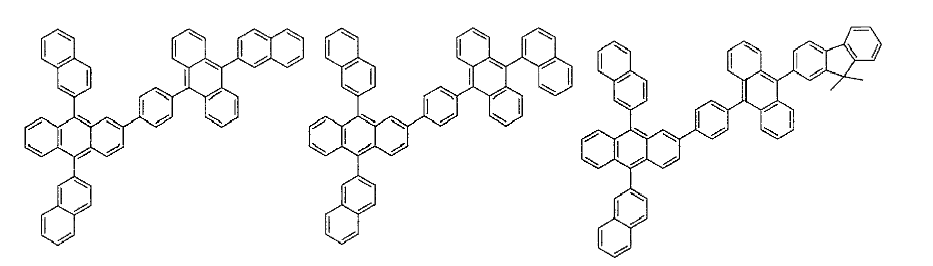

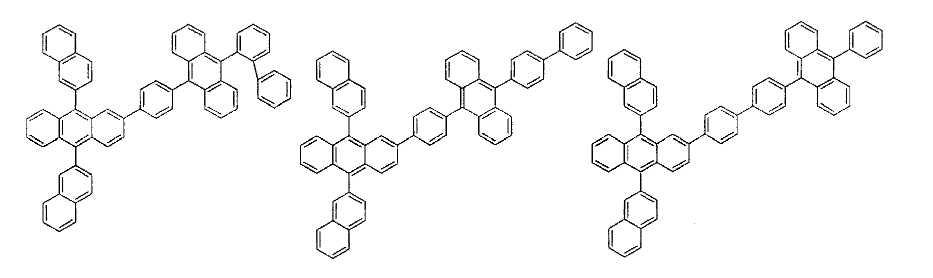

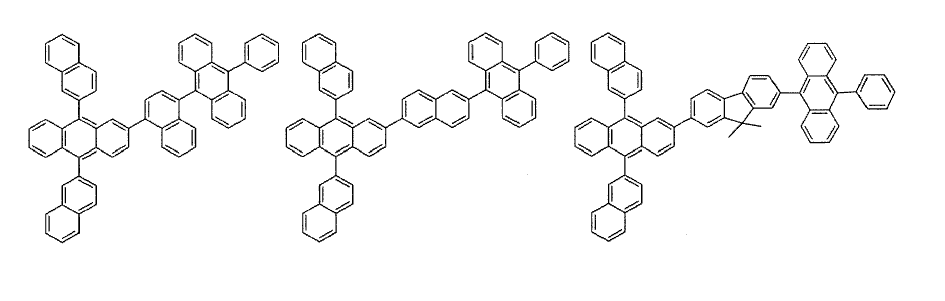

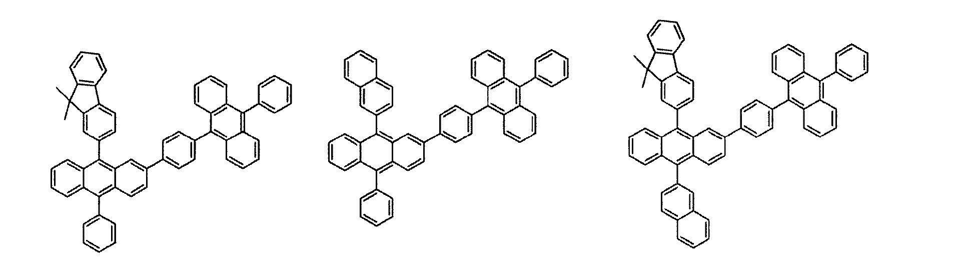

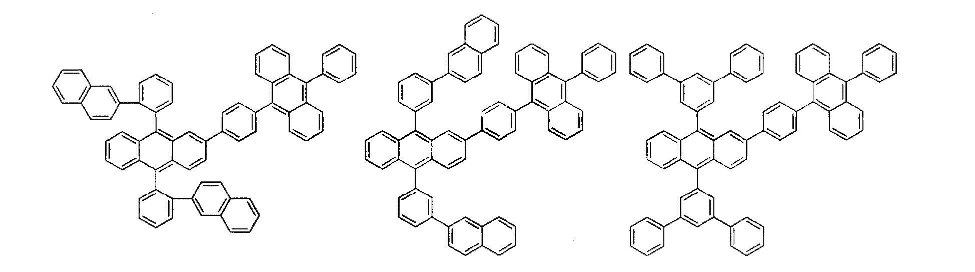

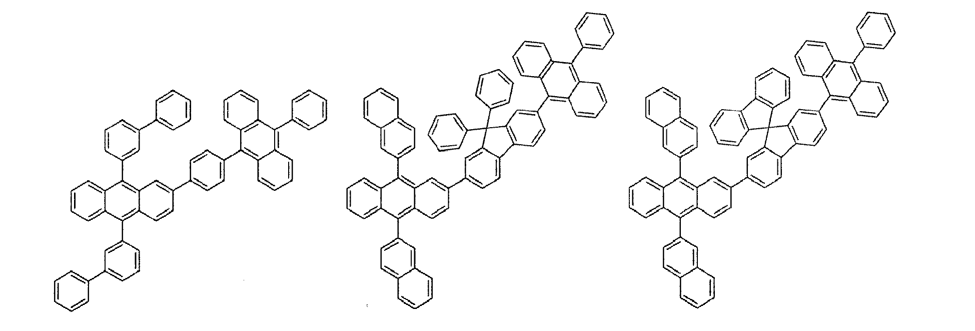

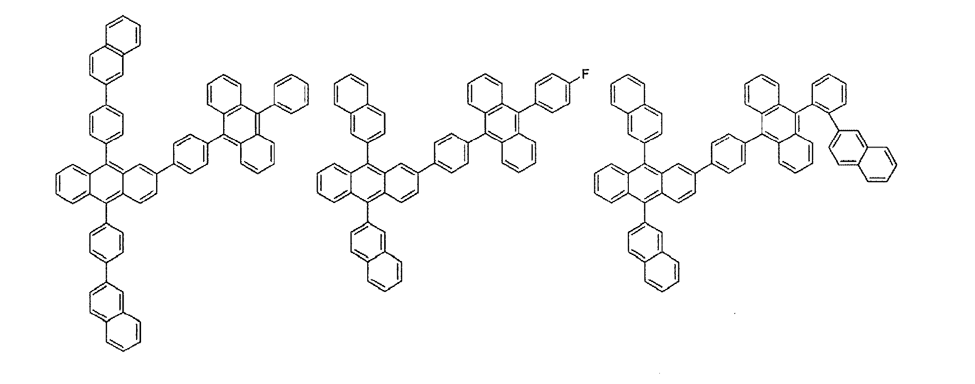

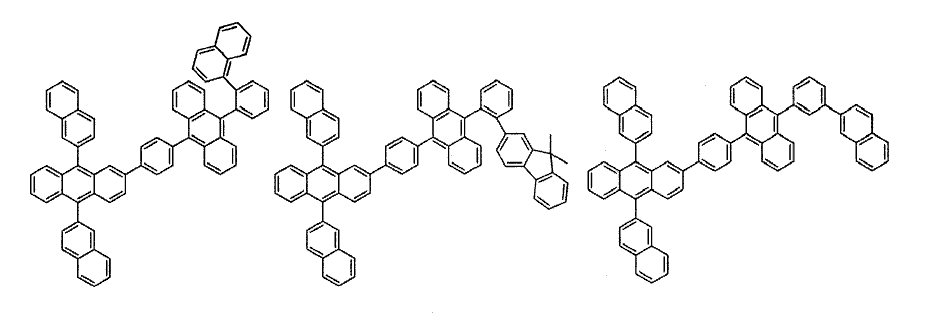

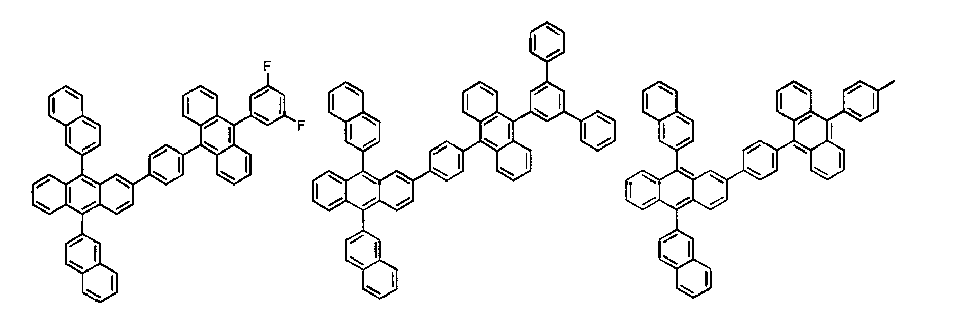

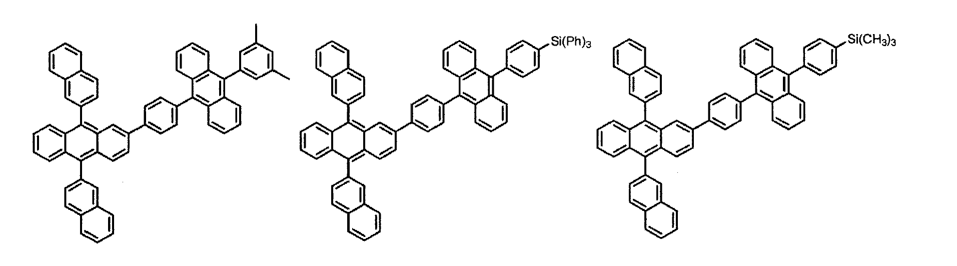

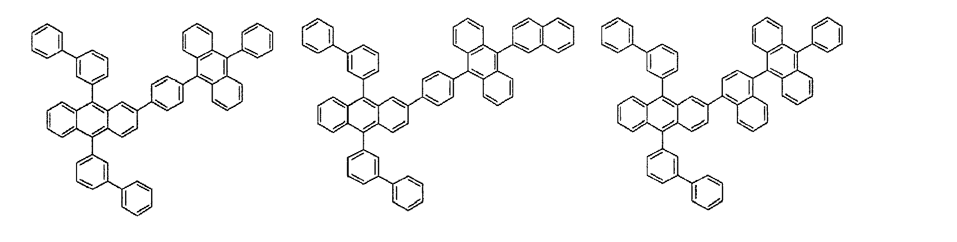

6. An organic electroluminescent device according to claim 1, wherein the dopant is selected from the following compounds.

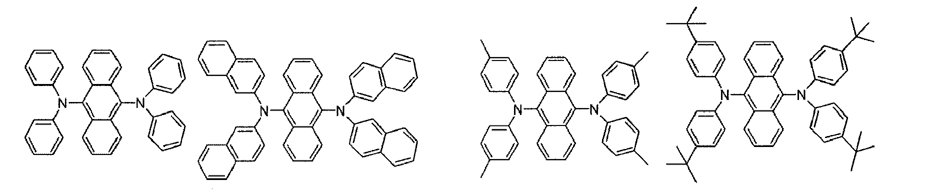

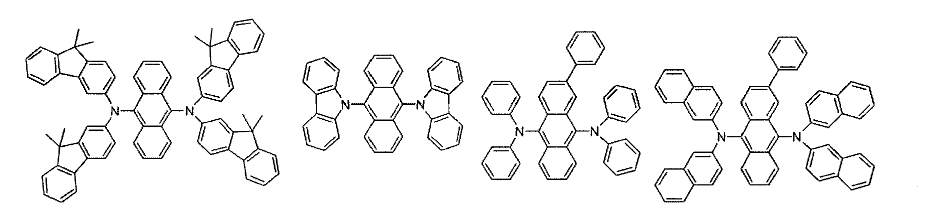

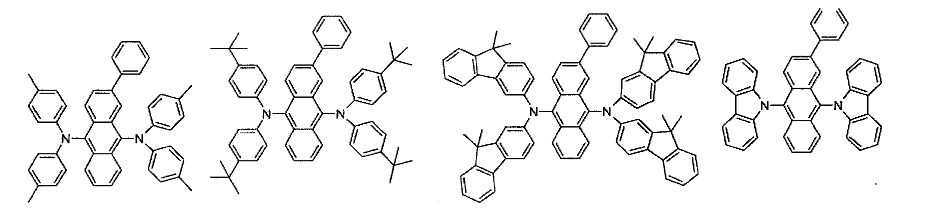

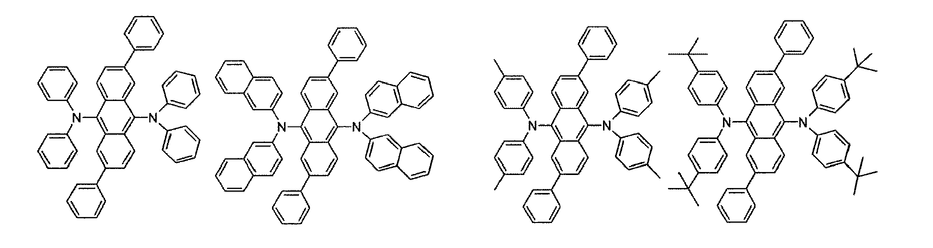

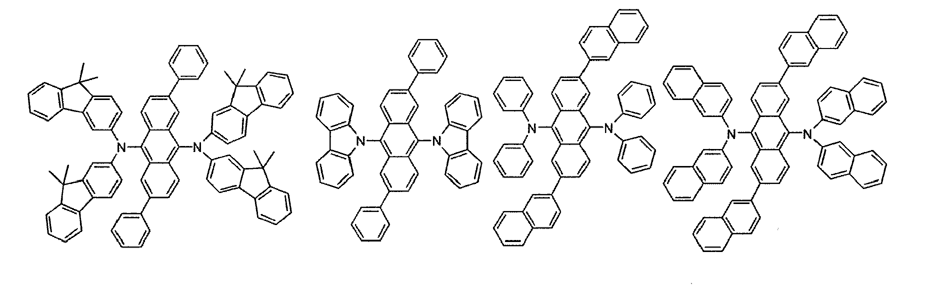

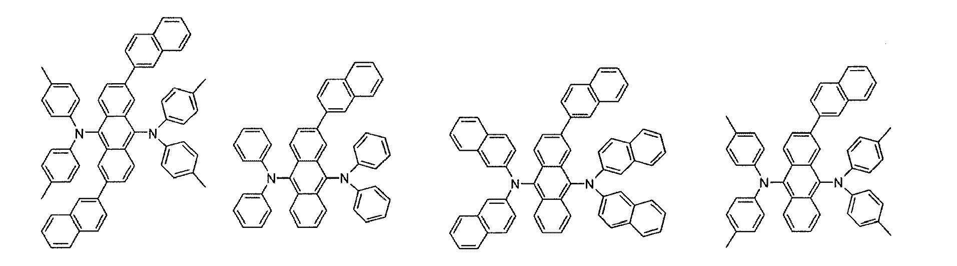

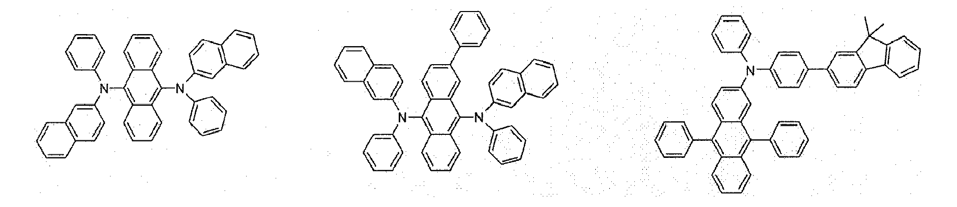

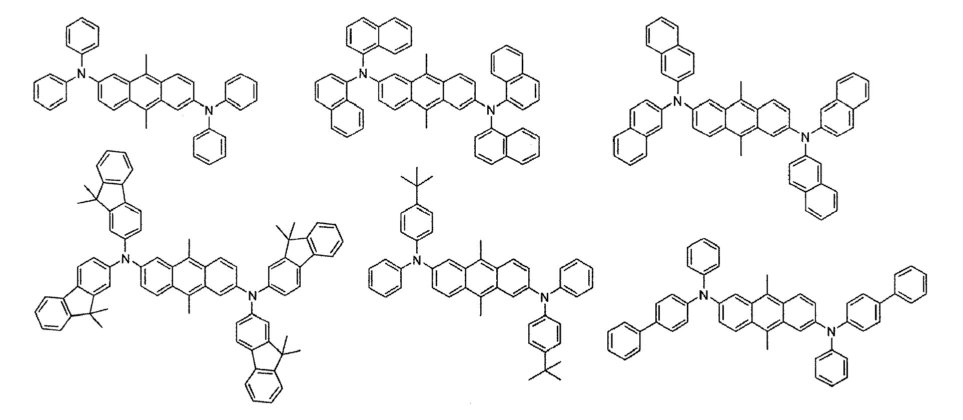

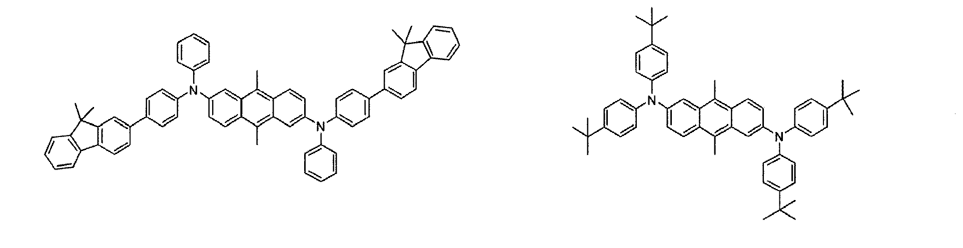

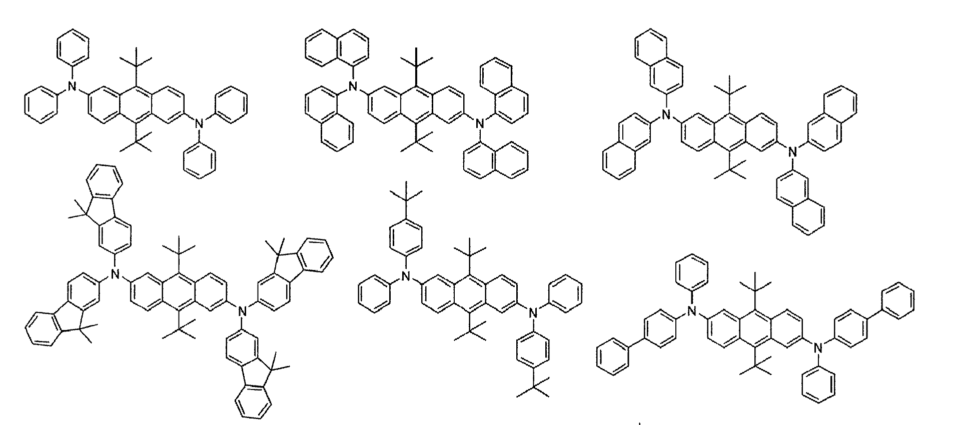

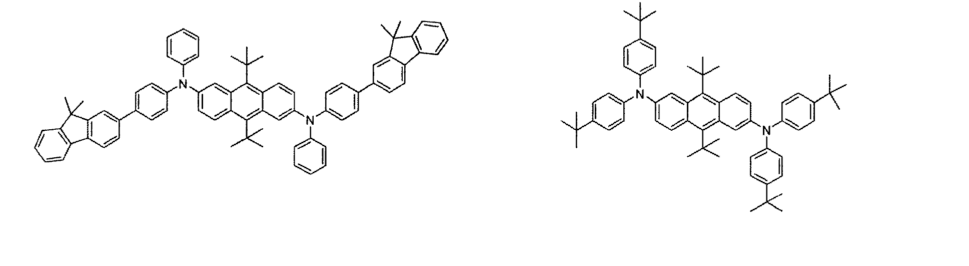

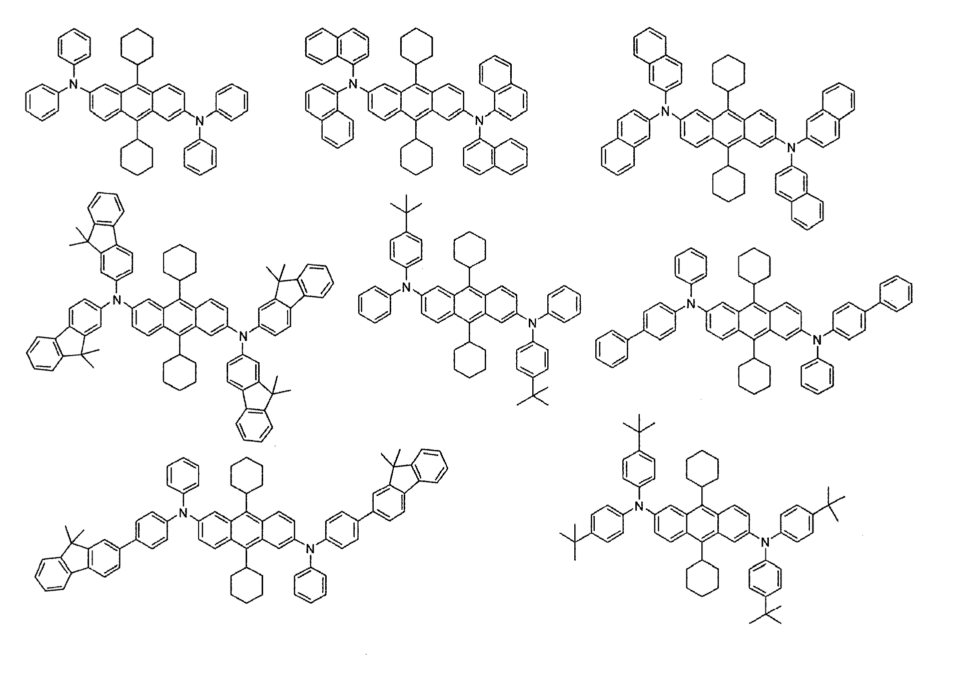

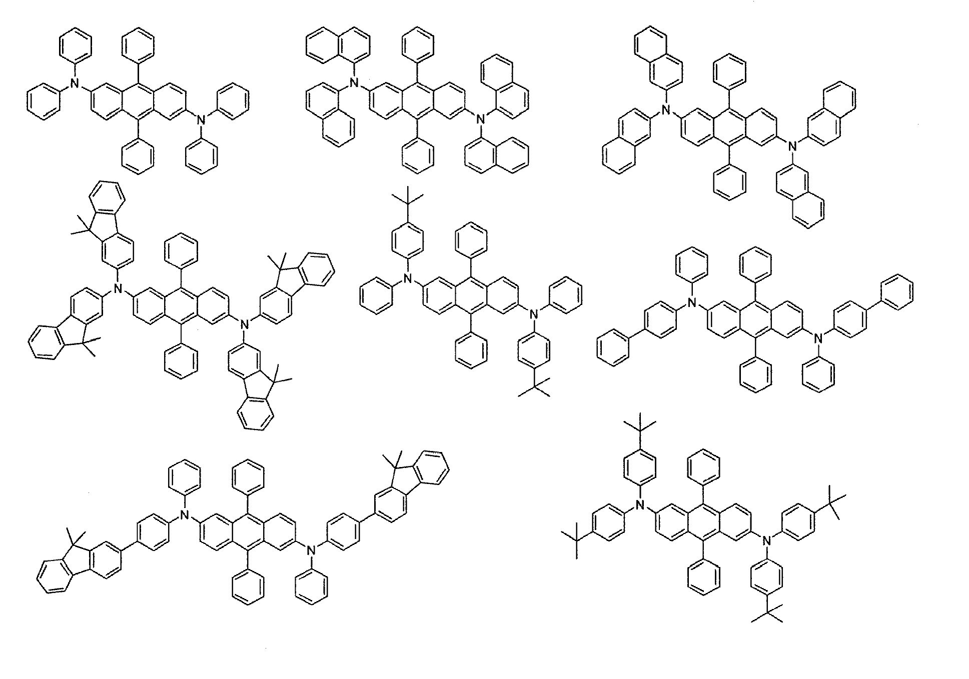

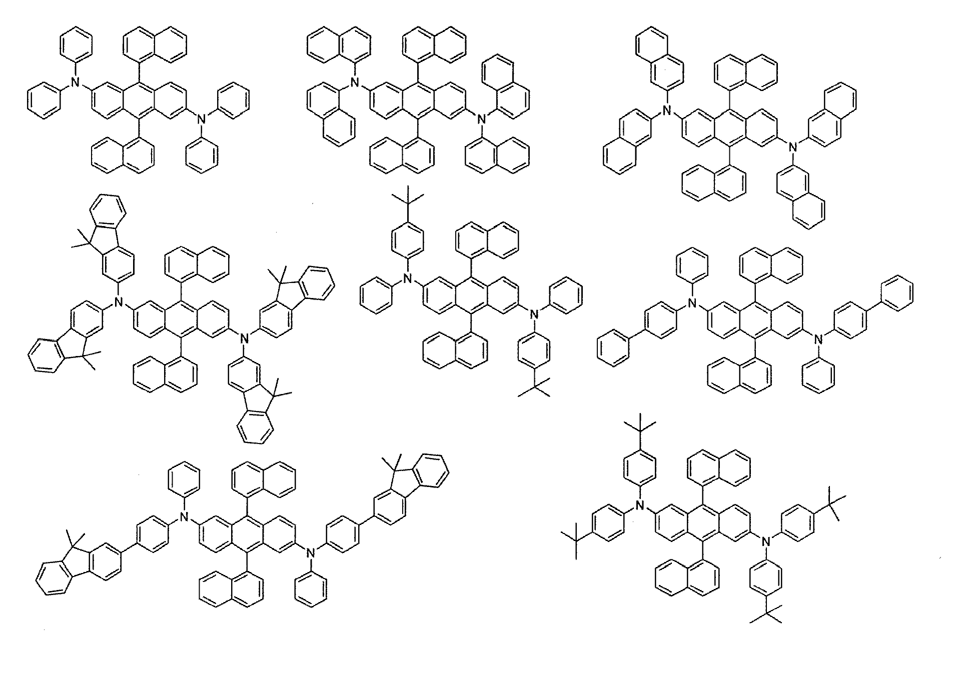

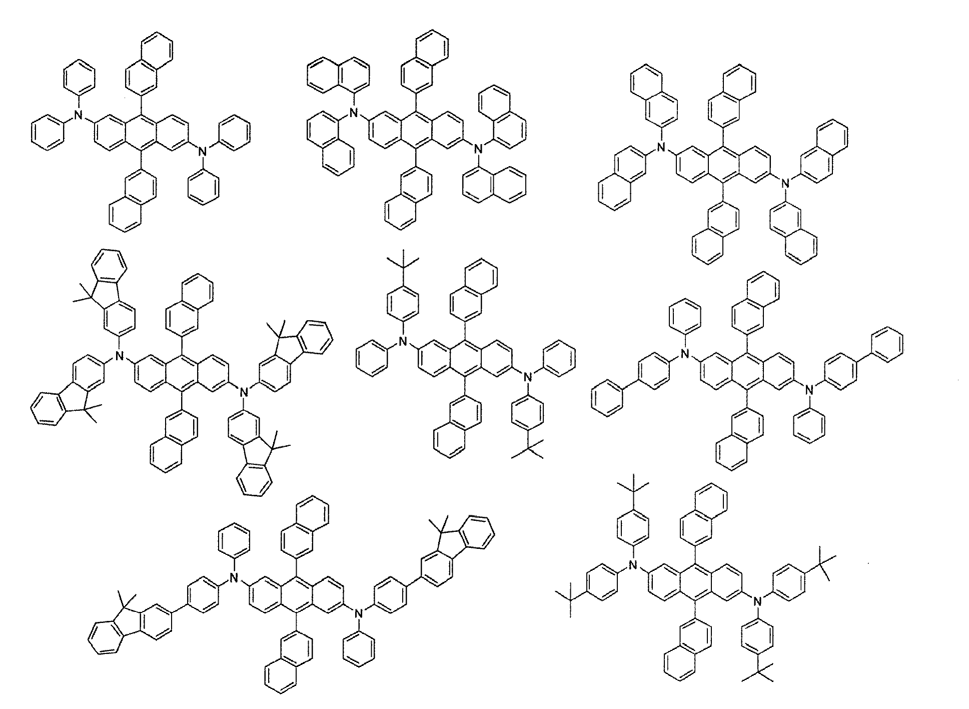

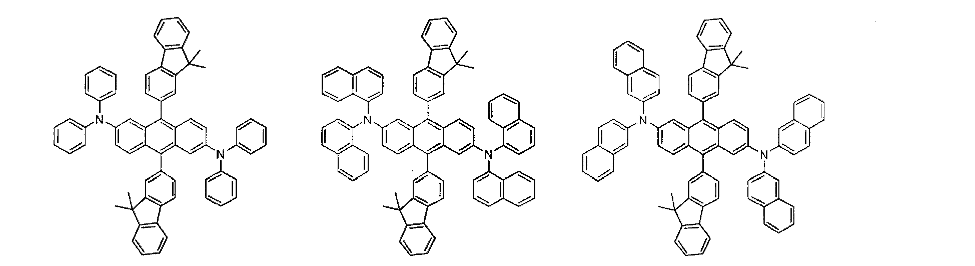

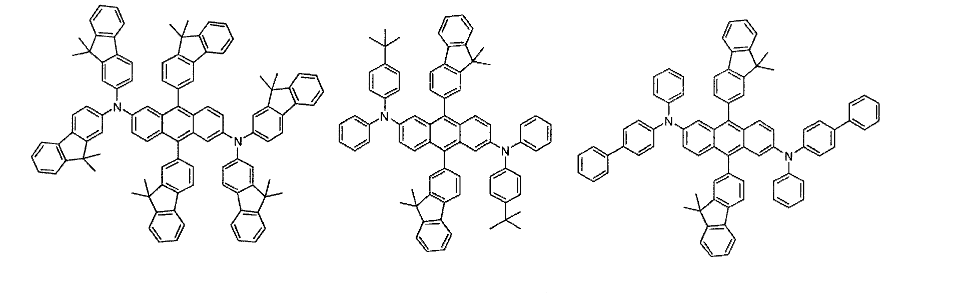

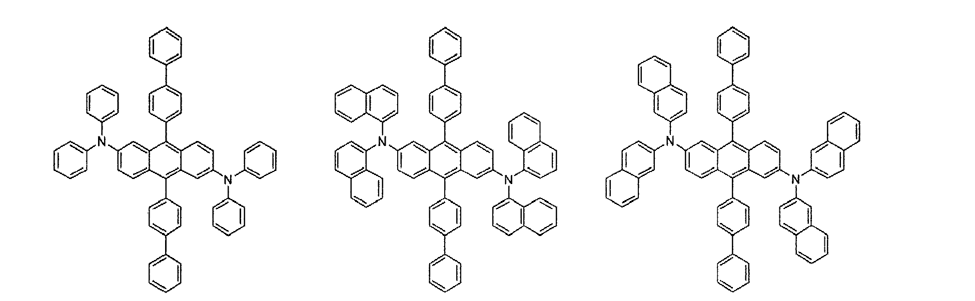

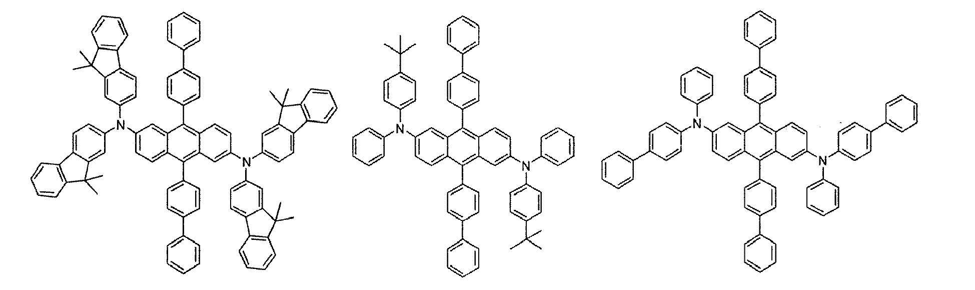

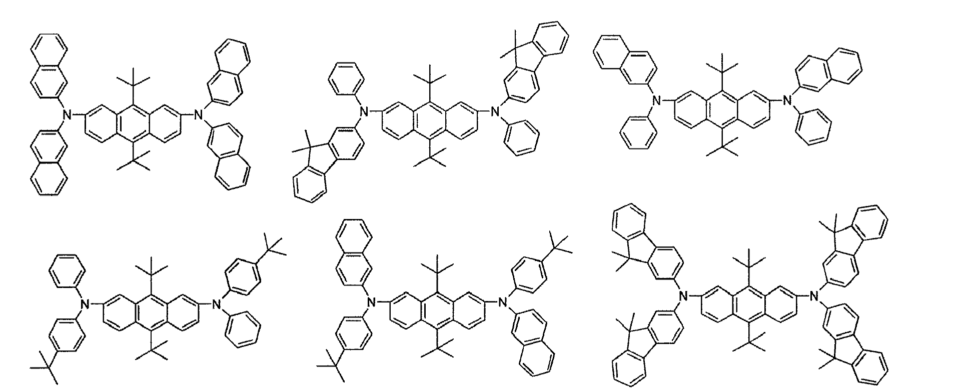

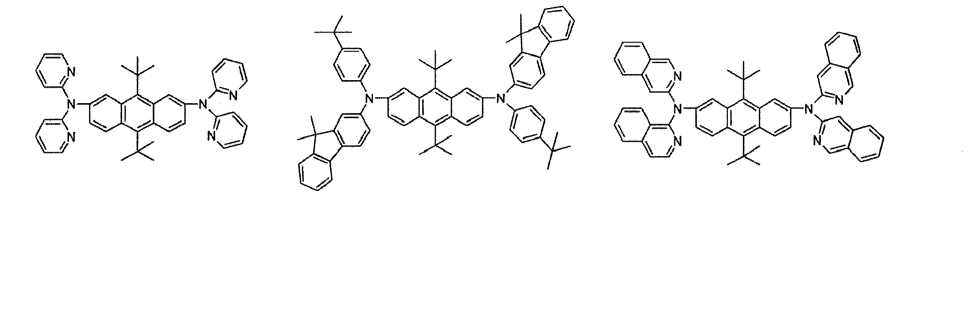

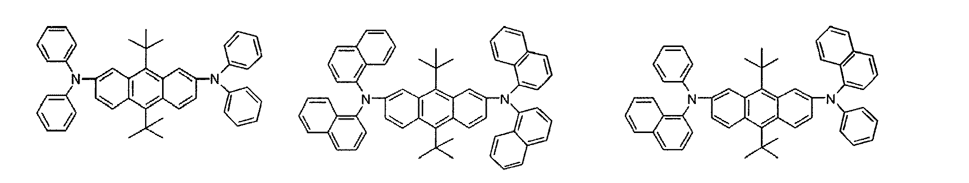

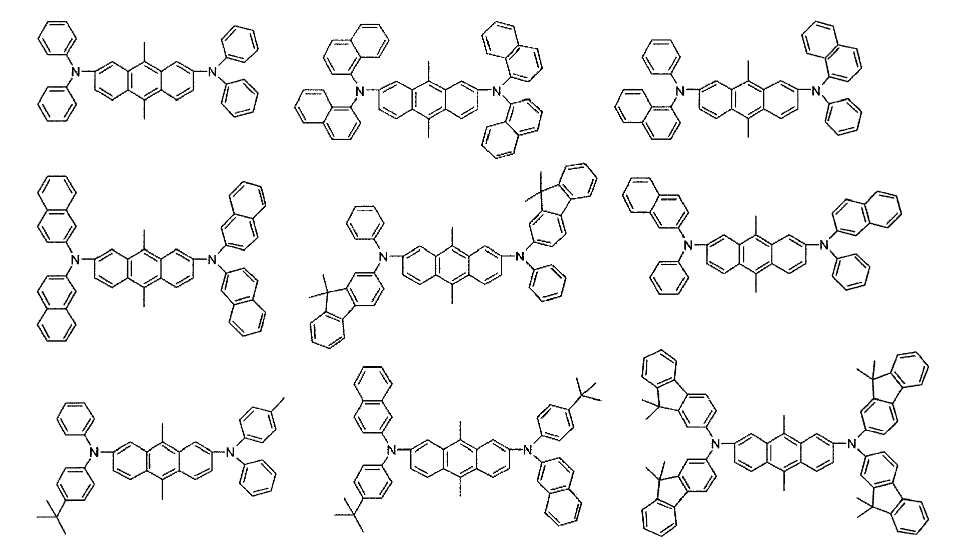

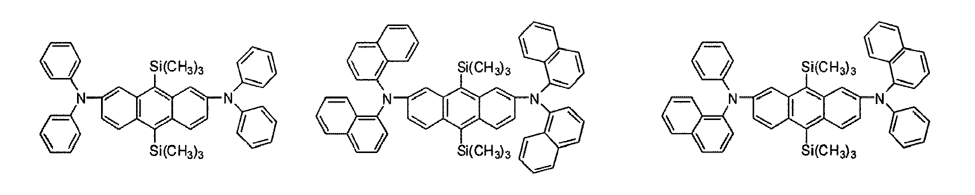

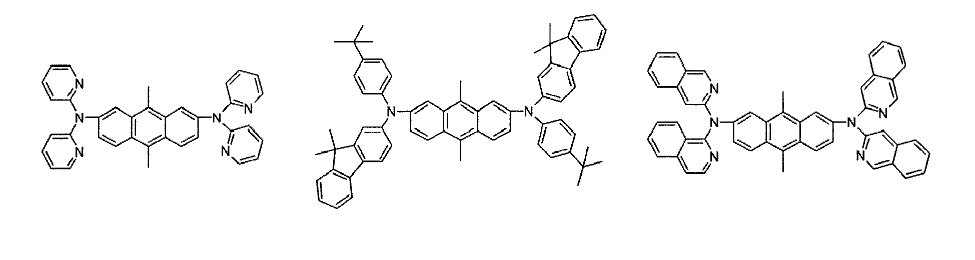

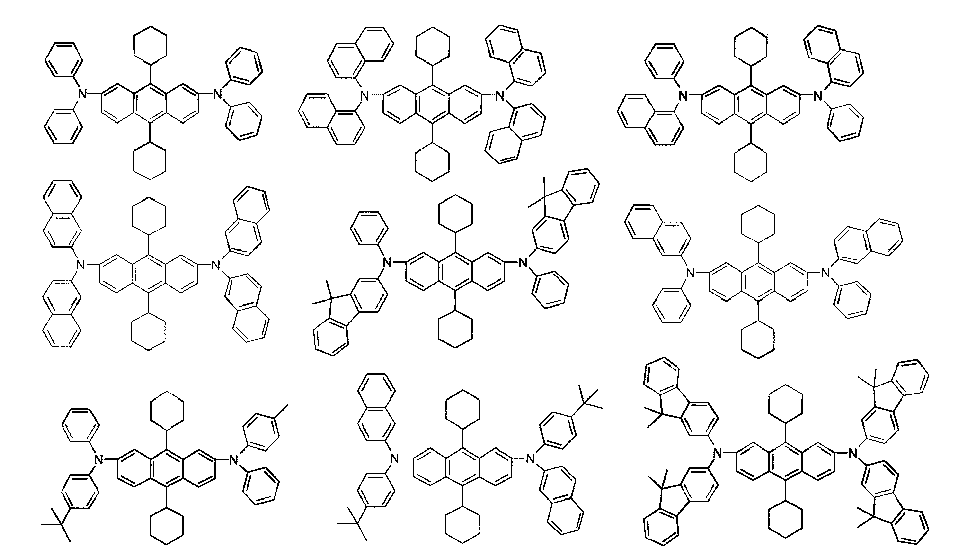

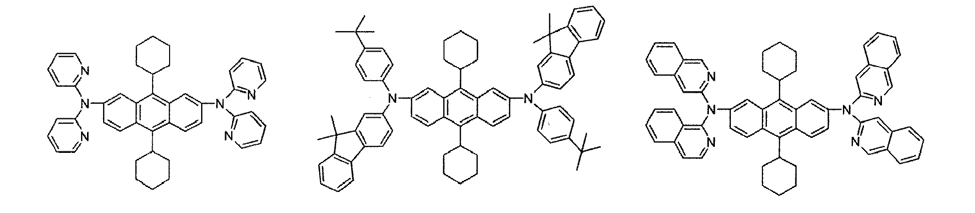

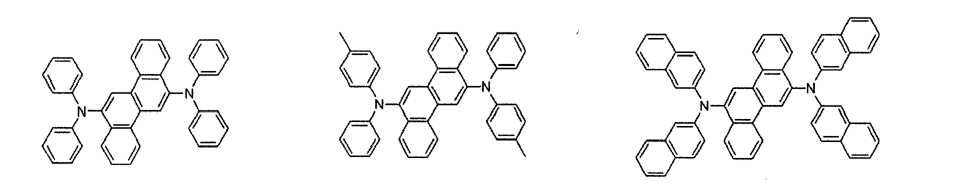

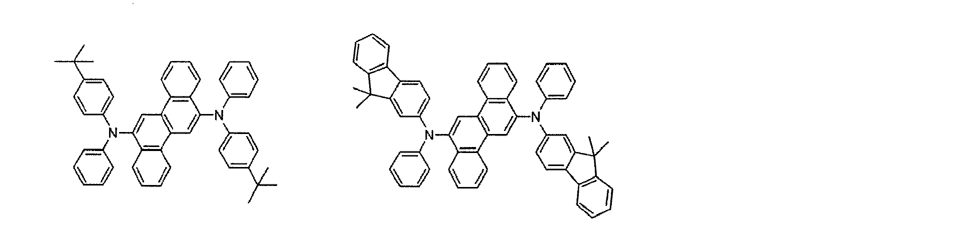

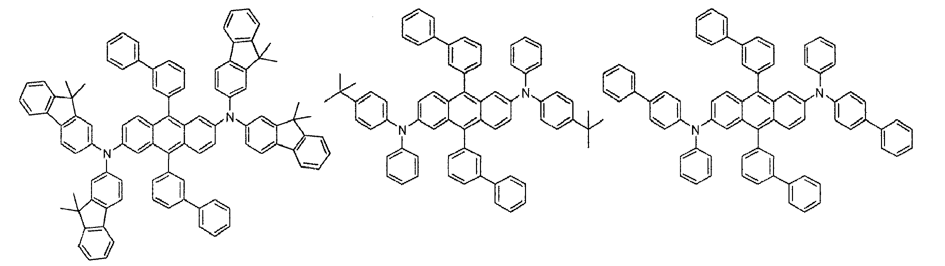

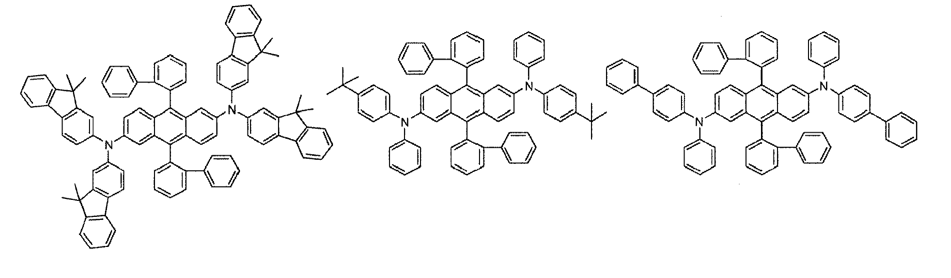

7. The organic electroluminescent device according to claim 1, wherein the doping concentration of the dopant with respect to the host in the electroluminescent layer is from 0.5 to 20% by weight.

8. The organic electroluminescent device according to claim 1, wherein the organic layer comprises one or more compound(s) selected from a group consisting of arylamine compounds and styrylarylamine compounds.

9. The organic electroluminescent device according to claim 1, wherein the organic layer comprises one or more metal(s) selected from a group consisting of organic metals of Group 1, Group 2, 4^{th} period and 5^{th} period transition metals, lanthanide metals and d-transition elements.

10. The organic electroluminescent device according to claim 1, which has a pixel structure of independent light-emitting mode, which comprises an organic electroluminescent device containing the organic layer as a sub-pixel, and one or more sub-pixel(s) comprising one or more metal compound(s) selected from a group consisting of Ir, Pt, Pd, Rh, Re, Os, Tl, Pb, Bi, In, Sn, Sb, Te, Au and Ag, patterned in parallel at the same time.

11. The organic electroluminescent device according to claim 1, wherein the organic layer comprises a compound having electroluminescent peak of wavelength of not more than 500 nm, or a compound having electroluminescent peak of wavelength of not less than 560 nm, as well as the organic electroluminescent compounds defined in claim 1, at the same time.

12. The organic electroluminescent device according to claim 1, wherein the organic layer comprises a charge generating layer as well as an electroluminescent layer.

13. The organic electroluminescent device according to claim 1, wherein one or more layer(s) selected from chalcogenide layers, metal halide layers and metal oxide layers is(are) placed on the inner surface of at least one side of the pair of electrodes.

14. The organic electroluminescent device according to claim 1, wherein a mixed region of reductive dopant and organic substance, or a mixed region of oxidative dopant and organic substance is placed on the inner surface of one or both electrode(s) among the pair of electrodes.

15. The organic solar cell which comprises one or more compound(s) represented by Chemical Formula (1) or Chemical Formula (2): 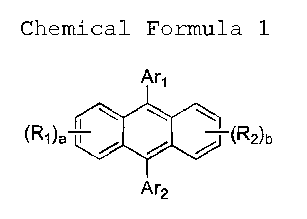 wherein, Ar₁, Ar₂, R₁ and R₂ independently represent hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl, or a substituent selected from the following structures; or each of them may be linked to an adjacent substituent via (C3-C60)alkylene or (C3-C60)alkenylene with or without a fused ring to form an alicyclic ring, or a monocyclic or polycyclic aromatic ring; 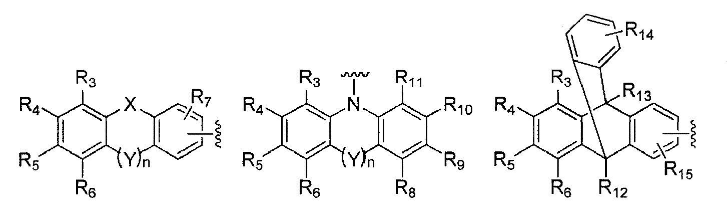 wherein, R₃ through R₁₅ independently represent hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl;
X and Y independently represent a chemical bond, or - C(R₂₁)(R₂₂)-, -N(R₂₃)-, -S-, -O-, -Si(R₂₄)(R₂₅)-, -P(R₂₆)-, - C(=O)-, -B(R₂₇)-, -In(R₂₈)-, -Se-, -Ge(R₂₉)(R₃₀)-, -Sn(R₃₁)(R₃₂)-, -Ga(R₃₃)-, or -(R₃₄)C=C(R₃₅)-;
R₂₁ through R₃₅ independently represent hydrogen, deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl; or each of R₂₁ through R₃₅ may be linked to an adjacent substituent via (C3-C60)alkylene or (C3-C60)alkenylene with or without a fused ring to form an alicyclic ring, or a monocyclic or polycyclic aromatic ring;
the alkyl, alkenyl, alkynyl, cycloalkyl, heterocycloalkyl, aryl, heteroaryl, arylsilyl, alkylsilyl, alkylamino and arylamino of Ar₁, Ar₂, R₁ and R₂ may be further substituted by one or more substituent(s) selected from deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl;
a and b are integers from 0 to 4, provided that a+b ≥ 1; and
n is an integer from 0 to 4; 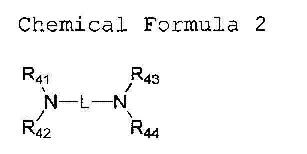 wherein,
L represents (C6-C60)arylene with or without one or more substituent(s) selected from a group consisting of deuterium, halogen, (C1-C60)alkyl, (C6-C60)aryl, (C4-C60)heteroaryl, 5-or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl; the alkyl, cycloalkyl, heterocycloalkyl, aryl, heteroaryl, arylsilyl, alkylsilyl, alkylamino and arylamino substituent on the arylene may be further substituted by one or more substituent(s) selected from deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl;
R₄₁ through R₄₄ independently represent (C1-C60)alkyl, (C6-C60)aryl, (C4-C60)heteroaryl, (C6-C60)arylamino, (C1-C60)alkylamino, 5- or 6-membered heterocycloalkyl containing one or more heteroatom(s) selected from N, O and S, or (C3-C60)cycloalkyl, or each of R₄₁ through R₄₄ is linked to an adjacent substituent via (C3-C60)alkylene or (C3-C60)alkenylene with or without a fused ring to form an alicyclic ring, or a monocyclic or polycyclic aromatic ring;
the alkyl, aryl, heteroaryl, arylamino, alkylamino, cycloalkyl or heterocycloalkyl of R₄₁ through R₄₄ may be further substituted by one or more substituent(s) selected from deuterium, halogen, (C1-C60)alkyl, (C6-C60)aryl, (C4-C60)heteroaryl, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl.
